(19) Europäisches Patentamt
European Patent Office
Office européen des brevets

(11) **EP 3 091 560 A1**

(12) **EUROPEAN PATENT APPLICATION**

(43) Date of publication:
**09.11.2016 Bulletin 2016/45**

(51) Int Cl.:
**H01J 37/32** $^{(2006.01)}$ **H01J 37/34** $^{(2006.01)}$

(21) Application number: **16168630.8**

(22) Date of filing: **06.05.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **07.05.2015 US 201514706510**

(71) Applicant: **Vapor Technologies, Inc.**
**Longmont CO 80503 (US)**

(72) Inventors:
 • GOROKHOVSKY, Vladimir
  Lafayette, Colorado 80026 (US)

 • HUMENIK, David
  Longmont, Colorado 80503 (US)
 • TRUBE, Scott
  Loveland, Colorado 80537 (US)
 • SULLIVAN, Patrick
  Longmont, Colorado 80504 (US)
 • PETERSON, Nicholas
  Erie, Colorado 80516 (US)

(74) Representative: **Beck Greener**
**Fulwood House**
**12 Fulwood Place**
**London WC1V 6HR (GB)**

(54) **REMOTE ARC DISCHARGE PLASMA ASSISTED SYSTEM**

(57) A coating system includes a vacuum chamber and a coating assembly. The coating assembly has a coating assembly which includes a vapor source, a substrate holder to hold substrates to be coated such that the substrates are positioned in front of the vapor source, a primary cathodic vacuum-arc assembly, a remote anode electrically coupled to the cathode target, a primary power supply connected between the cathode target and the primary anode, and a secondary power supply connected between the cathode target and the remote anode. The primary cathodic vacuum-arc assembly includes a cathode chamber assembly, a cathode target, an optional primary anode and a shield which isolates the cathode target from the vacuum chamber. The shield defines openings for transmitting either electron emission current or metal vapor plasma from the cathode target into the vacuum chamber. The vapor source is positioned between the cathode chamber assembly and the remote anode.

Fig. 13D

**EP 3 091 560 A1**

**Description**

CROSS REFERENCE TO RELATED APPLICATIONS

This application relates to U.S. Serial No. 13/617,005 filed September 14, 2012; U.S. Serial No. 13/840,305 filed March 15, 2013; and U.S. Serial No. 14/064,617 filed October 28, 2013.

FIELD OF THE INVENTION

The present invention relates to plasma assisted deposition systems and related methods.

BACKGROUND OF THE INVENTION

Physical vapor deposition (PVD) and low pressure Chemical vapor deposition (CVD) sources are used for deposition of coatings and surface treatment. Conventional metal vapor sources such as electron beam physical vapor deposition (EBPVD) and magnetron sputtering (MS) metal vapor sources can provide high deposition rates. However, the low energy of the metal vapor atoms and the low ionization rate of these processes result in coatings with low density, poor adhesion, poor structure and morphology. It is well established that assistance of the coating deposition process with bombardment by energetic particles dramatically improves coatings by densifying the depositing materials, reducing the grain size and improving coating adhesion. In these processes, the surface layer is affected by a high rate of bombardment by energetic ions which modifies the mobility of depositing metal vapor atoms and, in many cases, creates metastable structures with unique functional properties. Moreover, ion bombardment of the coating surface influences gas adsorption behavior by increasing the sticking coefficient of gases such as nitrogen and changing the nature of adsorption sites from lower energy physic-sorption sites to higher energy chemi-sorption sites. This approach is especially productive in the deposition of nanostructured composite coatings with ultra-fine or glass-like amorphous structures.

There are two different approaches to provide ion bombardment assistance during PVD or CVD processes. Ion beam assisted deposition (IBAD) is a method which holds great promise for forming dense ceramic coatings on polymers and other temperature sensitive materials. The IBAD process is typically carried out under vacuum ($\sim 1 \times 10^{-5}$ Torr) in which a ceramic is thermally evaporated onto a substrate and simultaneously bombarded with energetic ions. The ion beam causes the deposited atoms to mix with the substrate, creating a graded layer, which can improve coating adhesion and reduce film stress. The impinging ions also produce a "shot-peening effect" which compacts and densifies the layer thereby reducing or eliminating columnar growth.

For example, during the IBAD processing of diamond-like carbon (DLC) films, carbon is evaporated by an electron beam source or sputtered by a magnetron source. Ion bombardment is provided by an independent broad-aperture ion beam source such as an argon ion beam. Such argon ion beams do not change the chemistry of the growing films and only influences its structure, morphology, binding energy and atom-to-atom bonding by lattice network modification. Addition of an appropriate gaseous precursor to the ion beam results in doping of the growing DLC films thereby providing a chemical vapor assistance during the IBAD process. An example of such silicon doping of DLC films are deposited from an Ar + $SiH_4$ ion beam. Fluoride can be added to the films via an Ar and fluorohydrocarbon ion beam, nitrogen can be added by using an Ar and $N_2$ ion beam, and boron can be added by using Ar+$BH_4$ ion beam. IBAD is a flexible technological process which allows control of coating properties in a broadened area by variation of the processing parameters: the ion beam composition, ion energy, ion current and the ion-to-atom arrival ratio.

Although the IBAD process works reasonably well, it has limitations due to its line-in-sight nature which is detrimental to achieving uniform coating distribution over complex shape components when the conformity of the coating deposition process is important. In addition, the IBAD process has limited scale up capability. The plasma immersion ion deposition (PIID) process overcomes some of these limitations by providing a low pressure plasma environment which effectively envelops the substrates to be coated within the uniform plasma cloud. This results in a highly uniform rate of ion bombardment over both 3-D complex shape substrates and large loads. The PVD or CVD process is used to generate vapor species for treatment of the substrate surface. In contrast to IBAD, the PIID is a non-line-of-sight process capable of treating complex surfaces without manipulation. PIID utilizes plasma generated from a gas discharge that fills in the entire processing chamber thereby allowing complex compositions and architectures to be coated. Examples of plasma immersion ion treatment include ionitriding, carbonitriding, ion implantation and other gaseous ion treatment processes that may be performed by immersing a substrate to be coated in a nitrogen containing plasma under negative bias. In addition, the electron current extracted from the plasma when substrates are positively biased can be used for pre-heating and heat treatment processes. Clearly, the non-line-of-sight processing feature presents numerous advantages over the line-of-sight processing, particularly for the efficient processing of a large quantity of three dimensional objects. The ionized gaseous environment used during the PIID processes can be generated by applying different types of plasma discharges, such as glow discharge, RF discharge, micro-wave (MW) discharge and low pressure arc discharge. Low pressure arc discharge is particularly advantageous in that it provides a dense, uniform highly ionized plasma over large processing volumes at low cost. In the arc discharge plasma assisted coating deposition or ion treatment processes, substrates are positioned between the arc cathode and the remote arc anode within the arc discharge plasma area. Thermionic filament cathodes, hollow cathodes, vacuum arc evaporating cold cathodes, and combinations thereof can be used as electron emitters for generating a gaseous low pressure arc plasma discharge environment. Alternatively, the conductive evaporative material itself can be used as a cathode or an anode of an ionizing arc discharge. This latter feature is provided in the vacuum cathodic arc deposition processes or in various arc plasma enhanced electron beam and thermal evaporation processes.

Deposition of a reacted coating like CrN may be accomplished by various physical vapor deposition techniques such as cathodic arc deposition, filtered arc deposition, electron beam evaporation and sputter deposition techniques. Electron beam physical vapor deposition (EBPVD) technology, both conventional and ionized, has been used in many applications, but is generally not considered a viable manufacturing technology in many fields because of batch-processing issues, difficulties of scaling up to achieve uniform coating distribution across large substrates and because of the difficulty of multi-elemental coating composition control due to thermodynamically driven distillation of the elements with different vapor pressures. In contrast, magnetron sputtering (MS) based PVD is used for a wide variety of applications due to the high uniformity of magnetron coatings at acceptable deposition rates, precise control of multi-elemental coating composition and the ability of the MS process to be easily integrated in fully automated industrial batch coating systems. Cathodic and anodic arc enhanced electron beam physical vapor deposition (EBPVD) processes dubbed hot evaporated cathode (HEC) and hot evaporated anode (HEA) respectively have demonstrated increased ionization rate, but suffer from arc spots instabilities and non-uniform distribution of the ionization rate across the EBPVD metal vapor flow. In these processes, the arc discharge is coupled with evaporation process making it difficult to provide independent control of ionization and evaporation rates in HEA and HEC processes. Therefore, it is extremely difficult to integrate PA-EBPVD processes in fully automated industrial batch coating systems.

Sputter techniques are well known in the art as being capable of cost effectively depositing thick reacted coatings although films beyond about one micron tend to develop haziness due to crystallization. The crystallization phenomenon or columnar film growth is associated with the inherent low energy of depositing atoms in sputter deposition techniques thereby creating an opportunity for energetically favored crystal structures. These crystal structures may have undesired anisotropic properties specific for wear and cosmetic applications. Various approaches have been developed over the last decade to enhance the ionization rate in a magnetron sputtering process. The main goal of these approaches is to increase the electron density along the pass of the magnetron sputtering atoms flow thereby increasing ionization of metal atoms by increasing the frequency of electron-atom collisions. The high power impulse magnetron sputtering (HIPIMS) process uses high power pulses applied to the magnetron target concurrently with DC power to increase electron emission and consequently increase the ionization rate of metal sputtering flow. This process demonstrates improved coating properties in the deposition of nitride wear resistant coatings for cutting tools. In the HIPIMS process, improved ionization is achieved only during short pulse times, while during pauses, the ionization rate is low as in conventional DC-MS processes. Since the pulse parameters are coupled with magnetron sputtering process parameters in the HIPIMS process, the sputtering rate, which is found to be almost three times lower than that of the conventional DC-MS process, can be adversely affected. Moreover, the high voltage pulses in the HIPIMS process may induce arcing on magnetron targets resulting in contamination of the growing films.

In order to generate a highly ionized discharge in a vicinity of magnetron targets, an inductively coupled plasma (ICP) source can be added in the region between the cathode and the substrate. A non-resonant induction coil is then placed parallel to the cathode in essentially a conventional DC-MS apparatus, immersed or adjacent to the plasma. The inductive coil is generally driven at 13.56 MHz using a 50 $\Omega$ rf power supply through a capacitive matching network. The rf power is often coupled to the plasma across a dielectric window or wall. Inductively coupled discharges are commonly operated in the pressure range of 1-50 mTorr and applied power 200-1000 W resulting in an electron density in the range of $10^{16}$-$10^{18}$ $m^{-3}$ which is generally found to increase linearly with increasing applied power. In a magnetron sputtering discharge, metal atoms are sputtered from the cathode target using dc or rf power. The metal atoms transit the dense plasma, created by the rf coil, where they are ionized. A water cooled inductive coil placed between the magnetron target and substrates to be coated adversely affects the metal sputtering flow. The MS setup is therefore much more complicated, expensive, and difficult to integrate into existing batch coating and in-line coating system. These disadvantages are also true for the microwave assisted magnetron sputtering (MW-MS) process. In the MW-MS process, the vacuum processing chamber layout must be re-designed to allow the metal sputtering flow crossing an ionization zone. However, the RF, MW and ICP approaches to ionizing the PVD process experience difficulties with plasma distribution uniformity over a large processing area, which is an obstacle for integration into large area coating deposition systems.

Another prior art technique for producing energetic ions is plasma enhanced magnetron sputtering (PEMS) which has a thermionic hot filament cathode (HF-MS) or hollow cathode (HC-MS) as a source of ionized electrons to increase the ionization rate in the DC-MS process. In the HF-MS process, a distant thermionic filament cathode is used as a source of ionizing electrons making this process similar to the HC-MS process. However, this process typically exhibits plasma non-uniformity and is difficult to integrate in industrial large area coating systems. Moreover, both hot filaments and hollow arc cathodes are sensitive and degrade quickly in the reactive plasma atmosphere. The disadvantages of these plasma generating processes are overcome by utilizing a cold evaporative vacuum arc cathode as a source of electrons for ionization and activation of a vapor deposition processing environment.

The cosmetic appearance of the conventional cathodic arc deposited films includes particulates of un-reacted target material called macros that renders the deposited film with defects undesired in applications requiring specific wear, corrosion and cosmetic properties. However, arc deposited films do not have a crystalline character unlike sputtered films because the arc evaporation process produces highly ionized plasma with a high energy of depositing atoms believed to effectively randomize crystal structures in the developing film.

Accordingly, there is a need for additional techniques of producing energetic particles in coating processes to produce improved film properties.

SUMMARY OF THE INVENTION

The present invention solves one or more problems of the prior art by providing in at least one embodiment a system for coating a substrate. The coating system includes a vacuum chamber and a coating assembly positioned within the vacuum chamber. The coating assembly includes a vapor source that provides material to be coated onto a substrate, a substrate holder to hold substrates to be coated such that the substrates are positioned in front of the vapor source, a cathode chamber assembly, and a remote anode. The cathode chamber assembly includes a cathode target, an optional primary anode and a shield which isolates the cathode from the vacuum chamber. The shield defines openings for transmitting an electron emission current from the cathode into the vacuum chamber. The vapor source is positioned between the cathode chamber assembly and the remote anode while the remote anode is electrically coupled to the cathode. The coating system also includes a primary power supply connected between the cathode target and the primary anode and a secondary power supply connected between the cathode target and the remote anode. Characteristically, the remote anode has a linear remote anode dimension, the vapor source has a linear vapor source dimension, the cathode target has a linear cathode target dimension, and the substrate holder has a linear holder dimension such that the linear remote anode dimension, the linear vapor source dimension, the linear cathode target dimension, and the linear holder dimension are parallel to each other, with the linear remote anode dimension being equal to or greater than the linear cathode target dimension and the linear vapor source dimension such that a confined plasma streams from the cathode target to the remote anode.

In another embodiment, a method of coating a substrate in the coating system set forth above is provided. The method includes a step of generating a primary arc in the electron emitting cathode source between the cathode target and the primary anode. A confined remote arc in a coating area is generated between the cathode chamber assembly and the remote anode such that metal vapor flow from the vapor source is generated toward at least one substrate to be coated. In still another embodiment, a coating system having a directed arc spot is provided. The coating system includes a vacuum chamber and a coating assembly positioned within the vacuum chamber. The coating assembly includes at least one sputtering source, a substrate holder to hold substrates to be coated such that the substrates are positioned in front of the sputtering source, and a plasma duct defining a first exit opening and a second exit opening. The coating assembly includes a cathode target for generating a metal plasma positioned in the plasma duct, a remote anode electrically coupled to the cathode target, a primary power supply for powering the cathode, and a secondary power supply connected between the cathode target and the remote anode. The sputtering source is positioned between the cathode target and the remote anode. A duct coil surrounds the plasma duct such that activation of the duct coil creating a transporting magnetic field within the plasma duct that is substantially parallel to an evaporating surface of the cathode target to direct the plasma away from the plasma duct extending to the sputtering source and/or substrates on the substrate holder during film deposition. A duct coil power supply activates the duct coil while a first trim electromagnet and a second trim electromagnet are positioned adjacent to opposite non-evaporating opposite sides of the cathode target where they generate a magnetic field above a surface of the cathode target.

In still another embodiment, a coating system having a remote anode is provided. The coating system includes a vacuum chamber and a coating assembly. The coating assembly includes a vapor source having a target face with a vapor source long dimension and a vapor face short dimension and a substrate holder to hold substrates to be coated such that the substrates are positioned in front of the vapor source. The substrate holder has a linear holder dimension. The coating assembly further includes a remote anode electrically coupled to the cathode target. The remote anode has a linear remote anode dimension. The coating assembly further includes a cathode chamber assembly having a cathode target, an optional primary anode and a shield which isolates the cathode target from the vacuum chamber. The cathode target having a linear cathode target long dimension and a linear cathode target short dimension. The shield defines at least one opening for transmitting an electron emission current of a remote arc discharge from the cathode target to the remote anode that streams along the target face long dimension. A primary power supply is connected between the cathode target and the primary anode while a secondary power supply is connected between the cathode target and the remote anode. Characteristically, the linear remote anode dimension and the vapor source short dimension are parallel to a dimension in which an arc spot is steered along the cathode target.

In still another embodiment, a method of coating a substrate in the coating systems herein is provided. The method includes steps of the generating a primary arc in the electron emitting cathode source between the cathode target and the primary anode; generating a confined remote arc in a coating area between the cathode chamber assembly and the remote anode; and generating metal vapor flow from the vapor source toward at least one substrate to be coated.

In still another embodiment, a coating system using electron emission current and/or metal vapor plasma is provided. The coating system includes a vacuum chamber and a coating assembly. The coating assembly includes a coating assembly. The coating assembly includes a vapor source, a substrate holder to hold substrates to be coated such that the substrates are positioned in front of the vapor source, a primary cathodic vacuum-arc assembly, a remote anode electrically coupled to the cathode target, a primary power supply connected between the cathode target and the primary anode, and a secondary power supply connected between the cathode target and the remote anode. The primary cathodic vacuum-arc assembly includes a cathode chamber assembly, a cathode target, an optional primary anode and a shield which isolates the cathode target from the vacuum chamber. The shield defines openings for transmitting electron emission current into the vacuum chamber while it remains impermeable for heavy particles of metal vapor plasma generating from the cathode target. The vapor source is positioned between the cathode chamber assembly and the remote anode. The remote anode has a linear remote anode dimension, the vapor source has a linear vapor source dimension, the cathode target has a linear cathode target dimension, and the substrate holder has a linear holder dimension such that the linear remote anode dimension, the linear vapor source dimension, and the linear holder dimension are parallel to each other. Characteristically, the linear remote anode dimension is equal to or greater than the linear vapor source dimension such that a confined plasma streams from the cathode target to the remote anode. Moreover, the linear vapor source dimension can be a long side that is parallel to linear cathode target dimension with the linear vapor source dimension being parallel to the linear cathode target dimension. Alternatively, linear vapor source dimension can be a short side that is parallel to linear cathode target dimension.

In still another embodiment, a coating system is provided. The coating system includes a coating chamber and a vapor source having a target face with a vapor source long dimension and a vapor face short dimension. The coating system also includes a substrate holder to hold substrates to be coated such that the substrates are positioned within the coating chamber and in front of the vapor source. The substrate holder has a linear holder dimension. A dual filtered arc unidirectional rectangular plasma source operates as a metal vapor plasma coating deposition source and an electron emitting source. The unidirectional dual filtered arc source includes a rectangular plasma duct having deflecting section and an exit tunnel section, a first cathodic arc chamber having a first cathode target, a second cathodic arc chamber having a second cathode target, and a baffled anode plate. The first cathodic arc chamber and the second cathodic arc chamber are separated by the baffled anode plate and positioned on opposite sides of a deflecting section. The coating system also includes a remote anode electrically coupled to the first cathode target and the second cathode target, a primary power supply connected between the cathode target and a primary anode, and a secondary power supply connected between the cathode target and the remote anode. Characteristically, the remote anode has a linear remote anode dimension and the vapor source has a linear vapor source dimension.

According to a first aspect of the present invention, there is provided a coating system comprising: a coating chamber; a vapor source having a target face with a vapor source long dimension and a vapor face short dimension; a substrate holder to hold substrates to be coated such that the substrates are positioned within the coating chamber and in front of the vapor source, the substrate holder having a linear holder dimension; a dual filtered arc unidirectional rectangular plasma source operating as a metal vapor plasma coating deposition source and an electron emitting source, the unidirectional dual filtered arc source including a rectangular plasma duct having deflecting section and an exit tunnel section, a first cathodic arc chamber having a first cathode target, a second cathodic arc chamber having a second cathode target, and a baffled anode plate, the first cathodic arc chamber and the second cathodic arc chamber separated by the baffled anode plate and positioned on opposite sides of a deflecting section; a remote anode electrically coupled to the first cathode target and the second cathode target, the remote anode having a linear remote anode dimension, the vapor source having a linear vapor source dimension; a primary power supply connected between the cathode target and a primary anode; and a secondary power supply connected between the cathode target and the remote anode, wherein a confined remote arc plasma streams from the cathode target to the remote anode through a narrow corridor between the chamber walls and substrates to be coated while substrates are positioned in front of the vapor sources during coating.

In embodiments, the coating system further comprises deflecting coils surrounding a deflection portion of the plasma duct.

In embodiments, the coating system further comprises stabilizing coils that surround the cathode chambers and confine confining cathodic arc spots at evaporable surface of the cathode targets.

In embodiments, the coating system further comprises focusing coils surrounding an exit portion of the cathode chambers that focus a metal vapor plasma stream towards a deflection portion of the plasma duct.

In embodiments, the coating system further comprises a first magnetron source and a second magnetron source positioned as an exit tunnel portion of the plasma duct, the first magnetron source and the second magnet source regulating the degree of ion bombardment by metal ions during a hybrid filtered arc enhanced magnetron sputtering coating deposition process.

In embodiments, the coating system further comprises a shielded cathodic arc electron emission source located centrally in the coating chamber.

In embodiments, the coating system is configured to operate in an inline mode.

In embodiments, the coating system is configured to operate in a batch mode.

According to a second aspect of the present invention, there is provided a coating system comprising: a vacuum chamber; and a coating assembly positioned in the vacuum chamber, the coating assembly including: a vapor source; a substrate holder to hold substrates to be coated such that the substrates are positioned in front of the vapor source; a primary cathodic vacuum-arc assembly including a cathode chamber assembly, a cathode target, an optional primary anode and a shield which isolates the cathode target from the vacuum chamber, the shield defining openings for transmitting either electron emission current or metal vapor plasma from the cathode target into the vacuum chamber; a remote anode electrically coupled to the cathode target; a primary power supply connected between the cathode target and the primary anode; and a secondary power supply connected between the cathode target and the remote anode, the vapor source being positioned between the cathode chamber assembly and the remote anode, the remote anode having a linear remote anode dimension, the vapor source having a linear vapor source dimension, the cathode target having a linear cathode target dimension, and the substrate holder having a linear holder dimension such that the linear remote anode dimension, the linear vapor source dimension, and the linear holder dimension are parallel to each other, with the linear remote anode dimension being equal to or greater than the linear vapor source dimension such that a confined plasma streams from the cathode target to the remote anode.

In embodiments, the linear vapor source dimension is a long side that is parallel to linear cathode target dimension, the linear vapor source dimension being parallel to the linear cathode target dimension.

In embodiments, the linear vapor source dimension is a short side that is parallel to linear cathode target dimension.

In embodiments, the primary anode is a ground or the shield.

In embodiments, the system further comprises at least one additional vapor source positioned between the cathode chamber assembly and the remote anode.

In embodiments, perpendicular distances between each of the vapor sources and the substrates to be coated are substantially equal and the distance between the cathode chamber assembly and the remote anode is less than the distance at which breakdown occurs when an applied voltage of the secondary power supply exceeds 1.2 to 10 times the applied voltage of the primary power supply.

In embodiments, a plurality of cathode targets are coupled to the remote anode, each cathode target of the plurality of cathode targets having a linear cathode target dimension that is parallel to the linear remote anode dimension.

In embodiments, a separation from the top of the cathode chamber assembly to substrates is from about 2 to 20 inches.

In embodiments, an external magnetic field is applied along a region between the vapor source and the substrates to be coated.

In embodiments, the external magnetic field is applied to magnetically insulate the cathode target of the cathode chamber assembly.

In embodiments, the external magnetic field is applied to magnetically insulate the anode of the remote anode.

In embodiments, the vapor source comprises a component selected from the group consisting of a magnetron, a thermal evaporator, an electron beam evaporator, and a cathodic arc evaporator.

In embodiments, the cathode target comprises a component selected from the group consisting of a cold vacuum arc cathode, a hollow cathode, a thermionic filament cathode, an electron beam evaporator, and combinations thereof.

In embodiments, the cathode target is made of metal having a gettering capability including titanium and zirconium alloys.

In embodiments, the shield of the cathode chamber is water cooled and negatively biased in relation to the cathode target wherein a bias potential of the shield ranges from -50 volts to -1000 volts

In embodiments, plasma probes are installed between the cathode chamber assembly and the remote anode to measure plasma density, the plasma probes providing feedback for controlling the secondary power supply in which a remote anode current is adjusted to obtain a uniform distribution of the plasma density between the cathode chamber assembly and the remote anode.

In embodiments, the cathode target is part of a cathode array having a plurality of cathode targets installed in the cathode chamber assembly, a linear dimension of each cathode target being substantially equal to the linear dimension of the remote anode.

In embodiments, the cathode target is a plate or a bar.

In embodiments, a plurality of slave remote anodes are connected to the remote anode via variable resistors.

In embodiments, a plurality of slave remote anodes are connected to the remote anode with capacitors.

In embodiments, the system comprises a plurality of coating assemblies.

In embodiments, the plurality of coating assemblies is aligned essentially inline.

In embodiments, the vapor source, the cathode target and the remote anode are distributed along a linear direction with the substrate holder moving along the linear direction.

In embodiments, the vacuum chamber has a circular cross section with the cathode target and the remote anode distributed about a central axis of the vacuum chamber with the substrate holder moving in a circular direction.

In embodiments, the primary cathodic vacuum-arc assembly includes a filtered cathodic vacuum-arc source.

In embodiments, the filtered cathodic vacuum-arc source includes a cathode target and a plasma duct, the plasma duct having a long side, the plasma duct having a bend section along a centerline of the plasma duct, the plasma duct having a cathode chamber portion and an exit tunnel portion on opposite sides of the bend.

In embodiments, the plasma duct has a rectangular cross-sectional shape of similar dimensions to the cathode target.

In embodiments, the cathode chamber assembly includes a rectangular tube.

In embodiments, the cathode target is mounted on an isolated holder at an end of cathode chamber portion so that an evaporable surface of the cathode target faces into the plasma duct.

In embodiments, the bend has an angle from about 60 to 120 degrees.

In embodiments, the system further includes a magnetic shutter having deflecting magnets and focusing electromagnets disposed about the plasma duct, the deflecting magnets positioned about an outer side of the cathode chamber and the bend section, the focusing electromagnetics positioned at the exit of the plasma duct.

In embodiments, the magnetic shutter is open when both deflection electromagnets and the focusing electromagnets are activated such that ionized filtered metal vapor plasma generated at the cathode target are transported through the plasma duct toward substrates.

In embodiments, a gaseous environment is also highly ionized within a narrow corridor defined between the substrates and walls of the vacuum chamber along a remote arc discharge path.

In embodiments, the vapor sources includes a plurality of magnetron sputtering source that combines discharge with a remote anode arc discharge thereby allowing an increase ionization of the magnetron sputtering source.

In embodiments, the magnetic shutter is closed when the deflecting magnets and the focusing electromagnets are not activated such that metal vapor plasma generated by the cathode target is trapped within the plasma duct while a remote anode arc discharge runs between the cathode target and the remote anode providing ionization and activation of coating deposition environment along a corridor defined between the substrates and walls of the vacuum chamber.

In embodiments, a plurality of magnetron sputtering sources and remote anodes are positioned on a hub in a central region of the vacuum chamber such that a remote arc discharge fill a region between the hub and walls of the vacuum chamber.

In embodiments, the vapor source include a bi-directional filtered arc source having a bi-directional plasma duct the remote anodes installed at a peripheral rim of the bi-directional plasma duct, a remote anode arc discharge being established along a corridor defined between an outer rim of the plasma duct and the substrates.

In embodiments, the bi-directional plasma duct further includes shields at both ends of the bi-directional plasma duct.

In embodiments, the remote anode arc discharge is supported either by a unidirectional filtered vacuum-arc source and/or by the bi-directional filtered arc source, such that a remote anode arc discharge plasma fills a coating deposition area defined between an outer wall of the bi-directional filtered arc source and walls of the vacuum chamber.

In embodiments, the bi-directional filtered arc source and the unidirectional filtered arc source are configured to operate concurrently and independently in a magnetic shutter mode while coupled with magnetron sputtering sources.

In embodiments, the system further comprises a first additional magnetron source and a second additional magnetron source positioned adjacent to the exit of the plasma duct in the vacuum chamber facing the substrates such that the magnetron sputtering flow is merging with the cathode target of the filtered arc source.

In embodiments, the system further comprises two magnetron sources positioned at the exit of the plasma duct.

In embodiments, the system is configured to operate in an inline mode.

In embodiments, the system is configured to operate in a batch mode.

BRIEF DESCRIPTION OF THE DRAWINGS

Exemplary embodiments of the present invention will become more fully understood from the detailed description and the accompanying drawings, wherein:

FIGURE 1A is an idealized side view of a coating system using a remote arc discharge plasma;

FIGURE 1B is a front view of the coating system perpendicular to the view of Figure 1A;

FIGURE 1C is a schematic of the coating system of Figure 1A;

FIGURE 1D is a schematic illustration showing confinement of the plasma jet streaming between the cathode and remote anode;

FIGURE 1E is a schematic of a multi-element cathode used to raster a plasma jet;

FIGURE 1F is a schematic illustration of a coating system having substrates positioned between a sputtering source and an anode;

FIGURE 1G is a schematic illustration of a coating system having an anode of thin wires;

FIGURE 2 provides a typical distribution of the plasma potential between the screen and the remote anode obtained by finite element modeling;

FIGURE 3 provides the intensity of the radiation emitted by excited argon atoms (spectral line ArI 739.79 nm) from the remote arc discharge plasma versus the discharge current;

FIGURE 4A provides a schematic of a coating system having additional remote anodes positioned between the magnetron sputtering source with additional shielded cathode chamber assemblies added to secure the uniformity and high ionization of a gaseous plasma environment;

FIGURE 4B provides a schematic illustration of a coating system which includes variable resistors installed between a master anode and each of a plurality of slave anodes;

FIGURE 4C provides a refinement in which a resistor in parallel with a capacitor is used to set the voltage potentials of the intermediate anode;

FIGURE 5 provides a schematic illustration of an inline modular configuration of a RAAMS system;

FIGURE 6 provides a diagram of potential distribution in RAD plasma processing;

FIGURE 7A provides a schematic illustration of a batch coating system with a centrally located shielded cathode chamber;

FIGURE 7B provides a schematic illustration of a batch coating system with a centrally located shielded cathode chamber;

FIGURE 8A is a schematic illustration of a variation of the system of Figures 7A and 7B;

FIGURE 8B is a schematic illustration of a variation of the system of Figures 7A and 7B;

FIGURE 8C is a schematic illustration of a variation of the system of Figures 7A and 7B;

FIGURE 8D is a schematic illustration of a variation of the system of Figures 7A and 7B;

FIGURE 8E is a schematic illustration of a variation of the system of Figures 7A and 7B;

FIGURE 8F is a schematic illustration of a variation of the system of Figures 7A and 7B;

FIGURE 8G is a schematic illustration providing magnetic contours for the systems of Figures 8A-8C;

FIGURE 8H is a schematic illustration providing magnetic contours for the systems of Figures 8A-8C;

FIGURE 9A is a schematic illustration of a coating system having additional magnetrons;

FIGURE 9B is a schematic illustration of a coating system having additional magnetrons;

FIGURE 9C is a schematic illustration of a coating system having additional magnetrons;

FIGURE 9D is a schematic illustration of a coating system having additional magnetrons;

FIGURE 9E is a schematic illustration of a coating system having additional magnetrons;

FIGURE 10 provides a schematic description of the physical processes which are involved in the bi-directional remote arc discharge;

FIGURE 11A provides a schematic of a batch coating system with a peripherally located shielded cathode chamber assembly;

Figure 11B is a schematic illustration of a coating system incorporating a rectangular unidirectional filtered cathodic arc source as both metal vapor plasma deposition source and electron emitting source;

FIGURE 11C is a schematic illustration of a coating system having centrally located magnetrons and a rectangular unidirectional filtered cathodic arc source as both metal vapor plasma deposition source and electron emitting source;

FIGURE 11D is a schematic illustration of a coating system having bi-directional filtered arc source and a rectangular unidirectional filtered cathodic arc source as both metal vapor plasma deposition source and electron emitting source;

FIGURE 11E is a schematic illustration of a coating system having bi-directional filtered arc source without the shield and a rectangular unidirectional filtered cathodic arc source as both metal vapor plasma deposition source and electron emitting source;

FIGURE 11F is a schematic illustration of a variation of the system of Figure 11E having magnetron sources at the tunnel section of the unidirectional filtered cathodic arc source;

FIGURE 11G is a schematic illustration of a variation of the system of Figure 11C that uses a surface treatment system;

FIGURE 11H is a schematic illustration of a coating system having bi-directional filtered arc source and a surface treatment system magnetron sources at the tunnel section of the treatment system;

FIGURE 12A is a schematic illustration of a further variation having a shielded cathodic arc electron emission source located in the center of the coating chamber;

FIGURE 12B is a schematic illustration of a coating system incorporating a unidirectional filtered cathodic arc source as both metal vapor plasma deposition source and electron emitting source;

FIGURE 12C is a schematic illustration of a coating system having a central hub and a unidirectional filtered cathodic arc source as both metal vapor plasma deposition source and electron emitting source;

FIGURE 12D provides a schematic illustration of a coating system having a cylindrical cathodic arc source with rotating tubular cathode target;

FIGURE 13A provides a schematic illustration of a system incorporating an electron emitting vacuum arc cold cathode source are provided;

FIGURE 13B is a schematic illustration of an inline system using the cylindrical cathodic arc source of Figure 13A as a primary cathodic arc electron emitting source;

FIGURE 13C is a schematic illustration of a coating system using the rectangular filtered arc source of Figure 11B;

FIGURE 13D is a schematic illustration of an inline coating system using the unidirectional dual filtered arc source described for Figure 11G;

FIGURE 13E is a schematic illustration of an inline coating system using the unidirectional dual filtered arc source described for Figure 11G with two magnetron sources at the exit tunnel of the arc source;

FIGURE 13F is a schematic illustration of an inline coating system with a cylindrical cathodic arc source;

FIGURE 13G is a schematic illustration of an inline coating system using the cylindrical primary cathodic arc source as previously described in relation to Figure 13B;

FIGURE 13H illustrates the design of the vacuum cathodic arc source with short cylindrical target and magnetically steered arc spots;

FIGURE 13I is a perspective view of rotary target magnetron metal vapor source utilizing the short cylindrical cathodic arc electron emitting source;

FIGURE 13J is a side view of rotary target magnetron metal vapor source utilizing the short cylindrical cathodic arc electron emitting source;

FIGURE 13K is a front side of rotary target magnetron metal vapor source utilizing the short cylindrical cathodic arc electron emitting source;

FIGURE 13L is a schematic illustration of a variation of the system of Figure 13I-K;

FIGURE 13M is a schematic illustration of a variation of the system of Figure 13I-K;

FIGURE 14A provides a schematic illustration of a variation of a coating system incorporating a macroparticle filter;

FIGURE 14B provides a top view for duct assemblies of a macroparticle filter;

FIGURE 14C provides a perspective view for duct assemblies of a macroparticle filter;

FIGURE 15A provides a perspective of the cylindrical cathodic arc source surrounded by a plurality of blades;

FIGURE 15B provides a schematic cross section of the cylindrical cathodic arc source surrounded by a plurality of blades;

FIGURE 15C provides a schematic perspective view of a cylindrical cathodic arc source surrounded by a plurality of blades at a 30 degree angle;

FIGURE 15D provides a schematic top view of a cylindrical cathodic arc source surrounded by a plurality of blades at a 30 degree angle;

FIGURE 15E provides a schematic perspective view of a cylindrical cathodic arc source surrounded by a plurality of blades at a 60 degree angle;

FIGURE 15F provides a schematic top view of a cylindrical cathodic arc source surrounded by a plurality of blades at a 60 degree angle;

FIGURE 15G provides a schematic illustration of a bidirectional cylindrical cathodic arc source with rotating target utilizing a set of plasma guiding magnetic baffles is provided;

FIGURE 15H provides a coating system similar to one shown in Figure 14A, utilizing the cathode chamber design of Figure 15G;

FIGURE 16A is a schematic of a substrate with a coating made by a remote arc discharge plasma assisted process; and

FIGURE 16B is a schematic of a substrate with a multilayer coating made by a remote arc discharge plasma assisted process.

DESCRIPTION OF THE INVENTION

Reference will now be made in detail to presently preferred compositions, embodiments and methods of the present invention, which constitute the best modes of practicing the invention presently known to the inventors. The Figures are not necessarily to scale. However, it is to be understood that the disclosed embodiments are merely exemplary of the invention that may be embodied in various and alternative forms. Therefore, specific details disclosed herein are not to be interpreted as limiting, but merely as a representative basis for any aspect of the invention and/or as a representative basis for teaching one skilled in the art to variously employ the present invention.

Except in the examples, or where otherwise expressly indicated, all numerical quantities in this description indicating amounts of material or conditions of reaction and/or use are to be understood as modified by the word "about" in describing the broadest scope of the invention. Practice within the numerical limits stated is generally preferred. Also, unless expressly stated to the contrary: percent, "parts of," and ratio values are by weight; the description of a group or class of materials as suitable or preferred for a given purpose in connection with the invention implies that mixtures of any two or more of the members of the group or class are equally suitable or preferred; description of constituents in chemical terms refers to the constituents at the time of addition to any combination specified in the description, and does not necessarily preclude chemical interactions among the constituents of a mixture once mixed; the first definition of an acronym or other abbreviation applies to all subsequent uses herein of the same abbreviation and applies *mutatis mutandis* to normal grammatical variations of the initially defined abbreviation; and, unless expressly stated to the contrary, measurement of a property is determined by the same technique as previously or later referenced for the same property.

It is also to be understood that this invention is not limited to the specific embodiments and methods described below, as specific components and/or conditions may, of course, vary. Furthermore, the terminology used herein is used only for the purpose of describing particular embodiments of the present invention and is not intended to be limiting in any way.

It must also be noted that, as used in the specification and the appended claims, the singular form "a," "an," and "the" comprise plural referents unless the context clearly indicates otherwise. For example, reference to a component in the singular is intended to comprise a plurality of components.

Throughout this application, where publications are referenced, the disclosures of these publications in their entireties are hereby incorporated by reference into this application to more fully describe the state of the art to which this invention pertains.

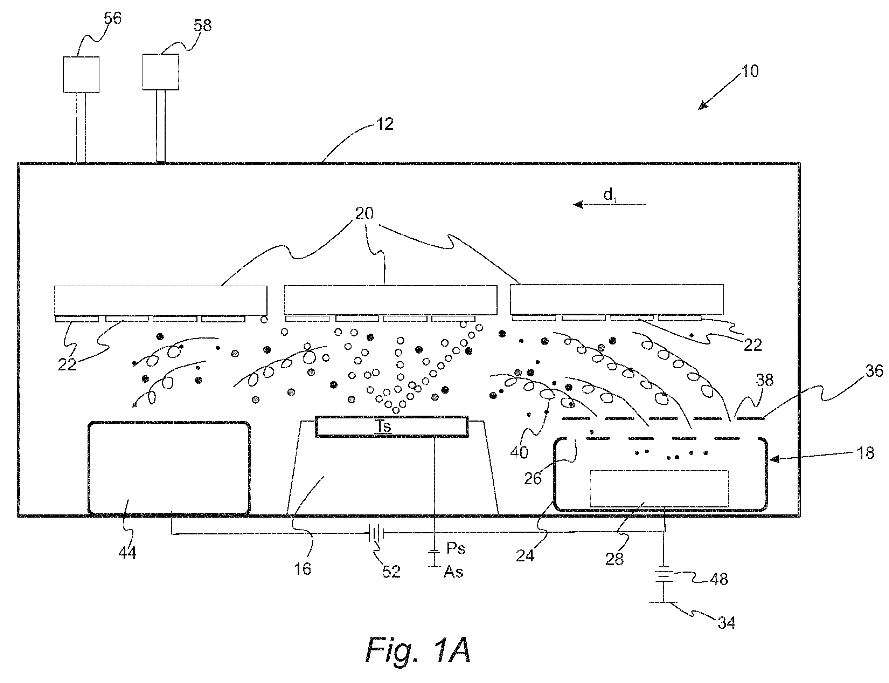

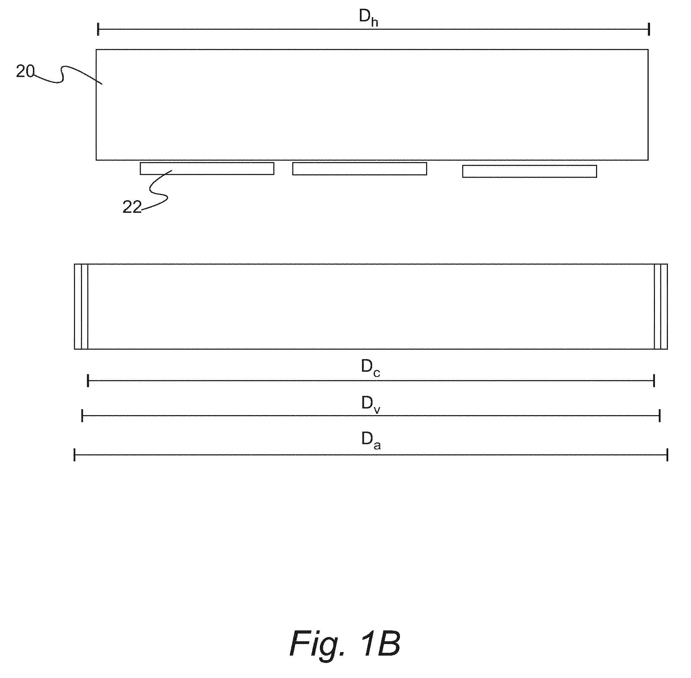

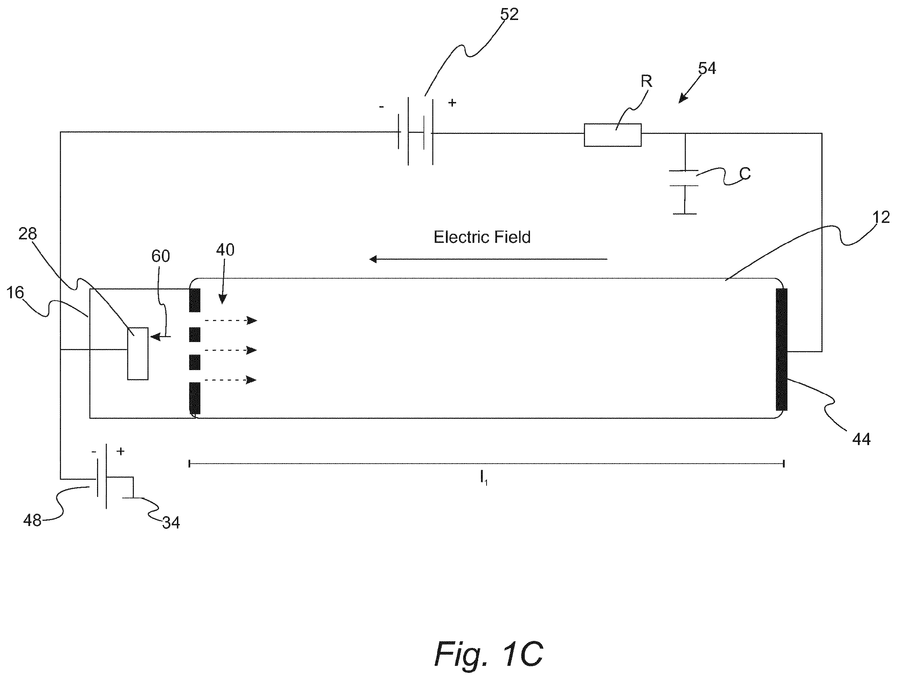

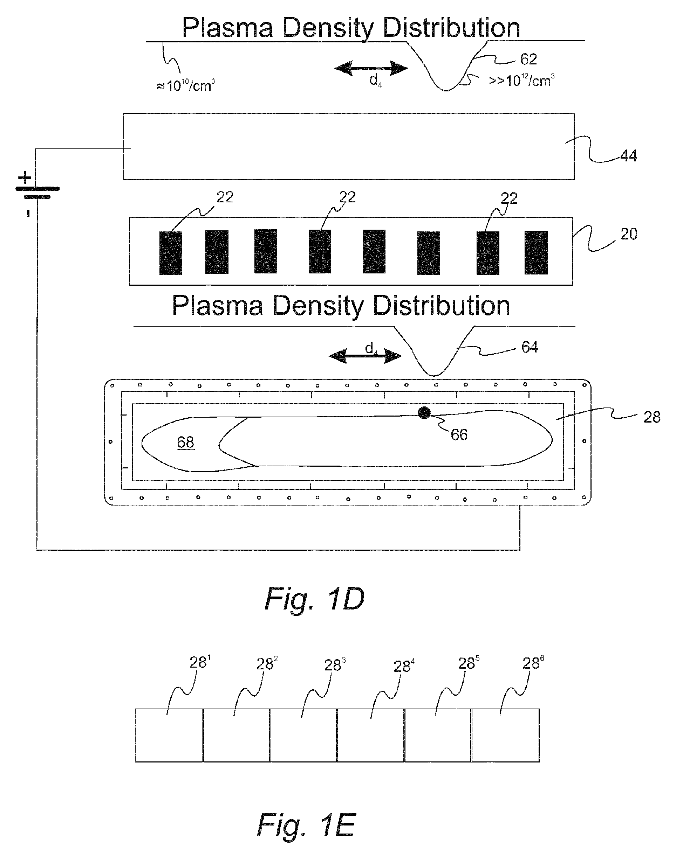

With reference to Figures 1A, 1B, 1C and 1D, a coating system that uses a remote arc discharge plasma is provided. Figure 1A is an idealized side view of the coating system. Figure 1B is a front view perpendicular to the view of Figure 1A. Figure 1C is a schematic of the coating system including electrical wiring. The system of this embodiment is particularly useful for arc plasma enhancement of large area magnetron sputtering coating deposition processes. Coating system 10 includes vacuum chamber 12 with a coating assembly positioned therein. The coating assembly includes vapor source 16, cathode chamber assembly 18 positioned in vacuum chamber 12, and substrate holder 20 to hold substrates 22 to be coated. Figures 1A and 1B depict a variation in which vapor source 16 is a magnetron sputtering source so that the coating process of system 10 is a remote arc assisted magnetron sputtering (RAAMS) process. Such magnetron sputtering sources include a target Ts, a power supply Ps, and an anode As. It should be appreciated that other types of vapor sources may be utilized for vapor source 16. Examples of such vapor sources include, but are not limited to, thermal evaporators, electron beam evaporators, cathodic arc evaporators, and the like. Substrates 22 are positioned in front of the vapor source 16 during coating and move along direction $d_1$ during deposition of the coating. In a refinement, substrates may be continuously introduced from a load-lock chamber at the right of vacuum chamber 12 and received by an output chamber at the left of vacuum chamber 12 in Figure 1A. Cathode chamber assembly 18 includes a cathode enclosure 24 with openings 26 defined therein, electron emitting cathode 28, an optional separate primary anode 34 and shield 36. Shield 36 isolates electron emitting cathode 28 from vacuum chamber 12. In a refinement, optional separate anode 34, cathode enclosure 24, shield 36, or a ground connection operate as the primary cathode-coupled anode.

Cathode chamber assembly 18 operates as an electron emitting cathode source in the context of the present embodiment. In a refinement, a primary arc is generated in the electron emitting cathode source between cathode 28 and the primary anode. The cathode enclosure 24 can serve both as an independent primary anode connected to the positive pole of the primary arc power supply 48 and as a grounded anode, when it is connected to the ground 34. Shield 36 defines openings 38 for transmitting electron emission current 40 from cathode 28 into vacuum chamber 12. The shield can be floating or it can be connected to the positive pole of either primary arc power supply 48 or an additional power supply (not shown). In another refinement, cathode 28 is a cathodic arc cathode and the grounded primary anode 34 is a cathodic arc anode. Any number of different cathodes may be used for electron emitting cathode 28. Examples of such cathodes include, but are not limited to, cold vacuum arc cathodes, hollow cathodes, thermionic filament cathodes, and the like, and combinations thereof. Typically, the cathode target is made of metal having a gettering capability including titanium and zirconium alloys. In a refinement, the shield of the cathode chamber is water cooled and negatively biased in relation to the cathode target wherein the bias potential of the shield ranges from -50 volts to -1000 volts. In still another refinement, cathode chamber assembly 18 includes a cathode array having a plurality of cathode targets installed therein with the height of cathode target array being substantially the same height of the remote anode and the height of a deposition area. Separation from the top of the cathode chamber assembly or vapor source 16 to substrates 22 (i.e., top of the substrates) is such that the plasma streaming from cathode 28 to remote anode 44 is confined. Typically, separation distance from the shield 36 of the cathode chamber assembly or from the evaporation surface of the vapor source 16 or from the remote anode 44 to substrates 22 is from about 2 inches to about 20 inches, which result in a formation of a narrow corridor for confinement of the remote arc plasma between the cathode 28 in a cathode chamber 18 and the remote anode 44. When the width of this corridor is less than 2 inches it creates high impedance in plasma leading to plasma instabilities and eventually extinguishing of the remote arc discharge. When the width of this corridor is greater than 20 inches the plasma density in the remote arc discharge is not increasing enough to ionize the metal sputtering flow. In a particularly useful refinement, a large area cathode target having a shape of plate or bar is installed in the cathode chamber assembly 18. Typically, such a large area cathode target has a height that is substantially equal to the height of the anode and the height of a deposition area. In a refinement, the cathode target can be made of the metal having a gettering capability such as for example titanium alloy or zirconium alloy. In this case the shielded cathode electron emitting source can also serve as a vacuum gettering pump which can improve pumping efficiency of the coating system. To further improve the gettering pumping efficiency the shield 36 facing the evaporating surface of the cathode target 28 in the cathode chamber 18 can be water cooled and optionally connected to high voltage bias power supply. When the water cooled shield 36 is biased to high negative potential ranging from -50V to -1000V in relation to the cathode target 28, it will be subjected to intense ion bombardment by metal ions generating by the cathodic arc evaporating process. Condensation of metal vapor under conditions of intense ion bombardment is favorable for pumping noble gases such as He, Ar, Ne, Xe, Kr as well as hydrogen.

System 10 also includes remote anode 44 electrically coupled to cathode 28, primary power supply 48 connected between cathode 28 and the primary cathode-coupled anode. Remote anode 44 is positioned in vacuum chamber 12 such that vapor source 16 is positioned between cathode chamber assembly 18 and the remote anode. In a refinement, a plurality of vapor sources is positioned between cathode chamber assembly 18 and remote anode 44 as set forth below in more detail. System 10 also includes secondary power supply 52 which electrically couples cathode 28 to remote anode 44. Low pass filter 54 is also depicted in Figure 1A which includes resistor R and capacitor C. Typically, vapor source 16 is positioned between cathode chamber assembly 18 and remote anode 44. System 10 further includes pumping system 56 for maintaining a reduced pressure and gas system 58 for introducing one or more gases (e.g., argon, nitrogen, helium, etc.) into deposition chamber 12. In a refinement, secondary power supply 52, which powers the distant arc discharge in coating chamber 12 is installed between cathode chamber assembly 18 and remote anode 44 and provides at least 20% higher open circuit voltage than primary power supply 48.

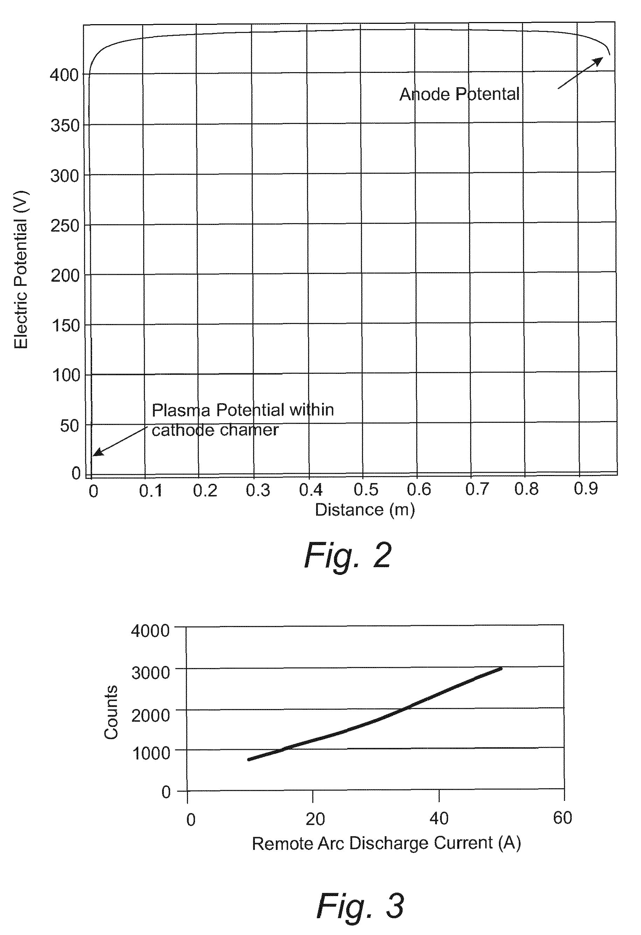

Still referring to Figures 1A, 1B, 1C, and 1D, a primary arc is initiated by arc igniter 60 in a cathode chamber 24 isolated from the discharge chamber by shield 36 with openings 38 for transmission of the electron current 40. Typically, the plasma potential near the screen is low, close to the plasma potential in cathode chamber assembly 18, while in the remote arc discharge plasma, the electric potential is high, close to the electrical potential of remote anode 44. Figure 2 provides a typical distribution of the plasma potential between the screen and the remote anode obtained by finite element modeling. Surprisingly, the present coating system is found to produce a confined plasma arc that streams from cathode chamber assembly 18 to remote anode 44. Figure 1D provides a schematic illustration showing the movement of the plasma density between remote anode 44 and cathode 28. A confined plasma streams (i.e., a plasma jet) between the remote anode and the cathode through the coating region. The ends of the confined plasma move along direction $d_4$ as set forth in Figure 1D. An arc spot 66 forms on cathode 28 along with erosion zone 68 The plasma field 62 at remote anode 44 and the plasma field 64 at cathode 28 are confined dimensionally in a space from about 1 to 5 inches along direction $d_4$. In one refinement, magnetic fields are used to accomplish the rastering movement along $d_4$. In other refinement, this rastering movement is accomplished by mechanically moving cathode 28 along direction $d_4$. In still other refinements, an emission filament bombarding cathode with electrons is moved along $d_4$. In still other refinements as shown in Figure 1E, the cathode includes a plurality of cathode elements $28^{1-6}$ which are sequentially activated in order to form a plasma jet moving along $d_4$. The confinement of the plasma arc results in a high density and hot plasma jet connecting cathodic arc spots at the primary cathode with an associated area at the remote anode running through a relatively narrow corridor created between the chamber walls (with primary cathodes, anodes and magnetrons attached) and substrate holder. This results in a high current density in the moving plasma jet connecting the cathode and remote anode. In a refinement, the current density in RAAMS plasma within this narrow corridor is from 0.1mA/cm$^2$ up to 100A/cm$^2$. Typically, the electron density $n_e$ in the background remote arc plasma ranges from about

$n_e \sim 10^8$ cm$^{-3}$ to about $n_e \sim 10^{10}$ cm$^{-3}$ while within the confined arc plasma jet area the electron density ranges from about $n_e \sim 10^{10}$ cm$^{-3}$ to about $n_e \sim 10^{13}$ cm$^{-3}$. The confinement creating the plasma jet is a result of the physical dimensional relations between the components as set forth below as well as the application of magnetic fields. In particular, the discharge operates at very high plasma potential which corresponds to a high energy of ion bombardment (i.e., the ion bombardment energy is the difference between the plasma potential (vs. ground) and the substrate bias potential (vs. ground)). Even at floating and grounded substrates, ions with 50-70eV are obtained because the plasma potential is above 50 V. In a refinement, the plasma potential is from 5V to 500V.

With reference to Figures 1A and 1B, an aspect of the relative sizing of various components of coating system 10 is provided. Remote anode 44 has a linear remote anode dimension $D_a$. Vapor source 16 has a linear vapor source dimension $D_v$. Cathode target Ts has a linear cathode target dimension $D_c$. Substrate holder 20 has a linear holder dimension $D_h$. In a refinement, the linear remote anode dimension $D_a$, the linear vapor source dimension $D_v$, the linear cathode target dimension $D_c$. and the linear holder dimension $D_h$ are parallel to each other. In another refinement, the linear remote anode dimension $D_a$ is greater than or equal to the linear vapor source dimension $D_v$ which is greater than or equal to the linear cathode target dimension $D_c$ which is greater than or equal to the linear holder dimension $D_h$.

In a variation of the present embodiment, several remote anodes are associated with (i.e., electrically coupled to) at least one arc cathode positioned in the shielded cathodic chamber assembly 18. The remote anodes are positioned at strategic positions within the coating chamber.

In another variation, the perpendicular distances between each of the vapor sources (e.g., vapor source 16) and substrates 22 to be coated is substantially equal. Moreover, in a further refinement, the distance between cathode 28 and remote anode 44 is less than the distance at which breakdown occurs when an applied voltage of secondary power supply 52 exceeds 1.2 to 30 times the applied voltage of primary power supply 48.

In still another refinement of the present embodiment, plasma probes are installed between the cathode 28 and remote anode 44 to measure plasma density. Such measurements provide a feedback so that the second power supply 52 is adjusted to provide adjusting a remote anode current to remote anode 44 to obtain a uniform distribution of the plasma density between cathode chamber assembly 18 and remote anode 44.

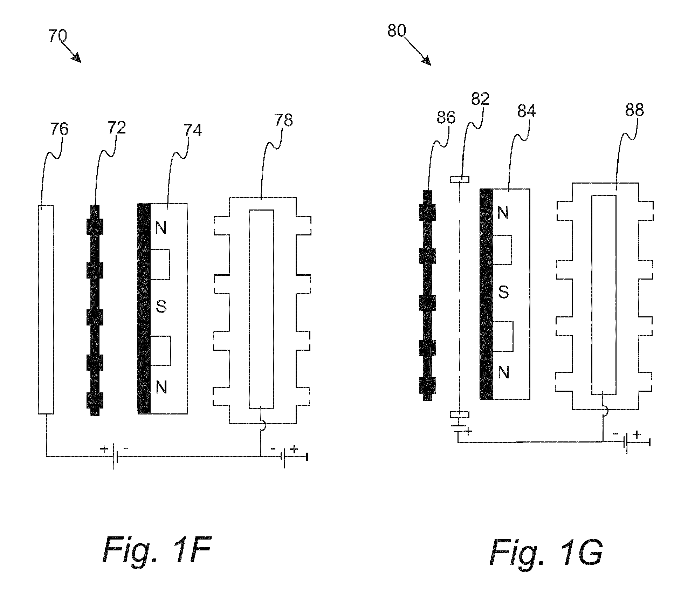

With reference to Figures 1F and 1G, alternative configurations of remote plasma systems are provided. Figure 1F provides a schematic illustration of a coating system having substrates positioned between a sputtering source and an anode. Coating system 70 includes substrate holder 72 positioned between magnetron sputtering source 74 and anode 76. Coating system 70 also includes cathode chamber 78 which is of the design set forth above. This configuration increases remote arc plasma density providing a higher ion bombardment assistance rate during magnetron sputtering. Figure 1G provides a schematic illustration of a coating system having an anode of thin wires. Coating system 80 includes anode 82 which is composed of thin wires. Anode 82 is installed between magnetron target 84 and substrate holder 86. Coating system 80 also includes cathode chamber 88 as set forth above. In this latter configuration, a denser zone of the remote arc discharge plasma is created in the gap between the magnetron target and substrates to be coated.

Remote arc plasma modeling of the present embodiment is characterized by the electric potential distribution between cathode chamber assembly 18 and remote anode 44 and by the plasma density in the remote arc discharge plasma. The plasma potential in the remote arc discharge plasma and the anode potential increase as the remote discharge current increases. The plasma density in the remote arc discharge plasma increases almost proportional to the discharge current. This result is verified by optical emission spectroscopy of the remote arc discharge plasma. Figure 3 shows the intensity of the radiation emitted by excited argon atoms (spectral line ArI 739.79 nm) from the remote arc discharge plasma versus discharge current. It can be seen that the intensity of light emission from the argon atoms excited by direct electron impact is nearly proportional to the discharge current. This phenomenon is explained by the direct proportional relationship between electron concentration in the remote arc plasma and the remote arc discharge current. The ion concentration in the remote arc discharge is nearly equal to the electron concentration such that plasma quasi-neutrality is maintained.

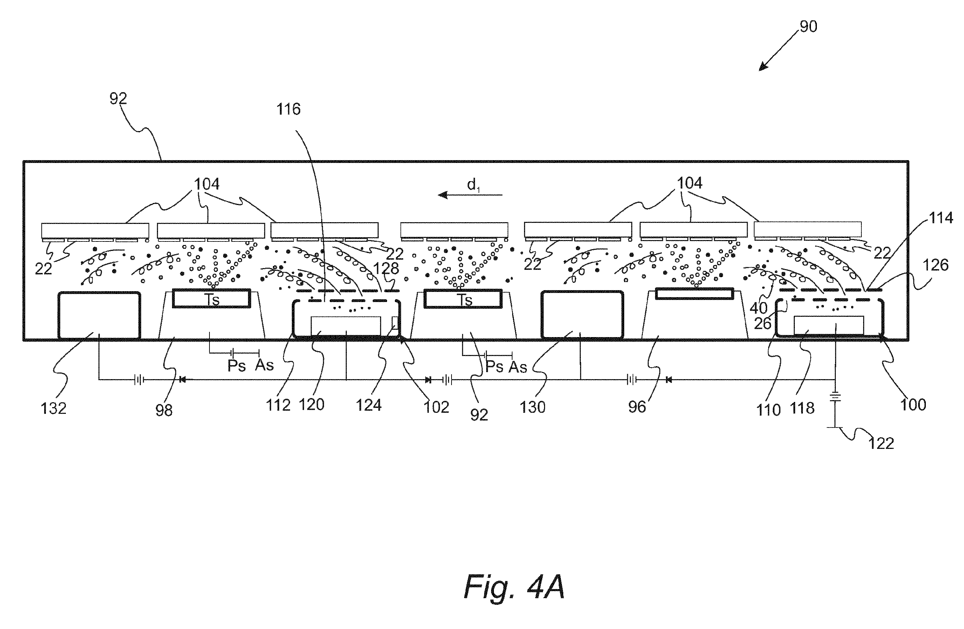

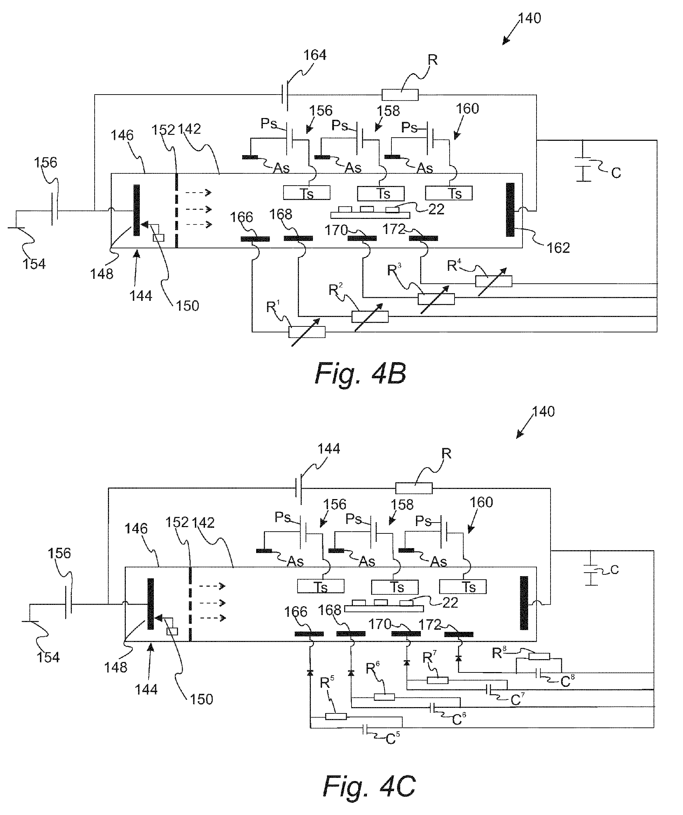

With reference to Figures 4A, 4B and 4C, variations of the present embodiment with a chain of magnetron sputtering sources installed inline between a shielded cathode chamber assembly on one side and a distant arc anode on the other side is provided. In this context, the term "inline" means that the components are linearly arranged such that the substrates may pass over the components while moving in a linear direction. Figure 4A provides a schematic of a coating system having additional remote anodes positioned between the magnetron sputtering source with additional shielded cathode chamber assemblies added to secure the uniformity and high ionization of gaseous plasma environment. Deposition system 90 includes vacuum chamber 92 with associated vacuum and gas supply systems as set forth above. Deposition system 70 also includes vapor sources 96 and 98, cathode chamber assemblies 100 and 102, and substrate holder 104 to hold substrates 22 to be coated. Figure 4A depicts a variation in which vapor sources 96, 98 are magnetron sputtering sources. The substrates are positioned in front of the vapor sources during coating. Typically, substrates 22 move along direction $d_1$ during deposition of the coating. Cathode chamber assemblies 100 and 102, respectively, include cathode enclosures 110 and 112 with openings 114 and 116 defined therein, cathodes 118 and 120, optional primary anodes 122 and 124, and shields 126, 128. Shields 126, 128 respectively isolate cathodes 118, 120 from vacuum chamber 92. Shields 126, 128 each define openings for transmitting electron emission currents into vacuum chamber 92. In a refinement, cathodes 118, 120 are cathodic arc cathodes and primary anodes 122, 124 are cathodic arc anodes. System 90 also includes remote anodes 130, 132, respectively, electrically coupled to cathodes 118, 120. In a refinement as depicted in Figure 4A, the shielded cathode chamber assemblies, the vapor sources (e.g., magnetron targets) and the remote anodes are aligned along the straight line which is suitable for the in-line coating systems.

Figure 4B provides a schematic illustration of a coating system which includes variable resistors installed between a master anode and each of a plurality of slave anodes. In this refinement, coating system 140 includes vacuum chamber 142 and cathode chamber assembly 144 which is of the general design set forth above. Cathode chamber assembly 144 includes cathode chamber 146, cathode 148, arc igniter 150, shield 152 defining a plurality of openings therein, and optional primary anode 154. System 140 also includes primary power supply 156 which connects cathode 148 and primary anode 154 and magnetron sputtering sources 156, 158, 160. Each magnetron sputtering source has a target Ts, a power supply Ps and an associated counter-electrode system 120 which also includes remote anode 142 with secondary power supply 144 providing a voltage potential between cathode 128 and remote anode 142. System 120 also includes slave anodes 146, 148, 150, 152 which are at intermediate voltage potentials established by variable resistors $R^1$, $R^2$, $R^3$, and $R^4$. In this refinement, the density of the plasma distribution can be controlled by changing the current through each of the slave anodes using variable resistors $R^1$, $R^2$, $R^3$, and $R^4$. The distances between the slave anodes and the distance between the slave anode closest to the master anode and the master anode cannot be greater than the minimal distance of the plasma discharge interruption in a processing gas composition and pressure.

Figure 4C provides a refinement in which a resistor in parallel with a capacitor is used to set the voltage potentials of the intermediate anode. In this refinement, resistor $R^5$ in parallel with $C^5$ sets the voltage potential for anode 166, resistor $R^6$ in parallel with $C^6$ sets the voltage potential for anode 168, resistor $R^7$ in parallel with $C^7$ sets the voltage potential for anode 170, and resistor $R^8$ in parallel with $C^8$ sets the voltage potential for anode 172. In this refinement, the capacitors are used to extend the RAAMS process along the large distance by pulse igniting of the remote arc discharges between the cathode in a cathode chamber and each of the slave anodes positioned between the cathode in a cathode chamber and the master anode. It is appreciated that slave anodes can be also provided with additional independent power supplies; each of the slave anode power supply can be installed between the cathode 148 and the corresponding slave anode. The open circuit voltage of each secondary power supply connected either to the master anode or to the slave anode exceeds at least 1.2 times the open circuit voltage of the primary arc power supply 136.

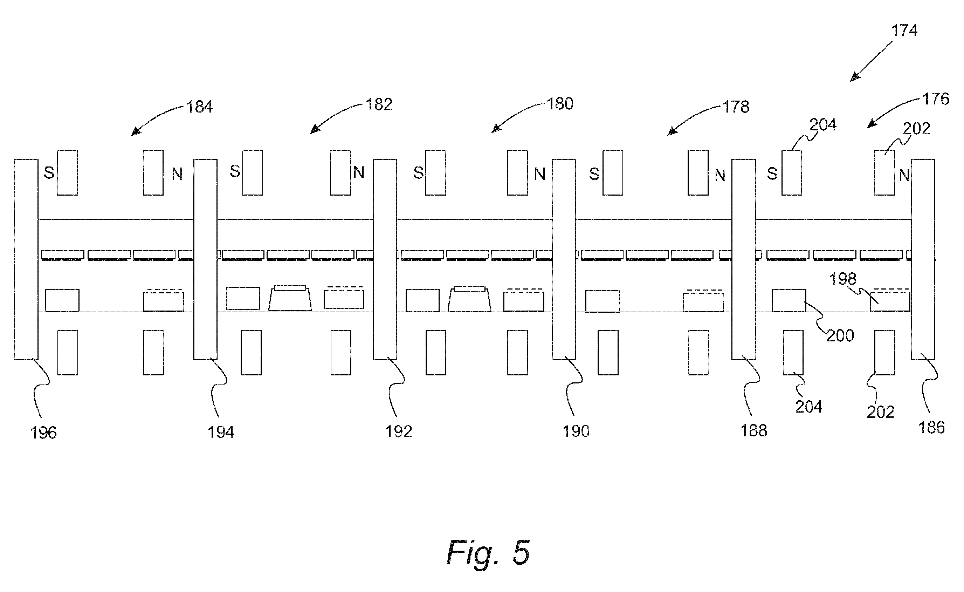

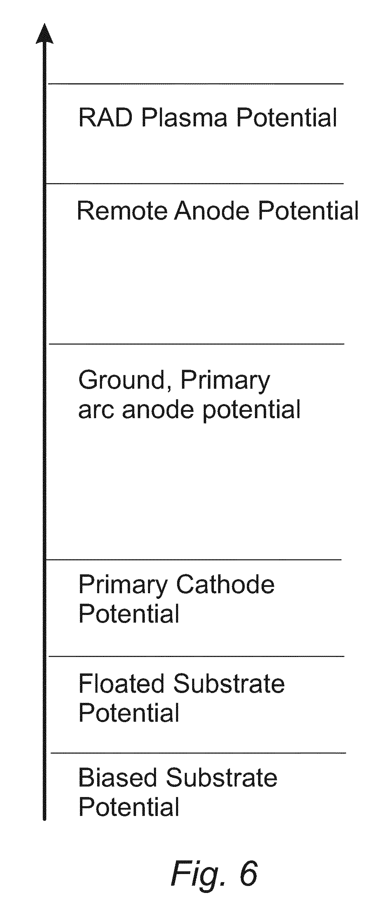

In still another variation of the invention, an inline modular configuration of the RAAMS setup is provided in Figure 5. Such an inline system may include any number of deposition stations and/or surface treatment stations (e.g., plasma cleaning, ion implantation carburizing, nitriding, etc.). In the variation depicted in Figure 5, coating system 174 includes modules 176-184 which are aligned inline. Modules 176-184 are separated from the neighboring module by load-lock gate valve 186-196. Modular RAAMS surface engineering system 174 includes module 196 which is a chamber-module having a shielded cathodic arc chamber 198 and a remote anode 200 positioned along one wall of the chamber as set forth above. An optional set of magnetic coils 202, 204 which create a longitudinal magnetic field ranging from 1 to 100 Gs along the coating chamber is also shown in this Figure. This module 176 performs the following operations: substrate loading; ion etching or ion cleaning of the substrates by high energy (typically E>200eV) ion bombardment in an argon with a remote anode arc discharge (RAAD) plasma generated between the cathode in a shielded cathode chamber and a remote anode; and conditioning of the substrates to be coated by soft ion bombardment (typically E<200eV) in an argon RAAD plasma generated between the cathode in a shielded cathode chamber and a remote anode. Second module 178 ionitrides the substrate surfaces to be coated in nitrogen or argon-nitrogen mix RAAD plasma generated between the cathode in a shielded cathode chamber and remote anode. The rate of plasma immersion ionitriding of HSS, M2 and 440C steel in the RAAD plasma immersion ionitriding process reaches 0.5 to 1 $\mu$m/min at pressures from 0.1 mtorr to 200 mtorr and a remote anode current ranging from 10 to 300 amps, but typically within the pressure range 0.2-100 mtorr and remote anode range from 10 to 200 amps. The RAAD plasma immersion ionitriding is a low temperature treatment where substrate temperature typically does not exceed 350° C. In this process, the substrates may be floating, grounded or biased at very low negative bias voltages (e.g. below -100V). Ionitriding at such low bias voltages is due to the high positive RAAD plasma potential causing the plasma ions to receive excessive energy from the high plasma potential which exceeds the grounded substrate potential. Alternatively, a low energy ion implantation of such elements as nitrogen, phosphorus, silicon, carbon from the gaseous RAAD plasma can be also performed at relatively low substrate bias voltages typically ranging from -200 to -1500 volts. The diagram of potential distribution in RAAD plasma processing is illustrated in Figure 6. In a typical RAAD plasma process, the primary cathode has potential ranging from -20 to -50 volts relative to the ground primary anode. In a refinement, the floating substrate potential ranges from -10 to -50 volts relative to the primary cathode. The biased substrate potential in ionitriding, carburizing and other ion diffusion saturation processes is typically from -10 to -200 V relative to the primary cathode, while in the RAAD plasma immersion low energy ion implantation process, the substrate bias is typically from -200 to -1500 volts.

It is appreciated that the modular chamber layout of Figure 5 can also be used to perform remote anode arc plasma assisted CVD (RAACVD) processes in gaseous RAAD plasma chambers (for instance, modules 176, 178 and 184 in Figure 5). For example, this low pressure plasma immersion CVD process setup can be used for deposition of polycrystalline diamond coatings in the plasma-creating gas atmosphere consisting of of 0.1-1% methane and balance hydrogen or hydrogen-argon mix. RAAD plasma acts as a powerful activator of the reactive atmosphere with high density of atomic hydrogen and HC radicals which are contributing to formation of polycrystalline diamond coating. In this process the substrate to be coated can be either grounded, floating or biased to the negative potential not below -100 volts vs. the primary cathode. Independent radiation heater array can be used to maintain substrate temperature in the range from 200 °C to 1000 °C as necessary for the deposition of polycrystalline diamond coating in the plasma enhanced low pressure CVD processes.

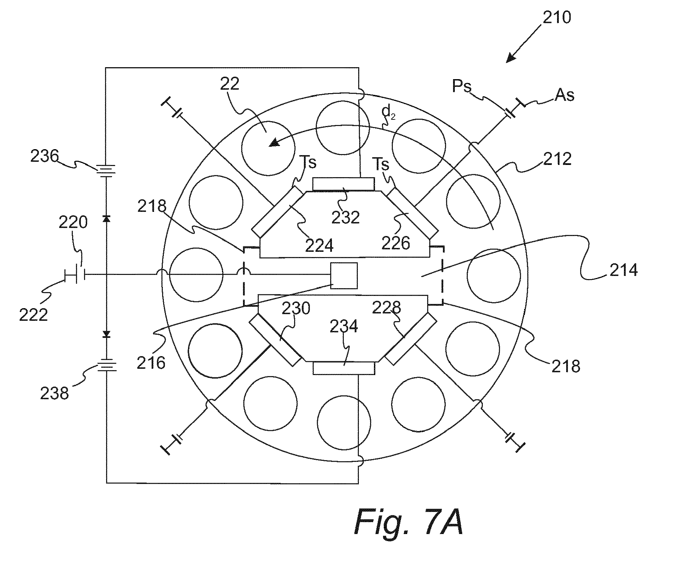

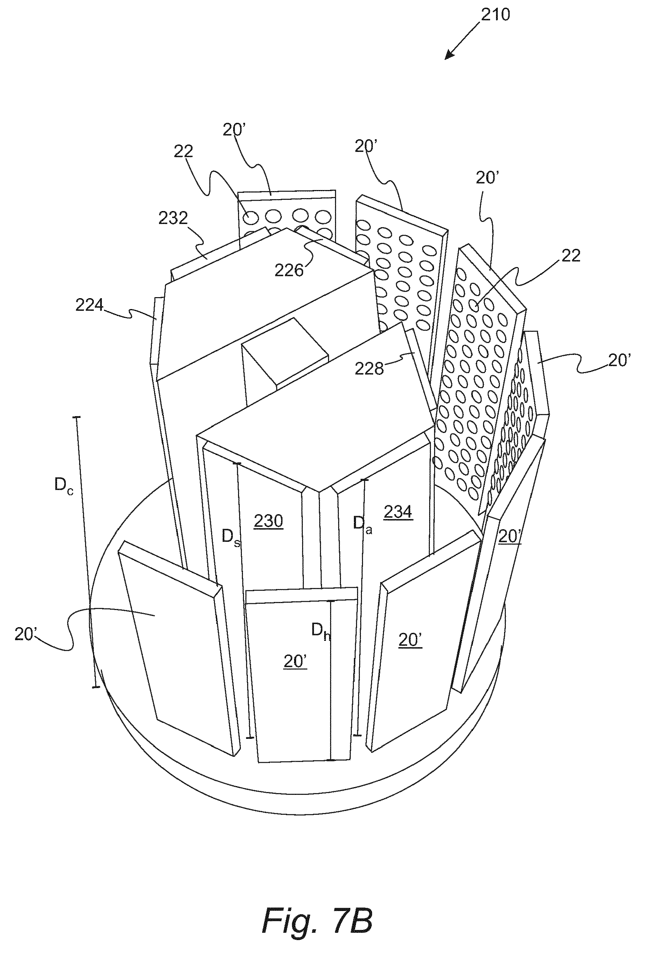

In another embodiment, a coating system having plasma sources aligned along curvilinear walls is provided. Figure 7A provides a schematic top view of a batch coating system with a centrally located shielded cathode chamber. Figure 7B provides a schematic perspective view of the batch coating system of Figure 7A. Coating system 210 includes vacuum chamber 212, cathode chamber 214 which includes cathode 216, and shield 218. Vacuum chamber 212 has a substantially circular cross section. System 210 also includes primary power supply 220 which sets the voltage potential between cathode 216 and primary anode 222. System 210 also includes magnetron sputtering sources 224-230 each of which includes target Ts, power supply Ps, and anode As. In a refinement, magnetron sputtering sources 224-230 are arranged along a circle having the same center as the cross section of vacuum chamber 212. System 210 also includes remote anodes 232 and 234 which are set at a voltage potential relative to cathode 214 by power supplies 236 and 238. In this embodiment, substrates 22 move axially along a circular direction $d_2$ as they are coated. In each of the variations of Figures 7A and 7B, the plasma streams between cathode 216 and the remote anodes. This streaming is confined by the separation between the remote anode (or sputtering sources) and the substrates (i.e., top of the substrates) which is typically 2 to 20 inches. The confinement persist through the coating zone Moreover, the plasma is rastered along the cathode in a direction perpendicular to the movement of the substrates as set forth above with respect to Figure 1D.

As set forth above, remote anodes 232 and 234 have a linear remote anode dimension $D_a$. Magnetron sputtering sources 224-230 have linear source dimension $D_s$. Cathode target 216 has a linear cathode target dimension $D_c$. Substrate holder 20 has a linear holder dimension $D_h$. In a refinement, the linear remote anode dimension $D_a$, the linear cathode target dimension $D_c$. and the linear holder dimension $D_h$ are parallel to each other. In another refinement, the linear remote anode dimension $D_a$ is greater than or equal to the linear cathode target dimension $D_c$ which is greater than or equal to the linear holder dimension $D_h$.

It is appreciated that an external magnetic field can be applied in a coating chamber for the embodiments set forth above to further enhance the plasma density during arc plasma enhanced magnetron sputtering coating deposition processes. The preferable magnetic field will have magnetic field lines aligned generally parallel to the cathodic arc chamber and/or remote anode. This will contribute to the increase of the arc discharge voltage and, consequently, to the electron energy and arc plasma propagation length along the coating chamber. For example, the external magnetic field can be applied along the coating chambers in the inline coating system shown in Figure 5.

A uniform plasma density distribution in the coating chambers set forth above can be achieved by appropriately distributing both remote anodes and the electron emitting surface of the shielded vacuum arc cathode targets to evenly cover the coating deposition area. For example, if coating deposition area is 1 m high then both electron emitting surfaces of the shielded cathode target and electron current collecting remote anode surfaces have to be distributed to evenly cover this 1 m high coating deposition area. To achieve these requirements, several small cathode targets can be installed in a shielded cathode chamber, each of the cathode targets is connected to the negative pole of the independent power supply. The cathode targets are distributed generally evenly so the electron flows emitted by each of the cathode targets overlap outside the shielded cathode chamber providing a generally even distribution of electron density over the coating deposition area. The positive poles of the remote arc power supplies can be connected to one large anode plate having the height generally the same as a height of the coating deposition area and facing the substrate holder with substrates to be coated as shown in Figures 1 and 4- 6. The set of anode plates, each connected to the positive pole of the remote arc power supplies, can be used to provide even distribution of electron density over the coating deposition area. Similarly, instead of using a set of small cathode targets in a shielded cathode chamber, a single large cathode target having a linear dimension similar to the linear dimension of the coating deposition area can be used as a cathode of remote arc discharge. In this case, electron emission spots (i.e., cathodic arc spots) are rastered over the cathode target to provide a generally even distribution of electron emission current over the coating deposition area. The rastering of the cathodic arc spots over a large cathode target area can be achieved, for example, by magnetic steering of the cathodic arc spots over the arc evaporating area of the cathode target or by mechanical movement.

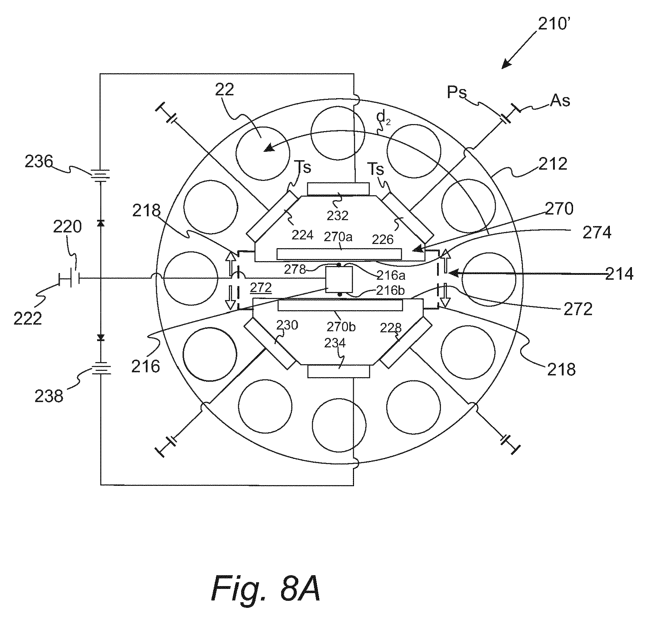

With reference to Figures 8A-8H, schematic illustrations depicting a refinement of the coating system of Figures 7A and 7B which uses a magnetically steered cathodic arc spot is provided. The present variation incorporates features from U.S. Pat. No. 6,350,356, the entire disclosure of which is hereby incorporated by reference. Referring to FIG. 8A, system 210' includes duct magnetic coil 270 surrounding plasma duct 272 which is formed within cathode chamber 194 between the two opposite sides of the housing 274. Coil 270 includes winding 270a facing side 216a of the cathode target 216 and an opposite winding 270b facing side 216b of the cathode target 216. Cathode target 216 is generally bar shaped with a long dimension $d_A$. Duct coil 270 generates a magnetic field along the duct 272 with magnetic force lines generally parallel to the sides 216a and 216b of the cathode target 216. When cathodic arc spot 278 is ignited on the evaporating surfaces 216a or 216b, arc spot 278 moves along a long side of the bar-cathode 216. At the end of the bar, arc spot 278 switches sides and continues its movement in the opposite direction at the opposite side of the bar. Isolation ceramic plates (not shown) attached to the sides of the cathode bar perpendicular to the magnetic force lines prevent the arc spot escaping from the evaporating surface of the cathode 216. Shields 218 are optionally installed at the ends of the plasma duct 272 facing the coating area in the coating chamber 212. In a refinement, shields 218 are movable (as shown by arrows in Figure 8A) to permit opening and closing the plasma duct 272 depending on the stage of the coating process. When shields 218 are closed the RAAMS process can be conducted with enhance ionization of the magnetron sputtering environment by the RAAD plasma. When the ends of the duct 272 are opened, the cathodic arc plasma flows along the magnetic force lines generated by duct coil 270 toward substrates 22 to be coated which results in deposition of cathodic arc coatings from the cathodic arc metal vapor plasma which is magnetically filtered from undesirable neutral metal atoms and macroparticles. The filtered cathodic arc coating deposition may be conducted as a single process phase or in conjunction with magnetron sputtering by the magnetron sputtering sources 224-230. The ionization and activation of the plasma environment by the remote arc discharge established between the cathode 216 in the cathode chamber 214 and the remote anodes 232, 234 improves the density, smoothness and other physic-chemical and functional properties of the coatings.

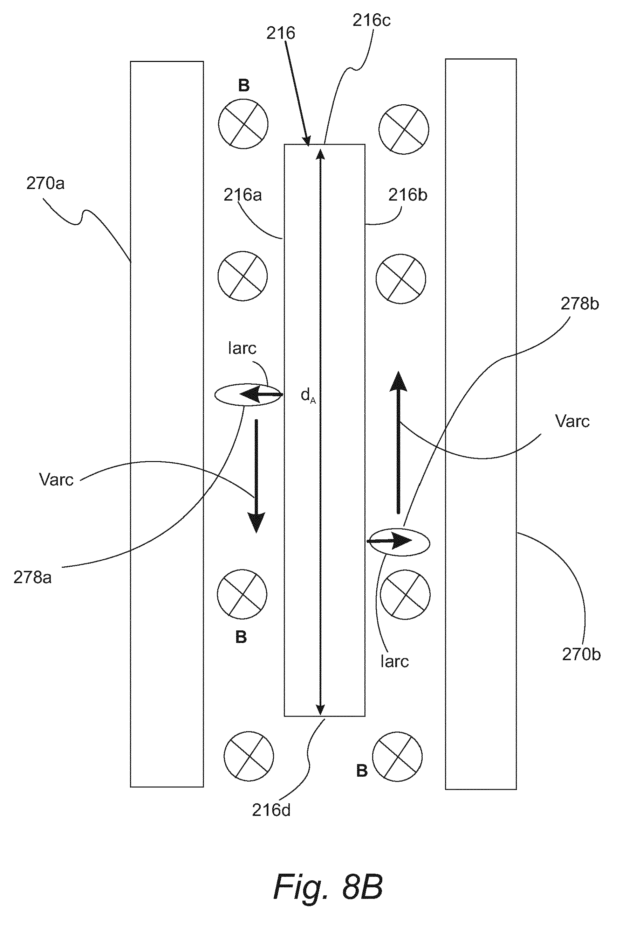

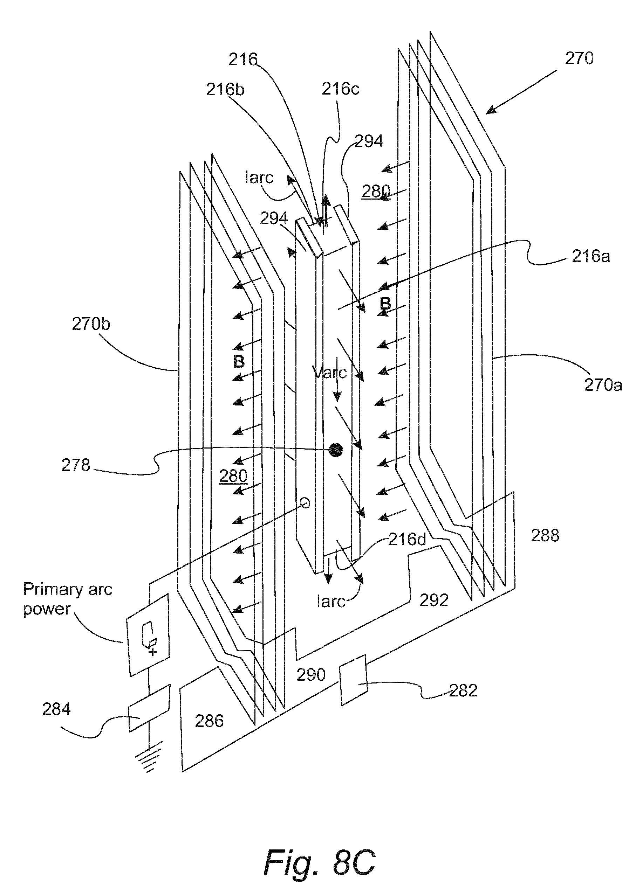

Referring to Figures 8B and 8C, schematic illustrations depicting the mechanism of magnetic steering of the cathodic arc spots around an elongated rectangular bar cathode are provided. Rectangular bar-shaped cathode 216 is positioned between two portions of duct coil windings 270. Left winding 270a and right winding 270b face the evaporating sides of the cathode 216. Cathode side 216a faces duct coil winding side 270a while cathode side 216b faces duct coil winding side 270b. The magnetic field B generated by the duct coil windings 270 is parallel to the sides of the cathode 216 facing the duct coil winding and at the same time is perpendicular to the axis d,a of the elongated cathode 216 (i.e. the long sides of the cathode target 216). When cathodic arc spot 278 is ignited on a side of the cathode 216 facing the duct coil winding arc, current !arc is generated perpendicular to the surface of the cathode target 216 and, therefore, perpendicular to the magnetic force lines B generated by duct coil 270. In this case, the cathode arc spot moves along the long side of the cathode with the average velocity $V_{arc}$, which is proportional to the Ampere force defined by a product of arc current $I_{arc}$ and magnetic field B, following the well-known Ampere law:

$$V_{arc.} = (-/+)c*I_{arc}*B, \qquad (1)$$

where c is a coefficient which is defined by the cathode material. The direction of the arc spot movement (the sign in the parenthesis in the above formulae) is also determined by the cathode target material since the magnetic field generated by the duct coil 270 is parallel to four sides of the cathode target (i.e., long in the same direction around the evaporative sides of cathode target 216). For example, when the cathode arc spot 278a is created on cathode side 216a facing the duct coil winding 270a, the arc spot moves down the cathode target 216 along the long side 216a. At the end of the cathode bar, the arc spots turn to the short side 216d followed by turning to the long side 216b and then continuing up along long side 216b, etc.

Figure 8C depicts the arc spots moving along the evaporative sides 216a, 216b, 216c and 216d of the cathode target 216, which are parallel to the magnetic force lines 280 generated by the duct coil 270. The duct coil is energized by the duct coil power supply 282 while arc power supply 284 is connected to the cathode target 216. The duct coil includes coils 270a and 270b connected by an electric circuit including current conductors 286, 288, 290 and 290. The sides of the cathode target 196 perpendicular to the magnetic force lines are covered by the isolation plates 294 which prevent arc spots from escaping the evaporative surface of cathode target 216. Cathodic arc plasma is trapped by the magnetic force 280 generated by the duct coils 270a and 270b which prevent plasma diffusion across magnetic force lines 280, while plasma can freely move along the magnetic force lines 280.

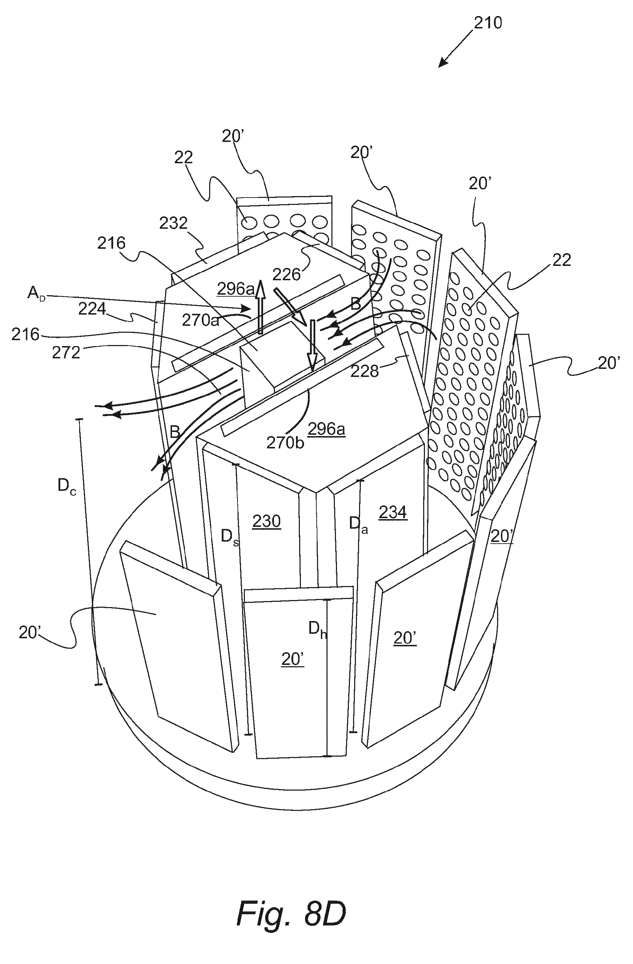

Figure 8D provides additional details regarding the steering of cathodic spots by the duct coil. The magnetic field generated by the duct coil 270 steers the cathodic arc spots along the sides of the cathode target bar 216 parallel to the magnetic field force lines as set forth above. The direction of the movement of the cathodic arc spots is shown by the arrows $A_D$. The ends of the plasma duct 272 are opened which allows the cathodic metal vapor plasma to flow along magnetic force lines toward substrates 22 installed on substrate holder 20 in the coating chamber. The neutrals and macroparticles are trapped within the cathode chamber on the inner walls of the duct 272 yielding near 100% ionized metal vapor plasma to enter in the coating area outside of the plasma duct 272. This design of the cathode chamber is essentially that of a filtered cathodic arc metal vapor plasma source capable of getting rid of macroparticles and neutrals in the outcoming metal vapor plasma and yielding nearly 100% atomically clean ionized metal vapor for deposition of advanced coatings. The RAAD plasma established between the cathode 196 and the remote anodes 232, 234 enhances ionization and activation of the plasma environment in the RAAMS coating deposition process, resulting in improved coating properties. In this design, the hybrid coating deposition processes can be conducted as a single cathodic arc or magnetron coating deposition or as a hybrid process combining cathodic arc metal vapor plasma with magnetron metal sputtering flow immersed in a highly ionized remote arc plasma environment.

Still referring to Figure 8D, the issue of arc plasma enhancement of large area magnetron sputtering coating deposition process and hybrid processes is addressed by positioning at least one remote arc anode off line-in-sight with the cathode target bar 216. In this variation, at least one substrate 22 held by substrate holder 20' and magnetron sputtering sources 224-230 are positioned in a coating chamber region outside of the plasma duct 272. The present RAAMS process effectively immerses the metal sputtering flow generated by conventional magnetron sources in the dense and highly ionized remote anode arc discharge (RAAD) gaseous plasma. The remote arc power supply (not shown) which powers the RAAD plasma is installed between the arc cathode target 216 and the at least one remote anode 232. The remote anodes 232, 234 provide at least 20% higher open circuit voltage than the power supply which powers the primary arc discharge in a cathode chamber which is ignited between the arc cathode 216 and the proximate anode. The proximate anode can be an inner wall of the plasma duct enclosures 296a, 296b or, optionally, an independent anode electrode within plasma duct 272. In another refinement, several additional remote anodes, each of them associated with at least one arc cathode positioned within plasma duct 272, may be utilized. The remote anodes are positioned at strategic positions within the coating chamber between the end-openings of the plasma duct 272 off line-in-sight from cathode 216. The minimal distance between the end-openings of the plasma duct 272 and the remote anodes 232, 234 must be less than the plasma discharge breakdown distance when the voltage applied between the cathode and remote anode exceeds 1.2 to 10 times the voltage drop between the cathode and the primary (proximate) anode, which can be either electrically grounded or isolated.

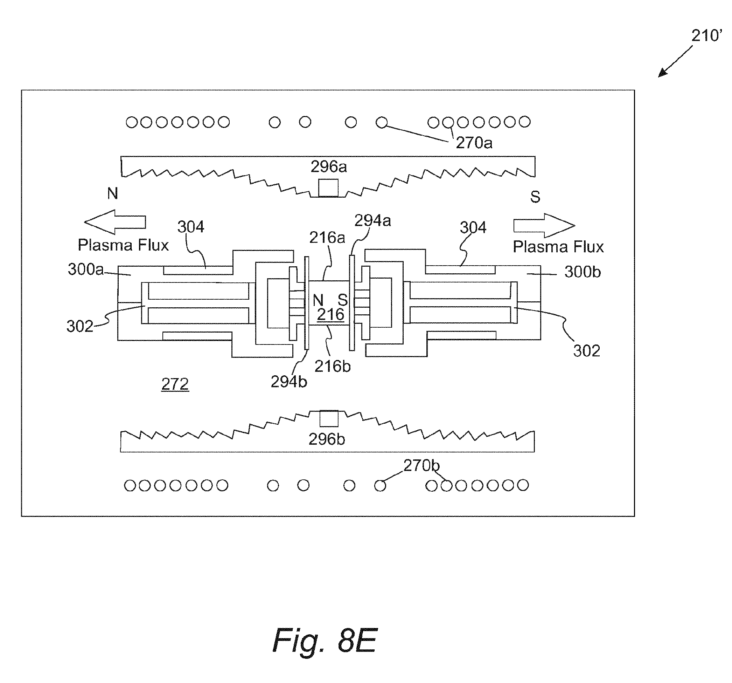

Figure 8E depicts a variation of the coating system of Figure 8A-8D which utilizes a macroparticle filter are provided. The design of this variation incorporates the advanced macroparticles filter of U.S. Pat. No. 7,498,587 and EU Pat. Application No. EP 1 852 891 A2, the entire disclosures of which are hereby incorporated by reference. System 210' includes trimming coils 300a and 300b positioned adjacent to the opposite sides of the cathode target 216 and facing opposite sides of the plasma duct 272. The inner walls of the opposite ducts 296a and 296b are provided with grooves or, optionally with baffles for trapping macroparticles. Duct coil 272 surrounds duct 272 with winding portion 270a being parallel to the long side of the cathode target 216a while facing duct side 296a. Similarly, winding portion 270b is parallel to the long side of the cathode target 216b and faces duct side 296b. Trimming coils 300a, 300b include magnetic cores 302 which are surrounded by electromagnetic coils 304. The cathodic arc spots move along the evaporation sides 216a and 216b of the cathode target 216 under influence of the Ampere force according to the expression (1) set forth above. The sides of the cathode target 216 perpendicular to the plane of symmetry of the duct 272 are covered by ceramic isolation plates 294a and 294b to prevent arc spots from escaping the evaporating surface of the cathode target 216. The direction of the magnetic field generated by the trimming coils 300 a, b coincides with the direction of the magnetic field generated by the duct coil 270. However, in the vicinity of the evaporating surfaces of the cathode target 216a or 216b, the magnetic force lines generated by trimming coils 300a, b are arch-shaped thereby allowing confinement of the cathodic arc spots within the evaporation area of the cathode target as require by the well-known acute angle rule (*see for example*, R.L.Boxman, D.M.Sanders, and P.J.Martin, Handbook of Vacuum Arc Science and Technology. Park Ridge, N.J.: Noyes Publications, 1995 pgs.423-444).

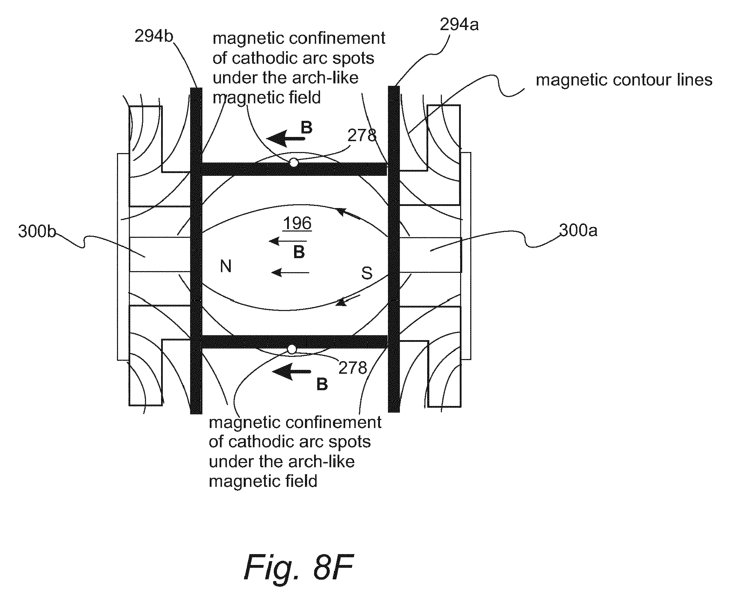

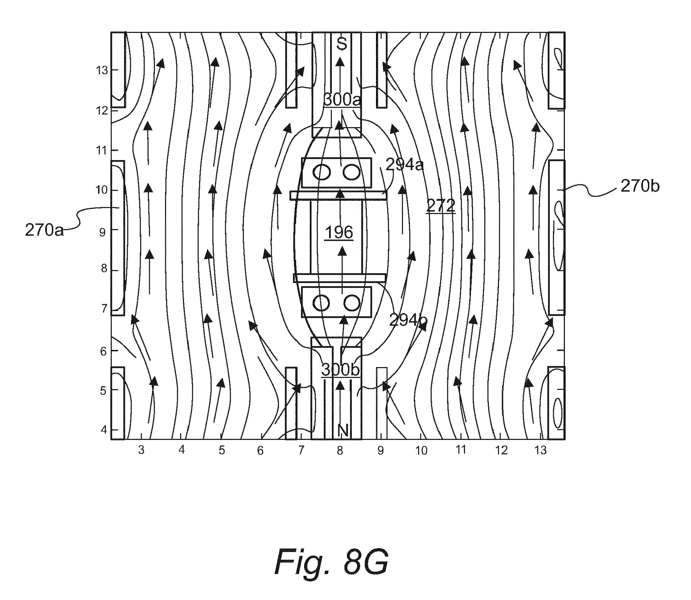

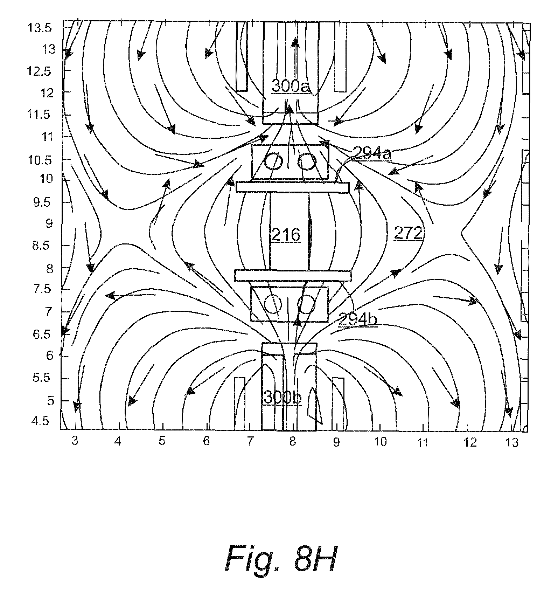

Figures 8F, 8G and 8H provide schematics illustrating the mechanism of arc confinement by the magnetic field generated by the trimming coils 300a, b. Cathodic arc spots 278 are located under a top point of the arch-shaped magnetic force lines as required by the acute-angle rule of arc spot confinement. The magnetic field with the arch-shaped configuration above the evaporating surface of the cathode target 216 is generated between the South pole of the trimming coil 300a and the North pole of the trimming coil 300b on both sides of the cathode target 216 facing the duct 272. The configuration of the magnetic field within plasma duct 272 is evaluated using numerical calculation. The magnetic field with plasma duct 272, when both duct coil 270 and trimming coils 300 are turned ON, generates a magnetic field in the same direction is shown in Figure 8G. This figure demonstrates that the magnetic force lines are directed in the same direction while still having an arch-shaped configuration in the vicinity of the evaporation surface of the cathode target 216. In this mode, the cathodic arc plasma magnetically filtered from the neutral metal atoms and macroparticles flows along the magnetic force lines away from the plasma duct 272 toward substrates to be coated (not shown) in the coating area of the coating chamber outside of the plasma duct 272. In this filtered cathodic arc deposition mode, the nearly 100% ionized metal vapor plasma with little, if any, neutral metal atoms or macroparticles is deposited onto substrates thereby creating defect-free coatings with superior properties. The magnetron sputtering coatings can also be deposited during this mode of operation by the magnetrons positioned on the outer walls of the plasma duct 272. Additional ionization and activation of the coating deposition plasma environment during this mode of operation is provided by the remote arc discharge established between cathode 216 and remote anodes 232, 234 positioned next to the magnetrons on the outer wall of the plasma duct 272 or, alternatively, on the inner wall of the coating chamber opposite to the magnetron sources (not shown). Referring to Figure 8H, the magnetic field force lines are shown to switch directions within the plasma duct when duct coil 270 is turned "OFF". However, when both trimming coils 300a, b are turned "ON" an arch-shaped magnetic field is generated above the evaporative surface of cathode target 216. Depending on the operating mode, the deflecting magnetic field generated by deflecting duct coil 270 can be turned "ON" or "OFF". When the magnetic field of the deflecting duct coil 270 is turned "ON", the metal vapor plasma generated by the cathode target 216 is transported bi-directionally throughout the plasma duct 272 towards substrates 20. When the deflecting duct coil 270 is turned "OFF", the metal vapor plasma generated by the cathode target 216 does not transport towards substrates 20, although the cathode arc spots continue their movement around the target bar 216 driven by the steering magnetic field generated by trim coils 300a, b. In this variation, the duct coil works as a magnetic shutter eliminating the need in a mechanical shutter or shield as shown in Figure 7A. When the magnetic shutter is "ON," the metal vapor is transported through the plasma duct toward substrates 20 in the processing chamber. When the magnetic shutter is "OFF", the magnetic shutter is closed and metal vapor does not reach substrates 20. Figure 7H shows the distribution of the magnetic field in plasma duct 272 is zero when the current of the duct coil is set to zero and the trim coils current set to 0.1 amperes and duct coil current is zero. It can be seen that when the magnetic field of duct coil 270 is zero, there is no magnetic field to transport metal vapor plasma away from the plasma duct 272, although trim coils 300a, 300b still generate a magnetic field with an arch-shaped geometry that is sufficient both for confinement of the arc spots 278 within evaporating area of the target 216 (magnetic arch configuration at the evaporating target surface) and for steering the arc spot movement around the cathode bar 196. In this latter operation mode, when cathodic arc metal vapor plasma is trapped within the plasma duct, the electrons still flow away from the plasma duct toward remote anodes positioned outside of the plasma duct 272 in the coating chamber. The resulting remote arc discharge is established between cathode 216 in the plasma duct 272 and the remote anodes (not shown) which can be positioned in the outer wall of the plasma duct 272 or in the wall of the coating chamber in a position opposite to the magnetron sources (not shown). The RAAD plasma enhances ionization and activation of the coating deposition processing environment in the coating chamber, resulting in deposition of advanced coatings with superior properties.

When the magnetic shutter is closed, cathode target 216 still generates a large electron current which can be extracted toward remote anodes to establish a remote arc assisted discharge plasma in the processing chamber. The RAAD plasma is characterized by high density, ranging from $10^{10}$-$10^{13}$ cm$^{-3}$, high electron temperature ranging from 3 to 20 eV, and high plasma potential which generally resembles the potential of the remote anode. An experimental study confirms that the magnetic shutter can seal the plasma duct 272 thereby preventing metal vapor plasma from reaching the substrates 20 when the magnetic shutter is closed. Cathode target bar 216 used in these experiments was made of stainless steel. The silicon wafers which are used as substrates 20 are installed on substrate holding shafts of the round table substrate holder which is rotated at 5 RPM during 2 hours of the coating deposition process. The current of trim coils 300 is set at 0.2 A while the duct coil 270 current is set to zero. The argon pressure is 1.5 mtorr while the current of the primary arc is 140 amperes. After a two hour exposure, the substrates are unloaded and the coating thickness is measured by means of optical interferometry using Veeco NT3300 Optical Profiler. The results are presented in Table 1 below.

Table 1.

| Measurement | Coating thickness (nm) on Si chip | Coating thickness (nm) on Si wafer |
|---|---|---|
| 1 | 11 | 15 |
| 2 | 12 | 8.5 |
| Average | 11.5 | 11.75 |
| ombined Average | 11.625 | |

From the results presented in Table 1, it follows that the deposition rate on a rotating substrate holder does not exceed 6nm/hr when the magnetic shutter is closed. The average coating thickness produced in a coating deposition process, either by filtered cathodic arc deposition or magnetron sputtering sources, typically exceeds 1 µm/hr. In this case, leakage of the metal vapor does not increase doping elements in a coating over the usual level of impurity of the cathode targets used in industrial coating deposition processes.

The following processes can be conducted in a remote arc assisted surface engineering (RAASE) chamber:

1. ion cleaning/etching in dense RAAD plasma (magnetic shutter is closed);

2. low temperature ion nitriding or oxi-nitriding, plasma carburizing. The temperature of substrates during this process can be as low as 150 °C. The ionitriding rate of M2 steel in RAAD nitrogen plasma is typically ranging from 0.1 to

0..5 μm/min. (magnetic shutter is closed);

2. low energy ion implantation (the substrate bias below 2 kV) (magnetic shutter is closed);

3. deposition of filtered arc coatings (magnetic shutter is open;

4. deposition of magnetron sputtering coating by remote arc assisted magnetron sputtering (RAAMS) process (magnetic shutter is closed); and

5. deposition of magnetron sputtering coatings modulated by filtered arc coatings (magnetic shutter OFF/ON as per duty cycle to achieve a required coating modulation period).

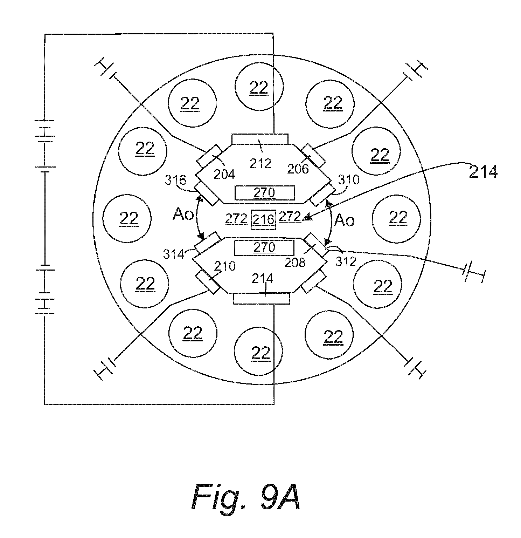

With reference to Figure 9A-E, schematics of a filtered arc assisted magnetron sputtering ("FAAMS") hybrid filtered arc-magnetron bi-directional system having additional magnetron sources are provided. In this variation, additional magnetron sputtering sources 310-316 are positioned adjacent to the arc cathode chamber 214 magnetically coupled with filtered arc source 216 and having the magnetron targets forming an open angle in the range from 10 degrees to 80 degrees. This opening angle Ao assists in focusing the magnetron sputtering flow toward the substrates. In this filtered arc assisted magnetron sputtering hybrid coating deposition process, the filtered arc metal plasma flows along the magnetic field lines of the transporting magnetic field created by the duct coil 270. Moreover, the magnetic field lines diverge at the exit of the plasma duct 272. This results in metal ions from the filtered arc cathode passing by the magnetron sputtering target area close to the target surface and crossing a magnetron discharge area with large close-loop magnetic field topology. A substantial portion of these metal ions are trapped in the magnetron magnetic field and contribute to the sputtering of the magnetron target, which can occur even without sputtering gas (argon or other noble gas) and within a broadened pressure range from $10^{-6}$ to $10^{-2}$ torr. Another portion of the metal ions generated by filtered arc cathodes continue towards substrates 22 where they mix with the focusing magnetron sputtering flow, providing an ionized metal fraction of the magnetron sputtering coating deposition process. It is well-known that increasing the ionization rate of the metal vapor improves coating adhesion, density, and other mechanical properties, and smoothness.

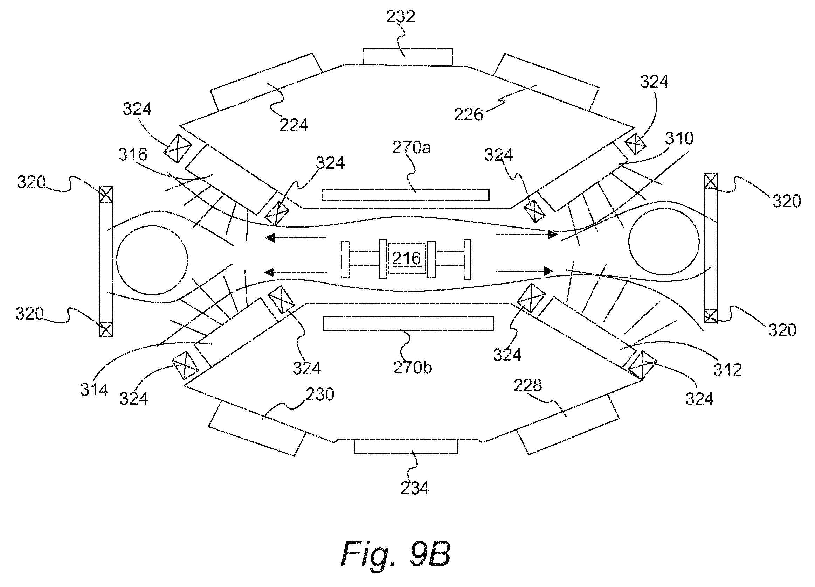

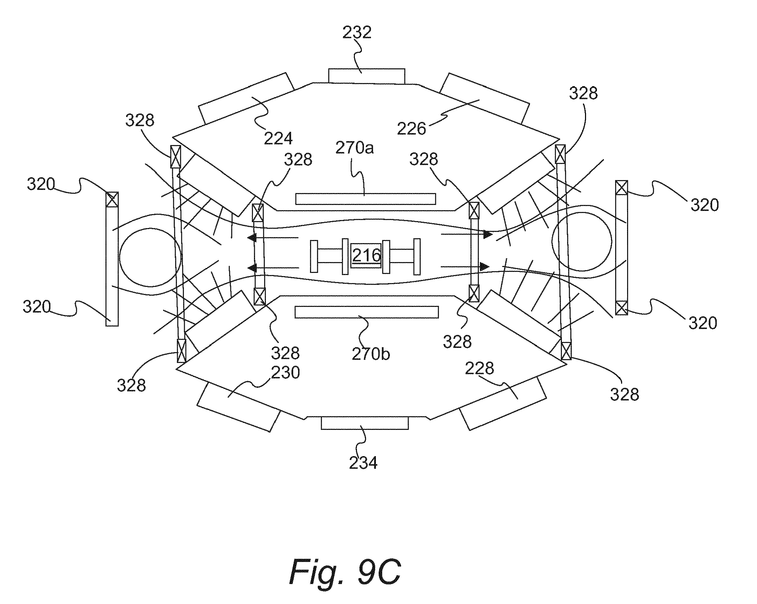

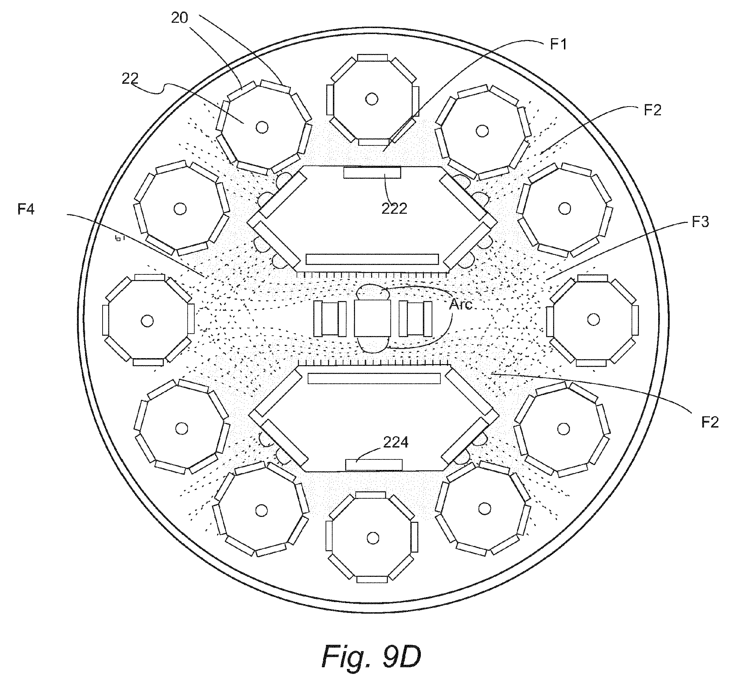

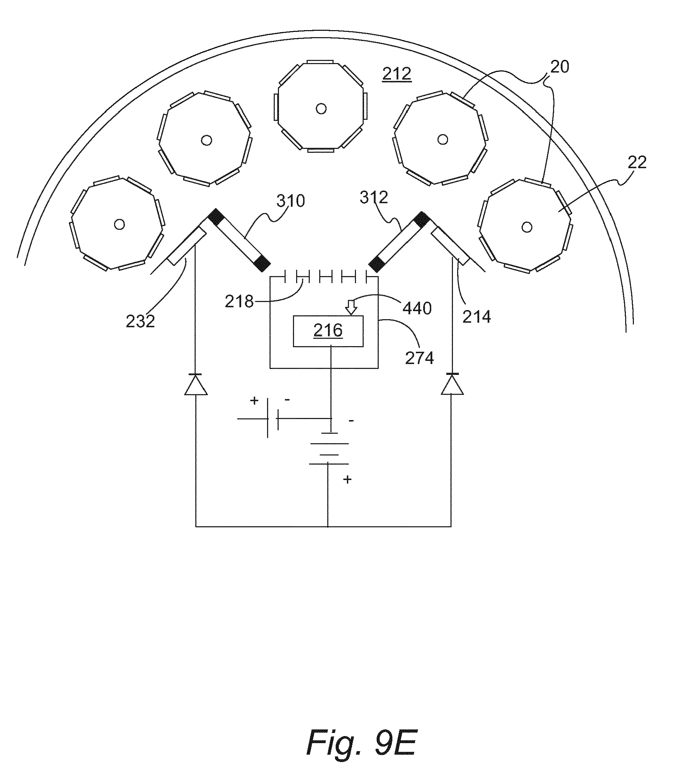

Figure 9B provides additional features of the FAAMS hybrid filtered arc-magnetron bi-directional source. Optional additional focusing magnetic coils 320 are positioned opposite to the exit opening of the plasma duct which provides additional improvement of the plasma density and controls mixing of the magnetron sputtering flow with filtered arc metal plasma flow focusing toward substrates to be coated in a coating chamber (not shown). In addition, optional focusing magnetic coils 324 are positioned about magnetron targets 310-316 at the exit portion of the plasma duct 272. Focusing coils 324 improve the concentration of the plasma density near the magnetron targets. The direction of the magnetic force lines generated by these coils at the side adjacent to the duct coil have the same direction as the transporting magnetic field generated by the duct coil. Figure 9C provides a schematic illustration of a refinement of the system of Figure 9B. In this refinement, pairs of magnetic focusing coils 328 are positioned at the exit portion of the plasma duct surrounding the plasma duct on both sides of the magnetron sources. Figure 9D provides a top cross section of the coating systems of Figures 9A-C, in which the remote arc plasma (F1), the magnetron sputtering flows (F2), and the filtered arc plasma stream (F3) are depicted. The direction of the magnetic field generated by these focusing coil coincide with the direction of the transporting magnetic field generated by the duct coil. Figure 9E provides yet another variation of a coating system. Figure 9E depicts a section coating chamber 212 outline with the rotating substrate holding turntable 22 with substrates to be coated 20. The cathode chamber 214 is positioned opposite to the substrates to be coated 20 in the coating chamber 212. The primary arc discharge in a cathode chamber 214 is ignited by the striker 440 on cathode target 216 which are enclosed within the housing 274. The housing 274 has a shield 218 with openings which are not transparent for heavy particles such as ions, atoms and macroparticles emitted from the surface of cathode target 216, but allow electrons to flow freely toward the remote anodes in the coating chamber 212. The magnetron targets 310, 312 are positioned adjacent to the cathode chamber shield 218 so that the sputtering flow emitted from the magnetron targets is coupled with highly ionized plasma in front of the shield 218 and focusing toward substrates 20 in the coating chamber 212. In this arrangement the cathodic portion of the remote arc plasma generating in front of the cathode shield 218 is coupled with magnetron sputtering flow resulting in substantial increase of ionization and activation of the metal-gaseous plasma generating by the magnetron targets 310, 312 which contributes to further improvement of coating adhesion, density, smoothness, reduction of the defects and improvement of their functional properties for different applications.

The FAAMS surface engineering system can operate in the following modes:

1. RAAD plasma immersion ion cleaning, ion nitriding, low energy ion implantation. In this mode the cathodic arc source is operating, both trim coils are ON, but the plasma transporting duct coil is OFF. Turning OFF the duct coil effectively prevents the metal plasma generated by the cathode positioned in a center of the plasma duct for reaching out of the plasma duct toward substrates to be coated in a coating chamber, but the gaseous dense and highly ionized RAAD plasma is filling the entire processing chamber including the interior of the plasma duct and the area in a chamber where substrates to be coated are positioned on the substrate holder. This dense gaseous plasma provides a highly ionized environment for plasma immersion ion cleaning, ion nitriding (as well as ion carburizing, oxi-carburizing, boronizing and other ion saturation processes) and low energy ion implantation. It can also be used for remote arc assisted CVD (RAACVD) processes, including deposition of a diamond-like carbon (DLC) coating when the hydrocarbon contained gaseous atmosphere is created in a coating chamber. In this mode, the remote arc plasma assisted CVD process can be conducted. Moreover, it is possible to deposit polycrystalline diamond coatings when substrates are heated to a deposition temperature ranging from 500 to 1000 °C (depending on type of substrate). In such a process, the gas pressure is typically ranging from 1 to 200 mTorr, the gas atmosphere typically includes 0.1-2% of methane in hydrogen at a hydrogen flowrate ranging from 50 to 200 sccm depending on pumping system capability with the balance being argon. The duct coil works as a magnetic shutter, effectively closing the way out of the metal plasma generated by the cathode in a plasma duct, while opening the way for the RAAD generated gaseous plasma.

2. When the duct coil is OFF (magnetic shutter is closed) and RAAD plasma is created within the coating chamber between the cathode in plasma duct and remote anode(s) in a coating deposition area outside of the plasma duct, the highly ionized plasma environment can be used for plasma assistant magnetron sputtering (RAAMS) processes. In this case, the magnetron sources positioned outside of the plasma duct in a coating area are turned ON and magnetron sputtering process is conducted in a highly ionized RAAD plasma environment. In this process, the productivity of the magnetron sputtering increases more than 30% and the coating is densified by the ion bombardment of the substrate surface by gaseous plasma-born ions.

3. When the plasma duct coil is ON, the magnetic shutter is open and metal plasma generated by the cathode in a plasma duct is flowing into the coating deposition area along the magnetic force lines of the transporting magnetic field generated by the duct coil. The filtered arc metal plasma can be used for deposition of the variety of coatings, including superhard hydrogen free tetrahedral amorphous carbon (ta-C) coating when graphite bar is used as a cathode target in a plasma duct. When magnetron sources positioned in the exit portion of the plasma duct and having their targets facing the substrates are turned ON, the hybrid filtered arc assisted magnetron sputtering (FAAMS) process starts. In this case, the filtered arc metal plasma which is 100% ionized is passing the magnetron sources mixing with the magnetron sputtering atomic metal flow which generally has a low ionization rate of <5%. The mixed filtered arc metal plasma and magnetron sputtering atomic metal flow is directed toward substrates in a coating area in front of the exit of the plasma duct, which provide hybrid filtered arc assisted magnetron sputtering coating deposition with high and controllable concentrations of the depositing metal atoms flow.

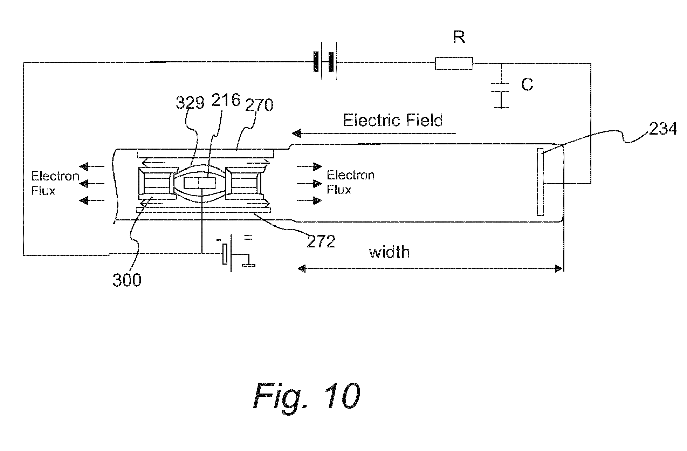

Figure 10 provides a schematic description of the physical processes which are involved in the bi-directional remote arc discharge of the present invention. The primary arc is initiated by an arc igniter on a surface of cathode target 216 isolated from the discharge chamber by the pair of trimming coils 300. This source can work in two modes: first, in a coating deposition mode when the arc vapor plasma is transported along the magnetic force lines of the longitudinal magnetic field created by the duct coil 270 force; and second, in electron emission mode, when the duct coil is turned off and arc plasma is confined and magnetically isolated from the processing chamber by the magnetic field created by a pair of trimming coils 300. The plasma potential within the plasma duct 272 is low, close to the potential of the proximate anode, which is in most cases grounded, while in the remote arc discharge plasma the electric potential is high, close to the potential of the remote anode 234. The typical distribution of the plasma potential between the plasma duct 272 and the remote anode 234, obtained by finite element modeling is shown in Figure 2.

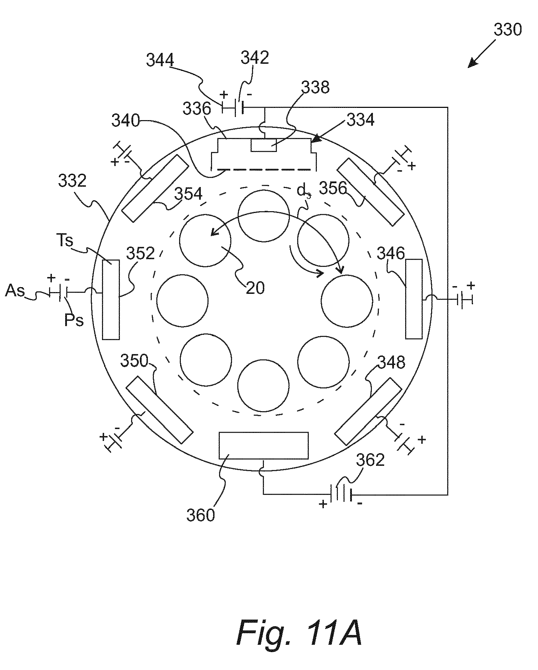

With reference to Figure 11A, a schematic of a batch coating system with a peripherally located shielded cathode chamber assembly is provided. Coating system 330 includes vacuum chamber 332, cathode chamber assembly 334, which includes cathode chamber 336, cathode 338 and shield 340. System 330 also includes primary power supply 342 which sets the voltage potential between cathode 338 and primary anode 344. System 330 also includes magnetron sputtering sources 356-366 each of which includes target Ts, power supply Ps, and anode As. System 330 also includes remote anode 360 which is set at a voltage potential relative to cathode 338 by power supply 362. In this embodiment, substrates 22 move axially along direction $d_3$ as they are coated.

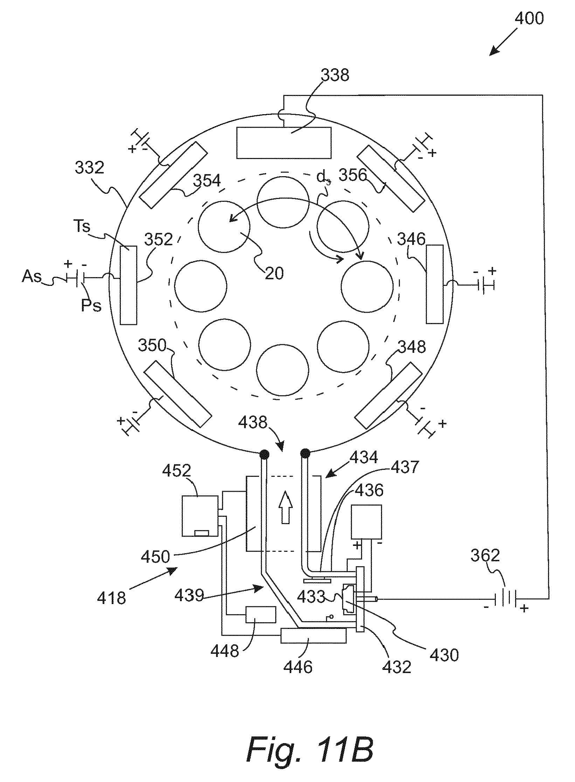

Figures 11B through 11G illustrate further variations that provide a unidirectional filtered cathodic arc metal vapor plasma sources in place of the shielded source shown in Fig.11A. The filtered cathodic arc sources can operate both as a sources of nearly 100% ionized, almost free of neutrals metal vapor plasma and as electron emitting source to provide a stream of electron current for generating remote anode arc discharge in the coating chamber. These two features can be accomplished by using the magnetic shutter mode as was discussed above in relation to Figures 8A-H. In the magnetic shutter mode, magnetic deflecting and focusing coils of the filtered arc source can be activated opening the magnetic shutter providing deflection and focusing of the metal vapor plasma, generating at the evaporating surface of the cathode target, toward substrates to be coated in the coating chamber. When magnetic deflecting and focusing coils are turned off, the magnetic shutter is closed. In this latter case, the cathode of the filtered arc source works as a powerful electron emitter delivering a high electron current toward the remote anode in the coating chamber where the remote anode arc discharge is established. When magnetic shutter is closed, the metal vapor ions generating by the cathode of the filtered arc source remain within the filtered arc source and cannot reach substrates to be coated in the coating chamber.

With reference to Figure 11B, a schematic illustration of a variation of a coating system incorporating a rectangular unidirectional filtered cathodic arc source as both metal vapor plasma deposition source and electron emitting source is provided. In a refinement, the design of the rectangular filtered arc source of U.S. Pat. No. 5,480,527 is used as the filtered arc source; the entire disclosure of this patent application is hereby incorporated by reference. Coating system 400 is similar to the system depicted in Figure 11A but is equipped with rectangular unidirectional filtered vacuum-arc source 418 (i.e., a plasma source).

The filtered vacuum-arc source 418 comprises of the plasma duct 434 which has a rectangular cross-sectional shape of similar dimensions to cathode target 430 while the long side of the plasma duct is parallel to the axes of the coating chamber 332. The plasma duct 434 includes a 90° bend in the axis along the centerline of the plasma duct 434. The plasma duct 434 consists of a cathode chamber portion in the form of the rectangular tube 436 and an exit tunnel 438 on either side of inner radius bend point 437 at the bend portion 439 of the plasma duct 434. The cathode 430 is mounted on an isolated holder 432 at or near the end of the cathode chamber 436 so that the evaporable surface 433 of the cathode target 430 faces into the plasma duct. A set of electromagnets is disposed about the plasma duct which includes deflecting and focusing electromagnets. Deflecting magnets 446 and 448 are connected to the power supply 452 and located about the outer side of the cathode chamber 436 and bend portion 439 of the plasma duct while the focusing electromagnetic solenoid 450 is connected to the power supply 452 while rapping around the exit tunnel portion 438 of the plasma duct 434. Cathode 430 is connected to the negative output of the primary arc power supply while the positive output is connected to the (grounded) plasma duct. Remote anode arc discharge is established by connecting the cathode 430 to the negative output of the remote anode arc power supply 362 while the positive output is connected to the remote anode 360 in the coating chamber 332. The system 400 operates in magnetic shutter mode. When both deflection coils 446 and 448 and the focusing coil 450 are turned ON the magnetic shutter is open and nearly 100% ionized filtered metal vapor plasma generated by the vacuum arc running the cathodic arc spots at the evaporable surface 433 of the cathode target 430 is transported throughout the plasma duct toward substrates to be coated 20 in a coating chamber 332. The gaseous environment is also highly ionized both within the filtered arc metal vapor plasma stream and within the narrow corridor defined between the passage of the substrates and the walls of the vacuum chamber 332 along the remote arc discharge path. In this case the magnetron sputtering sources 350, 352, 354, 356, 346, 348 can be also activated providing magnetron sputtering deposition assisted by remote anode arc discharge which allows to increase ionization of the magnetron sputtering flow while at the same time combining the magnetron sputtering with filtered cathodic arc deposition in a hybrid filtered arc-magnetron sputtering deposition process. When deflecting coils 446 and 448 and focusing coil 450 are turned OFF the magnetic shutter is closed and metal vapor plasma generated by the cathode 430 is trapped within the plasma duct 434 not reaching the substrates to be coated 20 in the coating chamber 332. In this mode the remote anode arc discharge is still running between the cathode 430 and remote anode 360 providing high ionization and activation of coating deposition environment along the corridor defined between the substrates passage $d_2$ and walls of the coating chamber 332. In this case the magnetron sputtering and gaseous plasma treatment of the substrates 20 can be performed in highly ionized environment established by the remote anode arc discharge. In a variation, the magnetron sputtering sources and remote anodes can be installed in the central area of the coating chamber attached to the outer wall of the source platform installed about the central area of the coating chamber.

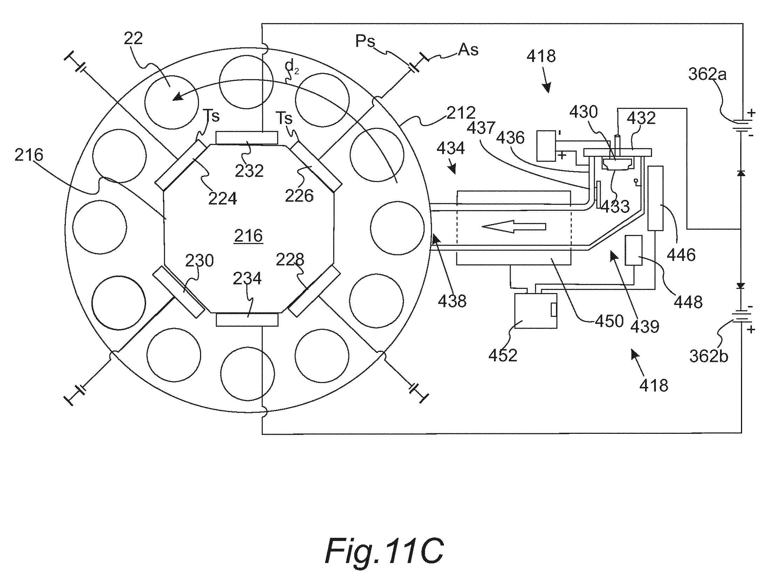

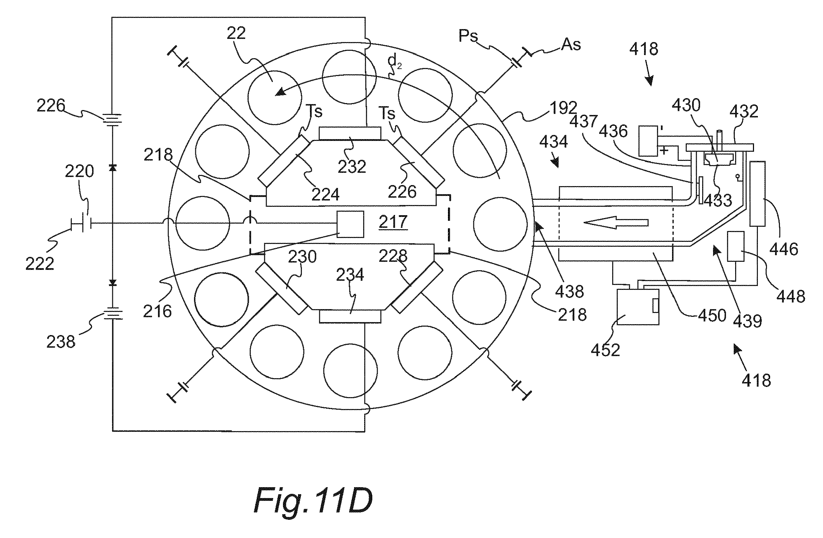

With reference to Figure 11C, a schematic illustrations of a coating system incorporating a rectangular unidirectional filtered cathodic arc source as both metal vapor plasma deposition source and electron emitting source is provided. Magnetron sources 224, 226, 228 and 230 and remote anodes 232 and 234 are attached to the outer wall of the central source hub 216. In this design substrates to be coated 20 are moving within the ring between the source hub 216 and the wall of the coating chamber 212. The remote anode arc discharge is established between the cathode 430 of the filtered arc source 418 and remote anodes 232 and 234 by connecting the cathode to the negative outputs of the remote anode arc power supplies 362a and 362b, while the positive output are connected to the respective remote anodes 232 and 234. In this case the RAAD plasma will fill the entire area defined between the central hub 216 and the wall of the coating chamber 212 leaving substrates 20 effectively immersed into highly ionized and activated RAAD plasma. In a refinement the shielded bi-directional filtered arc source similar to one discussed above in relation to Figures 7A, 8A can be also installed in a central area of the coating chamber. Figure 11D illustrates this refinement in which the remote anode arc discharge can be also established between the cathode 216 of a bi-directional filtered arc source and the remote anodes 232 and 234 installed at the peripheral rim of the bi-directional plasma duct 217. In this case the remote anode arc discharge is established mostly along the corridor defined between the outer rim of the plasma duct 217 and the substrate passage $d_2$ providing high ionization and activation of the metal sputtering flow generating by magnetron sources 224, 226, 228 and 230 disposed at the outer walls of the plasma duct 217.

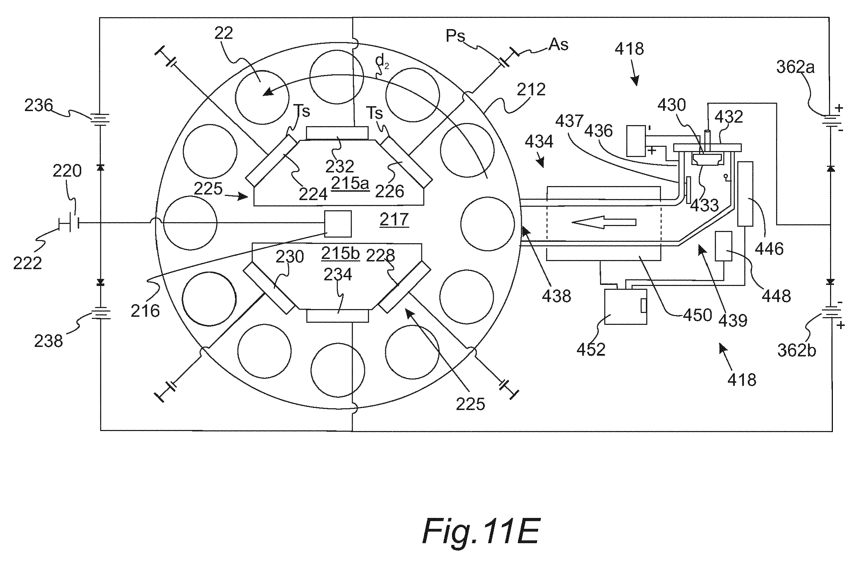

With reference to Figure 11E, a schematic illustrations of a coating system having bi-directional filtered arc source without the shield and a rectangular unidirectional filtered cathodic arc source is provided. In this variation, shields 218 from Figure 11D are removed to open the plasma duct 217 of the bi-directional filtered arc source toward coating deposition area in the coating chamber 212. In this advanced embodiment of the invention the remote anode arc discharge can be supported either by unidirectional filtered arc source 418 or by bi-directional filtered arc source 215 or by both filtered arc sources simultaneously. When the RAAD is established by the unidirectional filtered arc source 418, the cathode 430 is connected to the negative outlets of the remote anode arc power supplies 362a and 362b, while their respective positive outlets are connected to the remote anodes 232 and 234 disposed on the outer rim of the plasma duct 217. When the RAAD is established by the bi-directional filtered arc source 215, the cathode 216 is connected to the negative outlets of the remote anode arc power supplies 236 and 238, while their respective positive outlets are connected to the remote anodes 232 and 234 disposed on the outer rim of the plasma duct 217. In this case the remote anode arc discharge plasma will fill the coating deposition area defined between the outer wall of the bi-directional filtered arc source 215 and the wall of the coating chamber 212 providing improved ionization and activation of the magnetron sputtering flow generating by the magnetron sources 224, 226, 228 and 230 disposed at the outer walls of the plasma duct 217. In this arrangement both bi-directional filtered arc source 215 and unidirectional filtered arc source 418 can work both concurrently and independently in a magnetic shutter mode yet coupled with magnetron sputtering sources 224, 226, 228 and 230 while magnetrons and substrates to be coated 20 are immersed in highly ionized and activated RAAD plasma.

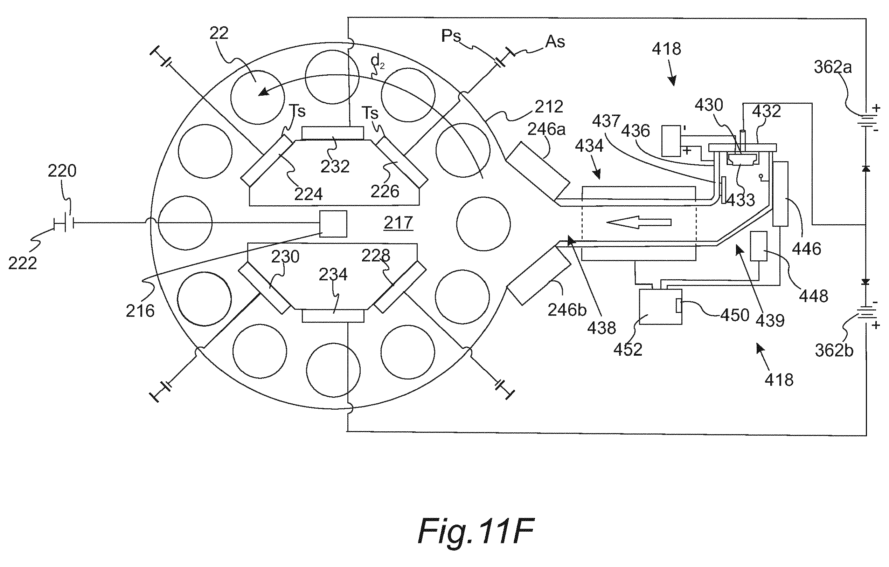

Figure 11F illustrates a further variation of the design of Figure 11E utilizing two magnetron sources 246a and 246b positioned adjacent to the exit tunnel portion 438 of the plasma duct 434 and the vacuum chamber 212 and facing the substrates 22 in the coating chamber 212. The magnetrons 246a and 246b are magnetically coupled with filtered arc source 418. In this design the magnetron sputtering flow is merging with the 100% ionized filtered arc metal vapor plasma generating by the cathode 430 of the filtered arc source 418 which allow to regulate the degree of ion bombardment by metal ions during coating deposition process.

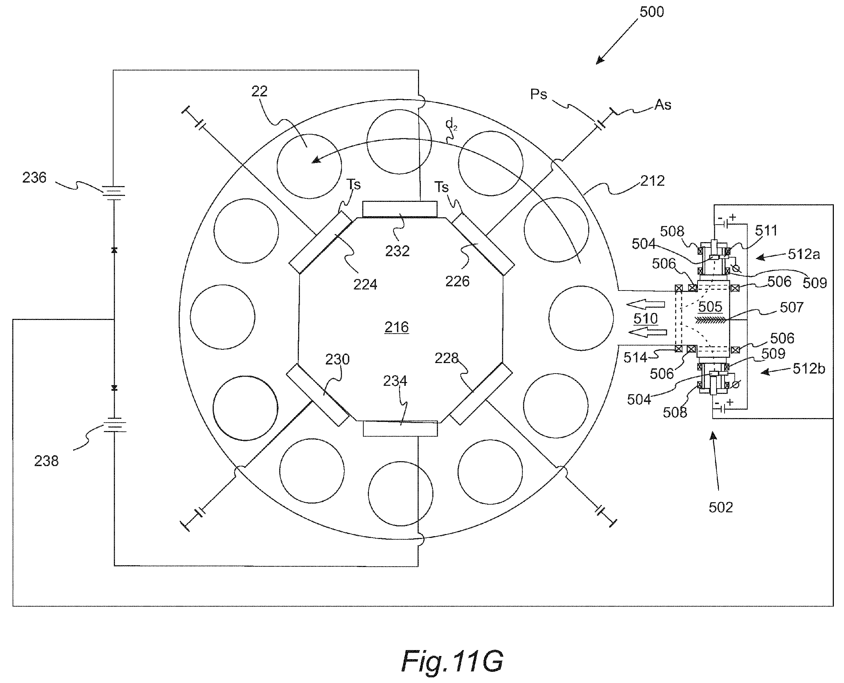

Figure 11G illustrates a further variation of the coating and surface treatment system presented above in Figure 11C. The design of this variation incorporates a coating and surface treatment system described in D.G. Bhat, V.I. Gorokhovsky, R. Bhattacharya, R. Shivpuri, K. Kulkarni, "Development of a Coating for Wear and Cracking Prevention in Die-Casting Dies by the Filtered Cathodic Arc Process," in Transactions of the North American Die Casting Association, 20th International Die Casting Congress and Exposition, Cleveland, OH, November 1999, pp. 391-399, the entire disclosures of which are hereby incorporated by reference. In this design, system 500 includes unidirectional dual arc rectangular plasma source 502 as a metal vapor plasma coating deposition source and as electron emitting source. The unidirectional dual filtered arc source of this design uses a rectangular plasma duct having deflecting portion 505 and exit tunnel section 510 with two cylindrical or rectangular cathodic arc chambers 512a and 512b installed on the opposite sides of the deflecting portion 505 of the plasma duct. Two or more cylindrical or two rectangular primary cathodic arc sources utilizing either cylindrical or elongated targets having form of a cylinder or rectangular plate are placed in the cathode chambers opposite each other on the side walls of the deflecting portion 505 of the plasma guide, surrounded by rectangular deflecting coils 506, and optionally separated by a baffled anode 507 plate. The stabilizing coils 508 are used to confine the cathodic arc spots at the evaporable surface of the cathode targets 504 while the focusing coils 509 which are surrounding the exit portion of the cathode chambers are focusing metal vapor plasma stream toward deflection portion 505 of the plasma duct. The arc can be ignited either by mechanical igniters which can periodically contact the surface of the cathode targets or by electronic (electro-spark) igniter 511 which can create a micro-arc plasma in the vicinity of the cathode targets. The front deflecting linear conductors of the deflecting coils are facing the coating chamber 212 in a position adjacent both to the cathode chamber and the plasma duct while the closing linear conductors of the deflecting coils are positioned behind cathode chambers away from the coating chamber 212. The source uses a superimposed deflecting magnetic field generated by the front linear conductors of the deflecting coils to turn the metal ion flow 90° towards the deposition chamber 212. Finally, a focusing coil surrounds 514 exit tunnel portion 510 of the plasma duct to focus two metal vapor plasma jets generated by the cathodes in cathode chambers 512a and 512b toward substrates 22 in a coating chamber 212. A set of scanning magnetic coils (not shown) allows the ion plasma jet to be swept in the vertical direction (perpendicular to the plane of the Figure 11G) so as to cover significantly large surface areas. At the same time, the arc column is well confined by a magnetic field in the horizontal direction, perpendicular to the plane of symmetry of the plasma duct, providing enhanced suppression of the turbulent plasma diffusion and leading to a significant increase in the metal vapor ion yield.

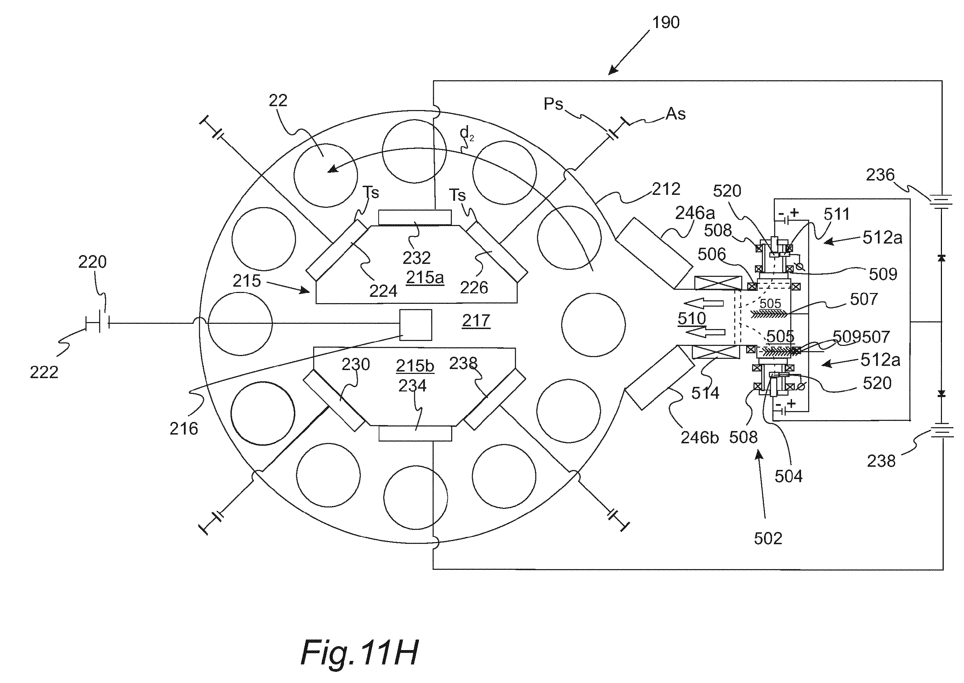

Figure 11H illustrates a further variation of the design of Figure 8D utilizing a bi-directional filtered arc source 215 which was discussed above in relation with Figure 11F and two magnetron sources 246a and 246b positioned adjacent to the exit tunnel portion of the plasma duct and the vacuum chamber 212 and facing the substrates 22 in the coating chamber 212. The magnetrons 226a and 226b are magnetically coupled with filtered arc source 502. In this design the magnetron sputtering flow is merging with the 100% ionized filtered arc metal vapor plasma generating by the cathode 520 of the filtered arc source 502 which allow to regulate the degree of ion bombardment by metal ions during a hybrid filtered arc enhanced magnetron sputtering coating deposition process.

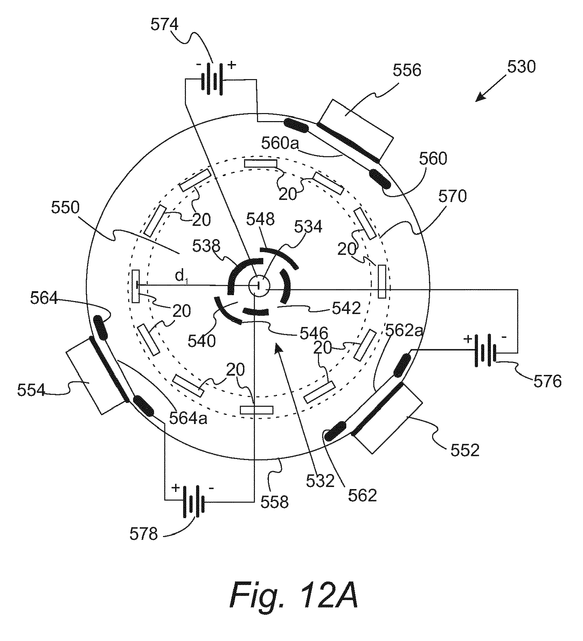

Figure 12A illustrates a further variation providing a shielded cathodic arc electron emission source located in the center of the coating chamber. In particular, the present variation provides a circular batch coating system 530 with cathode chamber assembly 532 located in its central area. The cathode 534 is positioned within the cathode chamber assembly 532 generally along the axes of the coating system 530. Cathode chamber assembly 532, respectively, include cathode enclosures 538 with openings 540 and 542 defined therein, cathode 534, optional primary anodes (not shown), and shields 546, 548. The enclosure 538 and shields 546, 548 respectively isolate cathode 534 from vacuum chamber 550 and can also serve as a primary anode for the arc discharge ignited in a cathode chamber 532. The primary arc power supply is also provided between the cathode 534 and the anode-enclosure 538. The enclosure 538 and shields 546, 548 each define openings for transmitting electron emission currents into vacuum chamber 550, while at the same time serving as a barrier stopping the heavy particles such as metal vapor atoms, ions and macroparticles, emitted from the cathode 534 to reach substrates 20 to be coated in the coating chamber 550. The magnetron sputtering sources 552, 554, and 556 are attached to the wall 558 of the chamber 550. The remote anodes 560, 562 and 564 are positioned next to the corresponding magnetron sources, preferably surrounding these sputtering sources. The remote anodes 560, 562 and 564 are optionally provided with thin wire grids 560a, 562a and 564a disposed in front of the sputtering targets of the respective magnetron sources 552, 554 and 556. The substrates 20 are positioned on rotary table platform 570 at the distance $d_1$ between the cathode chamber and magnetron sputtering targets. The distance from the magnetron target surface to the substrates 20 is typically ranging from 4 to 10 inches. The remote arc power supplies 574, 576, and 578 are installed between the remote anodes 560, 562 and 564 and the central cathode 534 in the cathode chamber 532. The cathode 534 can be a thermionic filament cathode, but preferably the cold evaporative vacuum arc cathode can be used, which is not sensitive to the reactive plasma processing environment which can contain chemically aggressive gases such as methane, oxygen and nitrogen for coating deposition of carbides, oxides and nitrides. Cathode 534 is either elongated thermionic filament or a cold cathode in a form of elongated metal bar or rod. Moreover, cathode 534 is positioned within the cathode chamber 532 along the axes of the coating chamber 550 with its electron emission zone length parallel and generally dimensionally equal to the height of the substrate 20 loading zone. Moreover, cathode 534 has a long dimension that is either less than or equal to the height of the remote anodes 560, 562 and 564. The heights of the magnetron targets are also either less than or equal to the height of the remote anodes.

In a refinement, the magnetrons 552, 554, 556 shown in Fig. 12A, can be replaced with planar heaters. The substrates to be coated can be placed at the heater surface, facing the center of the chamber where the shielded cathode chamber 532 is positioned with the cathode 534. In this case the substrates can be heated to 900 °C while at the same time highly ionized remote anode arc plasma can be established in the chamber 530 by remote anode arc discharge between the cathode 534 in a cathode chamber 532 and the remote anodes 560, 562, 564 positioned at the wall of the chamber 530. In this process, when gas atmosphere in a chamber 530 is composed of a mixture of methane, hydrogen and argon at the pressure range from 1 mTorr to 200 mTorr and methane concentration in hydrogen ranging from 0.1 to 2 at. weight % the polycrystalline diamond coatings can be deposited on substrates positioned at the heated surface of the heaters, heated to the deposition temperature ranging from 700 to 1000 °C.

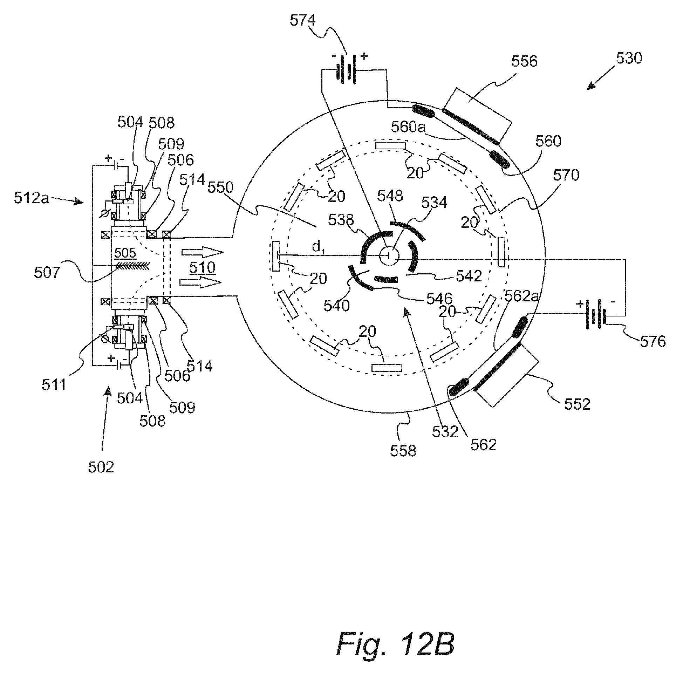

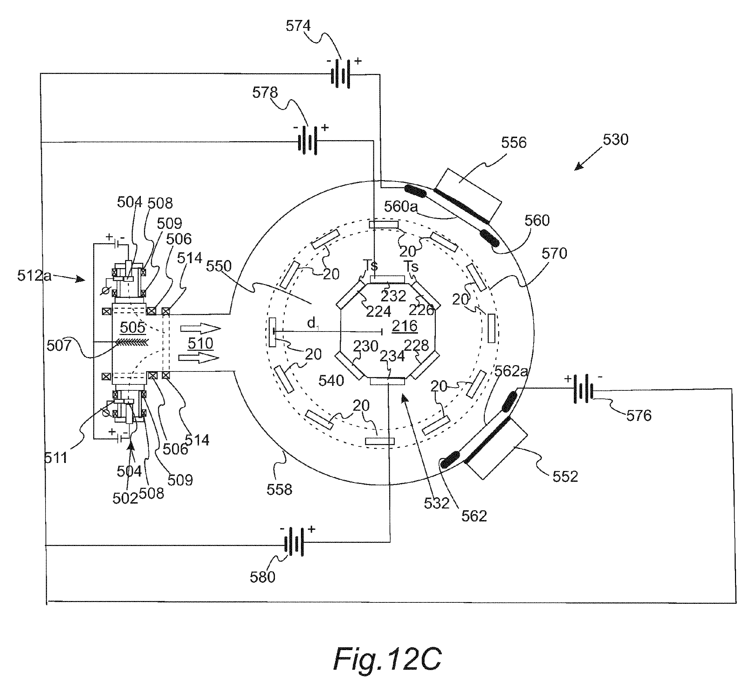

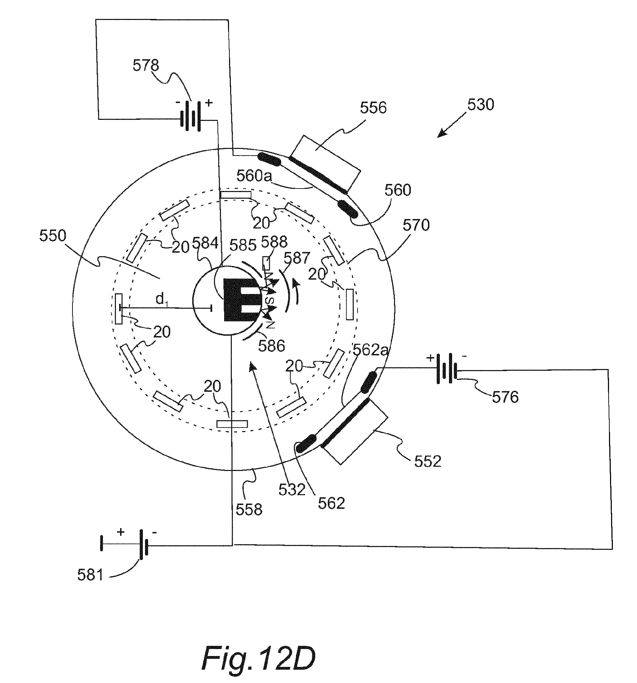

In a variation of the embodiment of Figure 12A, the coating and surface treatment system 530 can be equipped with unidirectional filtered arc source attached to the wall of the coating chamber. With reference to Figure 12B the unidirectional dual filtered arc source 502, which was discussed above in relation to Figure 11G, is attached to the coating chamber 558. The coating system 530 is also provided with two planar or rotary magnetron sputtering sources 552 and 556 attached to the wall of the coating chamber 558. The magnetron sputtering flow is ionized and activated by RAAD plasma established by connecting the centrally located shielded cathode 534 to the negative outputs of the RAAD power supplies 574 and 576 while their positive outputs are connected to the respective remote anodes 560 and 562, which are optionally provided with thin wire grids 560a and 562a disposed in front of the sputtering targets of the respective magnetron sources 552 and 556. In a refinement shown in Figure 12C the coating and surface treatment system 530 is also provided with a centrally positioned source hub 216 having magnetron sputtering sources 224, 226, 228 and 230 in addition to two remote anodes 232 and 234 attached to the outer rim of the source hub 216. The RAAD plasma is established by connecting the cathodes of the filtered arc source 502 to the negative outputs of the RAAD power supplies 578 and 580 while their positive outputs are connected to the respective remote anodes 232 and 234 positioned at the outer rim of the source hub 216. In this design the entire area between the wall of the source hub 216 and the wall of the chamber 558 is filled with highly ionized plasma of RAAD discharge providing ionized deposition both by magnetrons 552 and 556 positioned on the wall of the chamber 558 and by magnetrons 224, 226, 228 and 230 positioned on the outer wall of the source hub 216 while keeping substrates to be coated 20 immersed in RAAD plasma during all stages of the hybrid filtered arc plasma assisted remote anode arc enhanced magnetron sputtering coating deposition process. Figure 12D provides a schematic illustration of a system having a cylindrical cathodic arc source with rotating tubular cathode target. In this refinement, electron emitting arc source 532 positioned in a center of the coating chamber 558 can be cylindrical cathodic arc source with rotating tubular cathode target having high material utilization rate as illustrated schematically in Figure 12D. In this embodiment the cylindrical cathode target 584 is positioned in the center of the coating chamber 558. The direction of rotation of the target 584 is shown by the arrow. Magnetic yoke 585 composed of permanent magnets is positioned inside of the cathode target cylinder aimed on forming the racetrack magnetic field at the evaporation surface of the cathode target 585. The cathodic arc spots are steering within the racetrack formed between the poles of the magnetic yoke 585. The shields 586 prevent cathodic arc spots from escaping from the evaporation area of the cathode target 584 surface. The optional movable shield 587 is also installed in front of the evaporation area of the cathode target 584. When the shield 587 is closed the plasma source 582 is operating in electron emission mode as a primary cathodic arc source for the remote arc discharge established between the cathode 584 and the remote anodes 560 and 562 adjacent to the magnetron sources 552 and 556. When the shield 587 is open the evaporation area of the cathode target 584 is facing the substrates to be coated 20 and the cathodic arc source 582 is operating in both cathodic arc coating deposition mode while still supporting the remote anode arc discharge for ionization and activation of the magnetron sputtering produced by the magnetron sources 552 and 556.

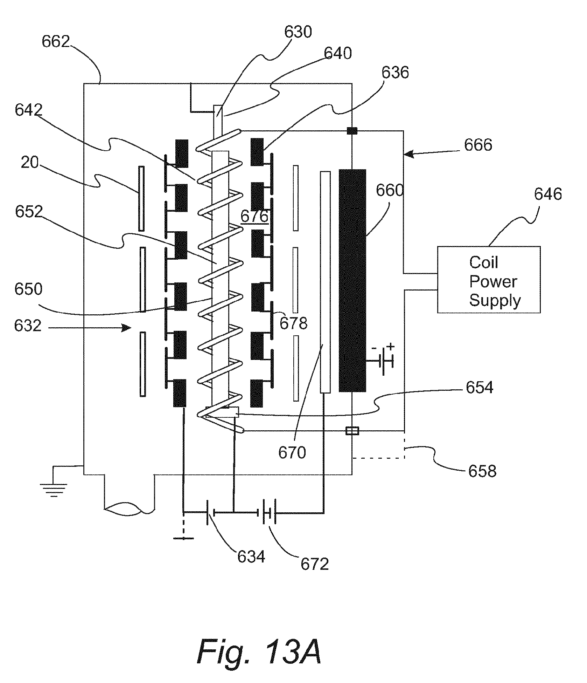

With reference to Figure 13A, a schematic illustration of a system incorporating an electron emitting vacuum arc cold cathode source is provided. In particular, the present variation adopts the design of the electron emitting vacuum arc cold cathode source of the system of U.S. Pat. No. 5,269,898, the entire disclosure of which is hereby incorporated by reference. Rod-shaped cathode 630 is mounted within cathode chamber 632, which serves as a primary anode for the vacuum cathodic arc discharge powered by the primary arc power supply 634. Cathode 630 is connected to the negative output of an arc power supply 634, and the enclosure 636 of the cathode chamber 632 is connected to the positive output of arc power supply 634. The positive output of the primary arc can be optionally grounded as shown by the dashed line in Figures 7D and 13A. An arc is struck repetitively by a striker 640, located at the end of cathode 630 that is opposite the connection to arc power supply 634. A helical electromagnet coil 642 is mounted coaxially with the cathode 630 and serves to generate a solenoidal magnetic field with flux lines substantially parallel to the cathode 630 axis, and having a magnitude proportional to the current furnished by a coil power supply 646. One or more substrates 20, upon which a coating is to be deposited, are disposed surrounding the cathode chamber 632 and optionally mounted on a substrate holding turntable platform (not shown) which will provide rotation of the substrates during deposition, if necessary, to achieve a uniform coating thickness distribution thereon. An arc spot 650 and a typical trajectory 652 thereof resulting from the influence of the applied magnetic field are also depicted. Arc spot travels all or part of the length of the cathode 630 toward the connection to arc power supply 634 before being re-struck. The insulator 654 prevents movement of the arc spot 650 off the desired evaporable surface of cathode 630. Electromagnet coil 642 may be electrically isolated from the arc circuit, or it may comprise a part of the anode by connection thereto as indicated by the dotted line 658. The electromagnetic coil 642 may alternatively serve as the sole primary anode for the primary arc discharge in the cathode chamber 632, in which case the electromagnetic coil 642 is isolated electrically from the chamber 430 and connected to the positive output of primary arc power supply 634, which is disconnected from the cathode chamber 632. One or more magnetron sputtering sources 660 are mounted along the walls 662 of the chamber 666 surrounded by the remote anodes 670. The remote anodes are connected to the positive output of the remote arc power supply 672, while its negative output is connected to the cathode 630 in the cathode chamber 632. The enclosure 636 of the cathode chamber 630 has openings 676 covered by shields 678 to prevent the heavy particles (ions, neutral atoms and macroparticles) emitted by the cathode 630 from reaching the deposition area outside of the cathode chamber 632, but the electrons are able to freely penetrate into the coating area throughout the openings 676 between the enclosure 636 and shields 678. The remote arc current is conducting between the cathode 630 within the cathode chamber 632 and remote anodes 670 surrounding the magnetron sputtering sources 660 at the wall of the coating chamber 666. The remote anode is connected to the positive output of the remote arc power supply 672, while the negative output of the remote arc power supply 672 is connected to the cathode 630 in the cathode chamber 632. The remote arc ionizes and activates the plasma environment during the magnetron sputtering coating deposition process, but can also serve as a source of ionization and creation of plasma environment in a coating area during preliminary ion cleaning of the substrates before the coating process starts, as well as for the plasma immersion ion implantation, ionitriding and plasma assisted low pressure CVD coating deposition processes.

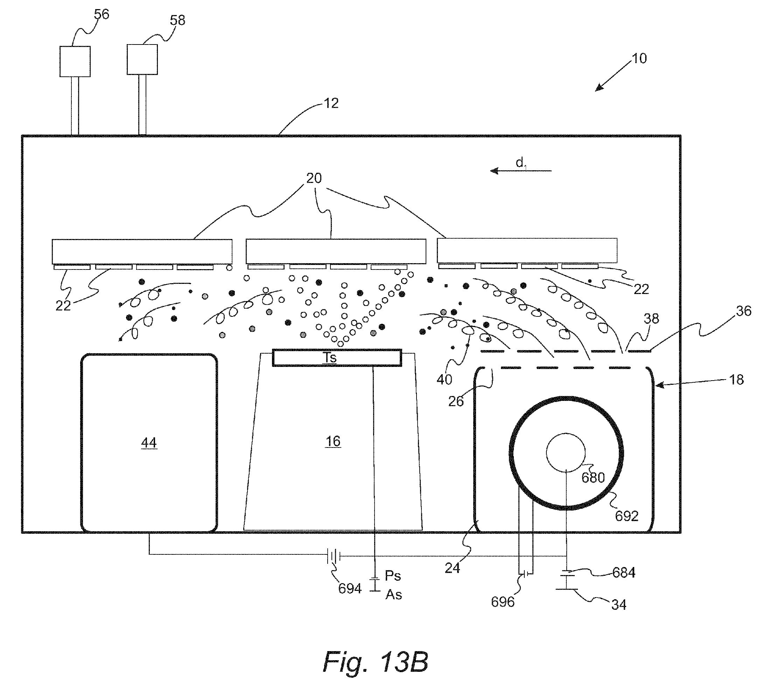

With reference to Figure 13B, a schematic illustration of an inline system (see Figure 1) using the cylindrical cathodic arc source of Figure 13A as a primary cathodic arc electron emitting source is provided. This design is illustrated in Figure 13B which shows the side view of one module of the inline coating system 10 equipped with magnetron sputtering source 16, remote anode 44 and primary cathodic arc electron emitting source 18. The primary cylindrical cathodic arc source 18 is positioned within the enclosure 24 having the output shield permeable for the electron current, but impermeable for heavy particles such as metal ions, atoms and macroparticles. Rod-shaped cathode 680 is mounted within the grounded cathode chamber enclosure 24, which serves as a primary anode for the vacuum cathodic arc discharge powered by the primary arc power supply 684. Cathode 680 is connected to the negative output of an arc power supply 684, and the enclosure of the cathode chamber 24 is grounded. A helical electromagnet coil 692 is mounted coaxially with the cathode 680 and serves to generate a solenoidal magnetic field with flux lines substantially parallel to the cathode 680 axis, and having a magnitude proportional to the current furnished by a coil power supply 696. The RAAD plasma is established within the corridor defined between the substrate holder 20 with substrates to be coated 22 and the walls 12 of coating system 10 by connecting the rod-cathode 980 to the negative output of the RAAD power supply 472 while the positive output of the power supply 694 is connected to the remote anode 44.

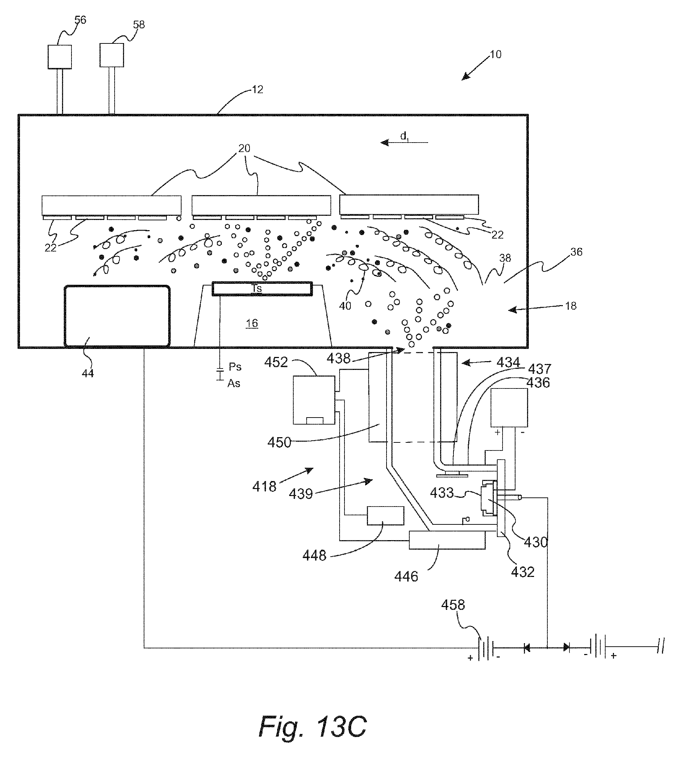

Figures 13C through 13E illustrate a further variation of the inline coating system providing the unidirectional filtered cathodic arc metal vapor plasma source instead of shielded cathodic arc source shown in Figures 13A and 13B as a primary cathodic arc sources both for establishing the RAAD plasma and for generating metal vapor plasma for coating deposition purposes. With reference to Figure 13C, a schematic illustration of a coating system using the rectangular filtered arc source previously described in relation to Figure 11B is provided. In this variation, the filtered arc source is used as metal vapor plasma source and as electron emitting source to support the RAAD plasma in inline system 10. The system 10 operates in magnetic shutter mode. When both deflection coils 446 and 448 and the focusing coil 450 are turned ON the magnetic shutter is open and nearly 100% ionized filtered metal vapor plasma generated by the vacuum arc running the cathodic arc spots at the evaporable surface 433 of the cathode target 430 is transported throughout the plasma duct toward substrates to be coated 20 in a coating chamber 212. When deflecting coils 446 and 448 and focusing coil 450 of the rectangular filtered arc source 418 are turned OFF the magnetic shutter is closed and heavy particles of the metal vapor plasma (metal ions, atoms and macroparticles) generated by the cathode 430 are trapped within the plasma duct 34 not reaching the substrates to be coated 20 in the coating chamber 12, while the electron current emitted by the cathode 430 can be conducted throughout the coating chamber 212. In this mode the remote anode arc discharge is still running between the cathode 30 and remote anode 44 providing high ionization and activation of coating deposition environment along the corridor defined between the substrates passage $d_1$ and walls of the coating chamber 12.

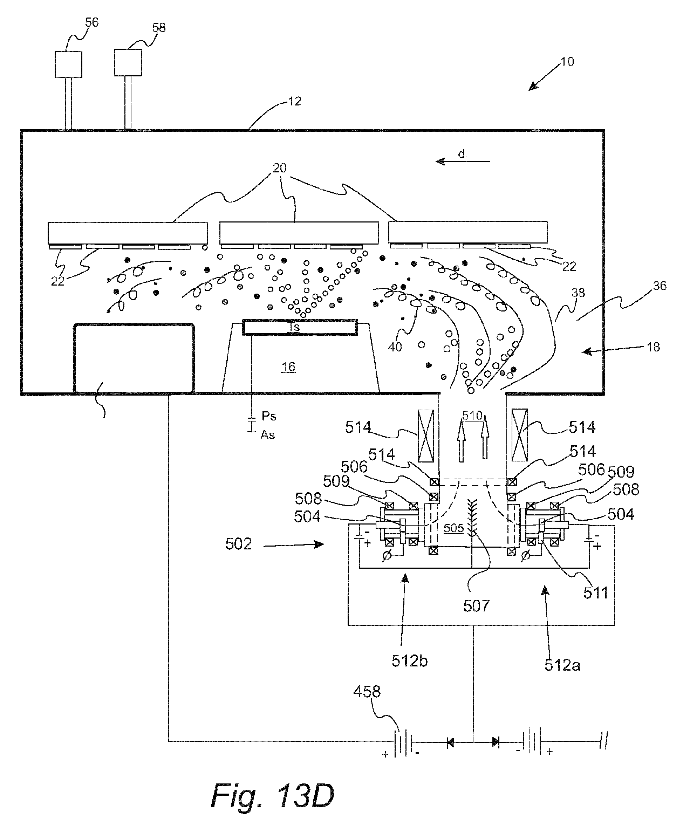

With reference to Figure 13D, a schematic illustration of an inline coating system using the unidirectional dual filtered arc source described for Figure 11G is provided. In this refinement, the unidirectional dual filtered arc source is used both as metal vapor plasma coating deposition and electron emitting source as illustrated in Figure 13D. The filtered arc source 418 is operating in the magnetic shutter mode: when deflecting coil and focusing coils of the plasma duct magnetic deflecting system are turned ON the magnetic shutter is opened and the metal vapor plasma generating by cathodic arc spots of the vacuum arc cathodes produce two metal vapor plasma jets which flow the metal vapor plasma through the cathode chamber into the deflecting portion of the plasma duct where the plasma flow is bending 90° by the magnetic deflecting system toward the exit tunnel section of the plasma duct where both jets are merging and focusing toward substrates to be coated 22 in the inline coating chamber 12. When deflecting coil and focusing coils of the plasma duct magnetic deflecting system are turned OFF the magnetic shutter is closed and heavy particles of the vacuum arc metal vapor plasma (metal ions, metal atoms and macroparticles) are trapped within the cathode chambers and the plasma duct, not reaching the substrates to be coated 22 in the coating chamber 12. In this case the filtered arc source 418 is still operating as a powerful electron emitter, providing the electron current throughout coating chamber 12 establishing the RAAD plasma environment for ionizing and activation of gaseous atmosphere and metal sputtering flow during coating deposition and surface treatment processes. In this mode the RAAD discharge is established between the primary cathodes of the filtered arc source 418 connected to the negative outputs of the RAAD power supply 458 while the positive output of this power supply is connected to the remote anode 44.

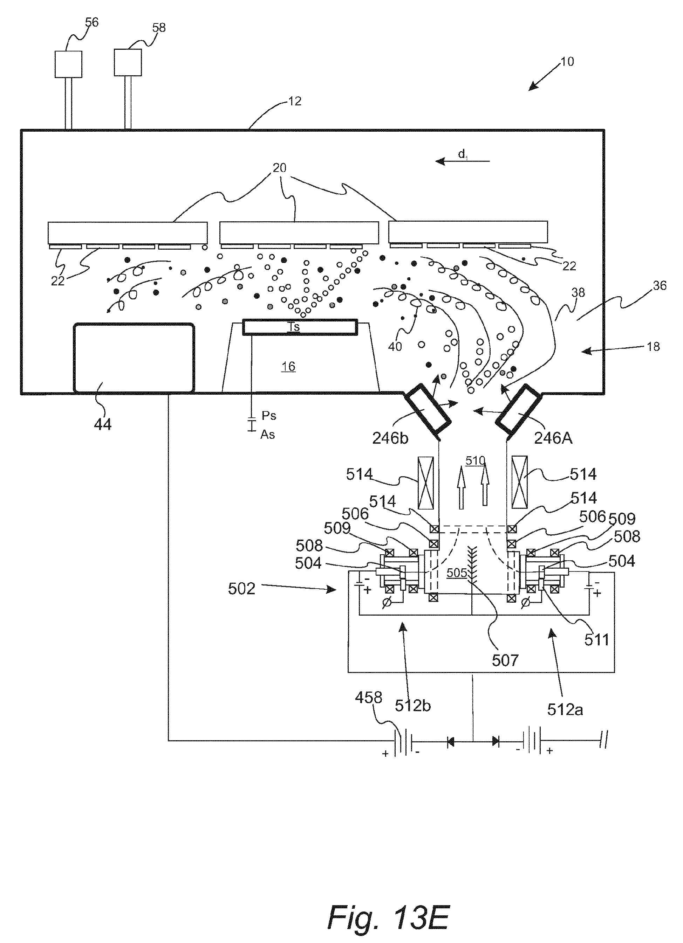

With reference to Figure 13E, a schematic illustration of an inline coating system using the unidirectional dual filtered arc source described for Figure 11G with two magnetron sources at the exit tunnel of the arc source is provided. Magnetron sputtering sources 246a and 246b are installed adjacent to the coating chamber 12 and the exit tunnel section of the plasma duct. The metal sputtering flows generating by the magnetron sputtering sources are merging with metal vapor plasma flow generating by the filtered arc source providing controlled ionization of the metal vapor plasma and consequently, a controllable level of ion bombardment during deposition of coatings by the hybrid filtered arc enhanced remote anode arc assisted magnetron sputtering process.

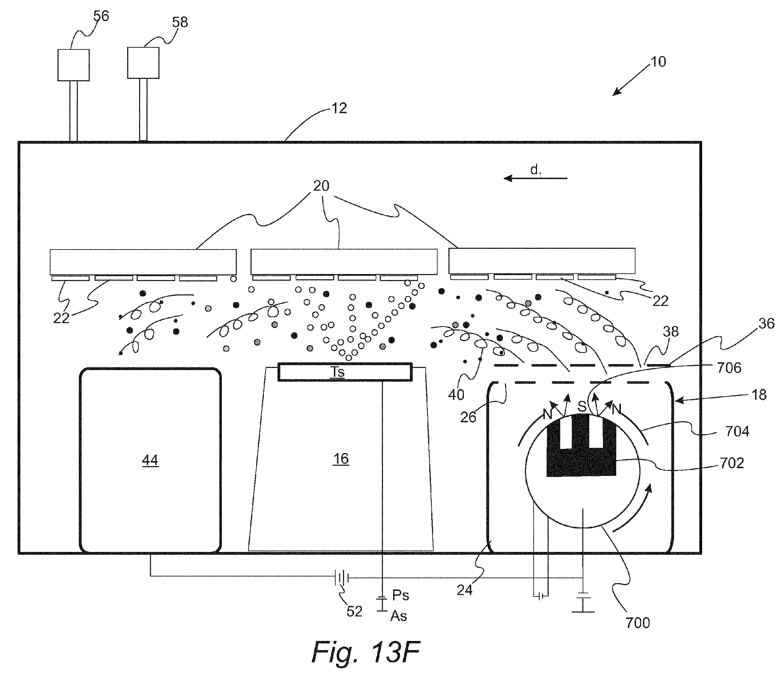

With reference to Figure 13F, a schematic illustration of an inline coating system with a cylindrical cathodic arc source is provided. In this refinement, the electron emitting primary cathodic arc source 18 positioned within the cathode chamber enclosure 24 can be cylindrical cathodic arc source with rotating tubular cathode target having high material utilization rate as illustrated schematically in Figure 13F. In this embodiment the cylindrical cathode target 700 is positioned in the cathode chamber enclosure 24. The direction of rotation of the target 700 is shown by the arrow. Magnetic yoke 702 composed of permanent magnets is positioned inside of the cathode target cylinder 700 aimed on forming the racetrack magnetic field at the evaporation surface of the cathode target 700. The cathodic arc spots are steering within the racetrack formed between the poles of the magnetic yoke 702. The shields 704 prevent cathodic arc spots from escaping from the evaporation area of the cathode target surface 706.

The primary cathodic arc electron emitting sources and remote anodes can be also positioned on both sides of one or more magnetron sputtering sources providing with a switching means for periodically switching the remote arc discharge from one primary cathode-remote anode pair to another which effectively will switch the direction of the electric field and the arc current in the remote arc discharge on opposite direction.

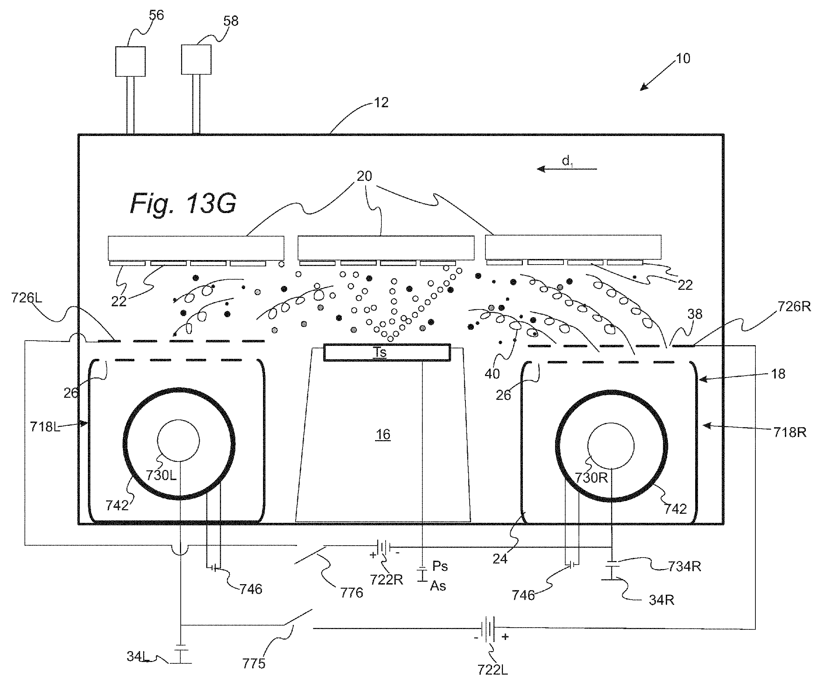

With reference to Figure 13G, a schematic illustration of an inline coating system using the cylindrical primary cathodic arc source as previously described in relation to Figure 13B is provided. In this variation, cathodic arc chambers 718L and 718R are positioned on left side and right side of at least one magnetron sputtering source 16. The remote arc power supply 722L is connected between the right remote anode 726R and the left primary cathode 730L in the left cathode chamber 718L via switch 1040. The remote arc power supply 736R is connected between the left remote anode 36L and the right primary cathode 730R in the right cathode chamber 1018R via switch 775. In operation the primary arcs in the primary cathode chambers 718L and 718R are operating continuously powered by the primary arc power supplies 734L and 734R respectively, while the remote arc discharges are activated either between the left cathode 730L and right remote anode 736R when the switch 775 is closed and the switch 776 is opened or between the right cathode 730R and the left remote anode 736L when the switch 776 is closed and the switch 775 is opened.

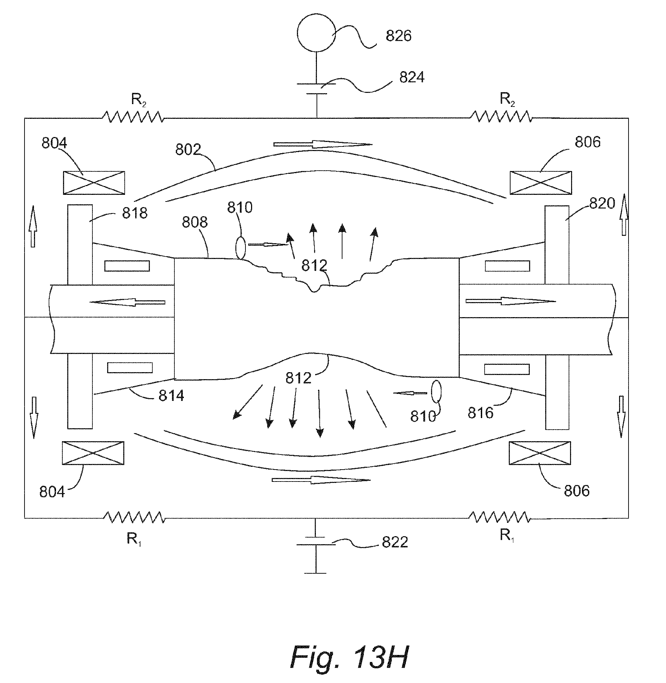

In a refinement, the electron emitting vacuum cathodic arc source with short cylindrical target and magnetically steering arc spots can be also used as a primary electron emission cathodic arc source in RAAD/RAAMS process implemented in batch coating systems such as shown in Figures 12A through 12D as well as in inline coating systems such as the one shown in Figures 13B and 13G. However, it should be noted that the remote anode linear dimensions should be chosen generally equal or exceeding and parallel to the linear dimensions of the substrates arrangement at the substrate holder and the longer linear dimension on the magnetron target even when the linear dimensions of the electron emitting primary cathode in the cathode chamber is shorter and not parallel to said dimensions of the magnetron target and substrates at the substrate holder. Figure 13H illustrates the design of the vacuum cathodic arc source with short cylindrical target and magnetically steered arc spots. The arch configuration of the magnetic force lines 802 created by the pair of steering magnetic coils 804, 806 positioned at the opposite ends of the cylindrical cathode target 808, allowed confinement of the vacuum cathodic arc spots 810 on cylindrical cathode target under the area where the magnetic steering field is nearly parallel to the axes through the length of the cathode target. At the same time the cathodic arc spots 810 are rotating around the axes of the target under the influence of electromagnetic forces proportional to the Ampere force as was described above in Eqn. 1. By changing the amplitude of current in one of the steering coils versus, the opposite one, the area where the magnetic field is generally parallel to the axes of the target can be moved along the target which will drive the location of the cathodic arc spots accordingly resulting in increase of the erosion area 812 and electron emission area on the cathodic arc target therefore increasing the service time of the cylindrical cathode target as electron emitting source in RAAD/RAAMS process. The cylindrical cathode target 808 is connected to the smaller butt-ends of the water-cooled frustoconical holders 814, 816 on both opposite ends of the cylinder. The frustoconical holders 814, 816 cool the cylindrical target and prevent the cathodic arc spots 810 from escaping the cylindrical surface area, where consumable vacuum arc cathode target emits the electrons. In addition, two ceramic insulating discs 818, 820 can be optionally added to the both ends of the cathode target to further prevent the arc spots from escaping the electron emission area. The cathode target 808 is connected to the arc power supply 822 in symmetrical manner where the negative pole of the primary arc power supply is connected to both ends of the cylindrical target via generally equal length connecting wire while the positive pole of the primary arc power supply is connected to the cathode chamber enclosure (shown in Figure 13G) or grounded. Another pair of generally equal length wires is connecting both ends of the target to the negative pole of the remote arc power supply 824 while its positive pole is connected to the remote anode 826.

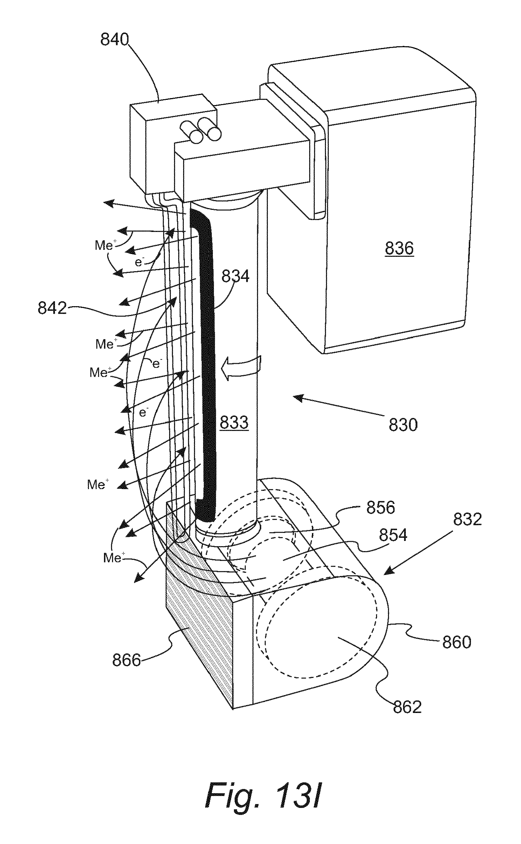

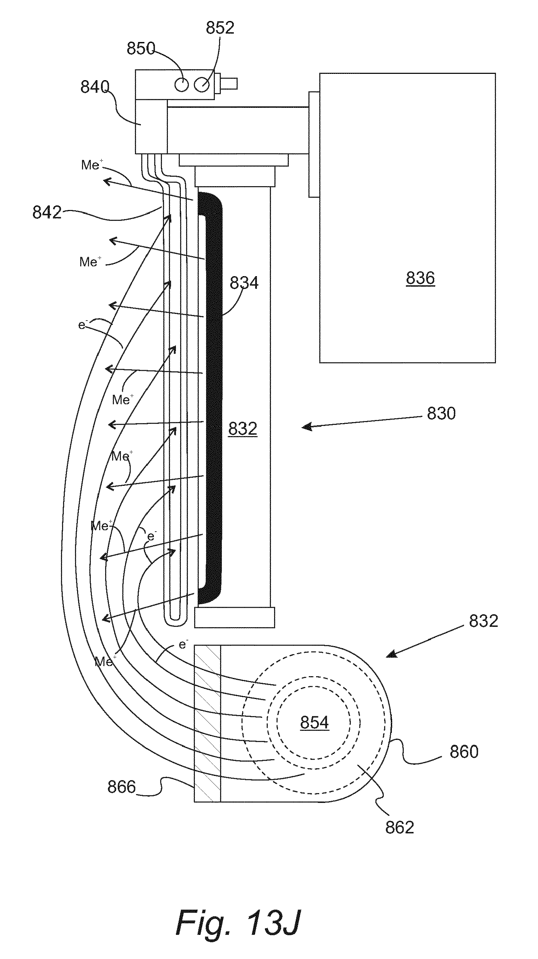

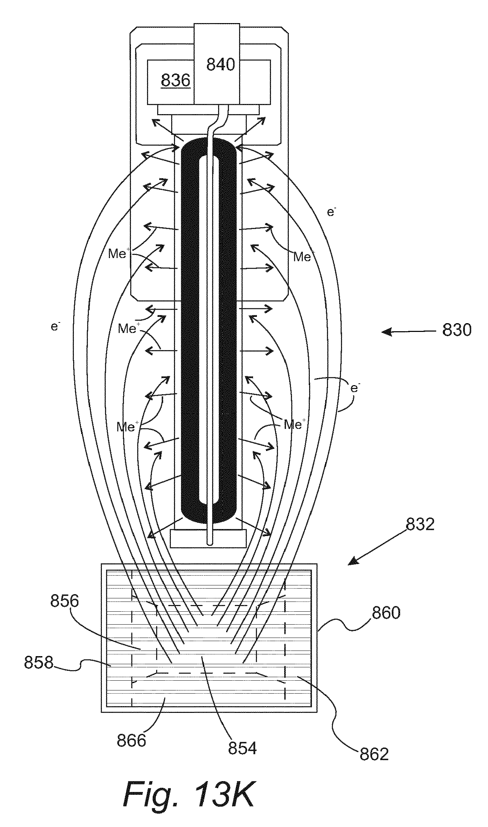

Figures 13I-13K provide schematic illustrations of coating systems incorporating cylindrical magnetron with rotating tubular targets and short cylindrical vacuum cathodic arc sources as electron emitter for the remote arc discharge. Figure 13I illustrates the global view of the rotary target magnetron metal vapor source 830 utilizing the short cylindrical cathodic arc electron emitting source similar to one shown in Figure 13H, positioned in the cathode chamber 832. The rotary magnetron 830 utilizes the rotating tubular target 833 with magnetron sputtering racetrack 834 facing the substrates to be coated in the coating chamber (as shown in Figure 12D). The tubular magnetron target 833 is held by the rotating mechanism located in the magnetron target holding chamber 836. The cathode chamber 832 is located at one end of the long side of the magnetron target 830, whiles the remote anode chamber 840 which holds the remote anode 842, is located at the opposite end of the long side of the tubular magnetron target 830. In the variation shown in Figure 13I, the water-cooled tubular remote anode 842 is positioned symmetrically along the central line in the middle between two long sides of the racetrack 834 as illustrated in Figure 13K and typically spaced from 0.5 cm to 5 cm from the magnetron target surface. The water for the cooling of the remote anode 842 is supplied via water cooling jacks 850 and 852 at the remote anode chamber 840 as illustrated in Figure 13J. The short cylindrical cathodic arc source incorporating the cylindrical consumable target 854, the frustoconical metal holders 856 and ceramic discs 858 preventing the cathodic arc spots escaping from the electron emitting area on cylindrical target 854 is positioned within the enclosure 860 of the cathode chamber 832 generally parallel to the short dimension of the magnetron target 830. The linear dimension of the cylindrical cathodic arc target ranges from the width (short dimension) of the magnetron racetrack 834 to the diameter of the magnetron sputtering tubular target 830. This alignment of the electron emitting cathode provides that the electron flowing along the remote arc discharge are uniformly covering the magnetron discharge zone in front of the magnetron sputtering racetrack 834. The steering magnetic coils 862 are located at the opposite ends of the cylindrical cathode target 854 for steering the vacuum cathodic arc spots along the evaporating are on cathode target. The enclosure 860 is covered by the baffled screen 866 facing the same side as the magnetron racetrack 834 providing that the electrons emitted by the cathodic arc source can flow toward the remote anode 840 and ionizing the metal atom sputtering flow generated along the racetrack 834 by the magnetron sputtering target 830.

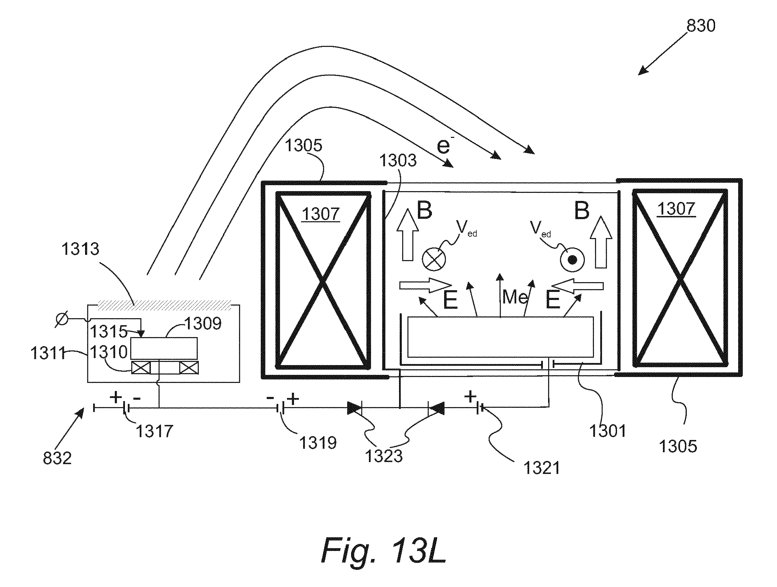

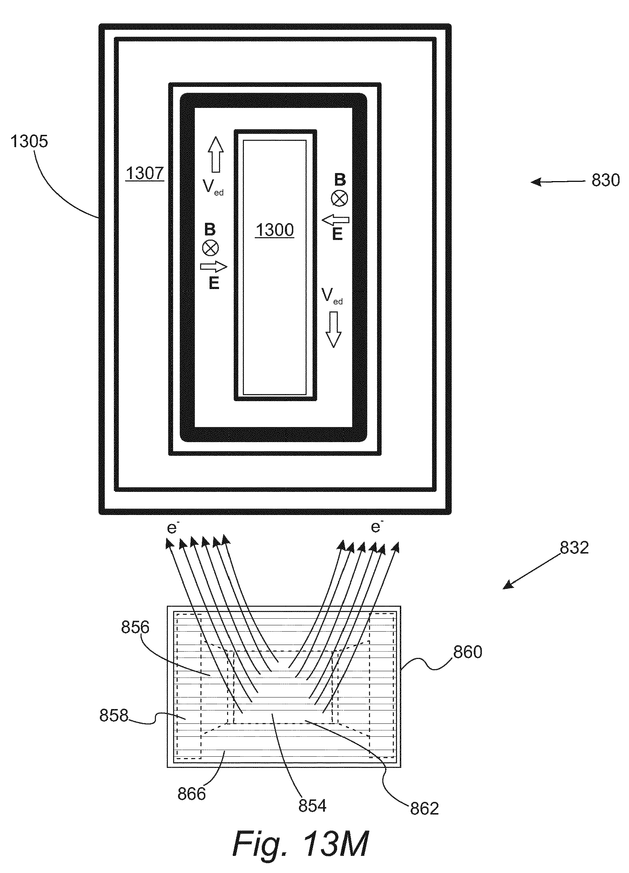

In a further variation of the embodiment in Figures 13I,J,K, the remote anode can surround the sputtering area in a manner shown schematically in cross-section in Figure 13L. This embodiment of the invention can be used both for enhancement of magnetron sputtering and diode sputtering which does not require the magnetron magnetic system for densification of sputtering discharge plasma in front of the sputtering target. The remote arc assisted diode sputtering (RAADS) embodiment is shown illustratively in Figures 13L-M. In the cross-sectional view shown in Figure 13M the diode sputtering source 830' consists of sputtering target 1300 enclosed in a shield 1301. The target 1300 is surrounded by the remote anode 1303 isolated from the surrounding plasma environment by the shield 1305, which leaves the anode open to the discharge plasma only on side facing the cathode. In this case a discharge cavity 1304 opened toward substrates to be coated in a coating chamber (as shown in similar arrangement in Figure 12A) is formed in front of the sputtering target limited by anode walls 1303 on side and the sputtering target 1300 on back butt-end. The magnetic coil 1307 can be optionally enclosed within the anode shield 1305 for increasing the plasma density within the discharge cavity 1304. The diode sputtering discharge is between the diode cathode target 1300 and remote anode 1303 is powered by high voltage low current power supply 1321 operating in voltage source mode. The igniting voltage of this discharge has a threshold of about 200-300 volts depending on target material which is determined by onset of secondary electron emission from the target under condition of ion bombardment from diode discharge plasma. The remote arc assistance mode is provided by the shielded electron emission cathodic arc source 1309 which can be installed elsewhere in the vacuum chamber. The electron emission cathodic arc source 832 shown in Figure 13L consists of cathode target 1309 with steering magnetic coil 1310. The cathode assembly is enclosed in the enclosure 1311 having a chevron lid 1313 which is impermeable for heavy particles (atoms, ions and macroparticle emitted by the cathode target 1309), but allows the electron current to flow freely toward vacuum chamber. The primary cathodic arc powered by primary arc power supply 1317 is ignited on evaporating surface of the cathode target 1309 by igniter 1315. The electron current emitted by the cathodic arc source 832 is conducted to the remote anode by remote arc power supply 1319 which generally has greater open circuit voltage than the primary power supply 1317. Additionally the diodes 1323 are installed to prevent the interference between diode power supply 1321 and remote anode power supply 1319. The remote arc provides high density discharge plasma in the anode cavity 1304 even when the diode sputtering discharge is not ignited. When the diode discharge or remote anode arc discharge or both are activated the cavity 1304 becomes filled high density plasma forming a hollow anode effect which dramatically increases the plasma density within the anode discharge cavity 1304. When magnetic coil 1307 is on it creates a cross ExB field by the walls of the remote anode 1303 (shown by the arrows in Figures 13L,M) generating the close-loop electron drifting current with electron drift velocity $v_{ed}$ around the anode walls 1303 which contributes to dramatic increase of ionization of both gaseous and metal components of gaseous-metal sputtering flow within the cavity 1304. The metal sputtering-gaseous plasma with high degree of metal ions is flowing throughout the opening in the cavity 1304 toward substrates to be coated in the coating chamber. The primary cathodic arc source used in this embodiment may of the same design as shown previously in Figures 13H-13K as illustrated in figure 13M. The magnetron magnetic system such as magnetic yoke can be also installed behind the target 1300 to further increase of the intensity of ion bombardment of the sputtering target 1300 and therefore to increase the productivity of the metal sputtering coating deposition process (shown in Figures 13I,J,K). In both diode and magnetron sputtering embodiments the remote hollow anode effect increases the flux of the metal ions which result in improvement of the functional properties of deposited metal sputtering coating.

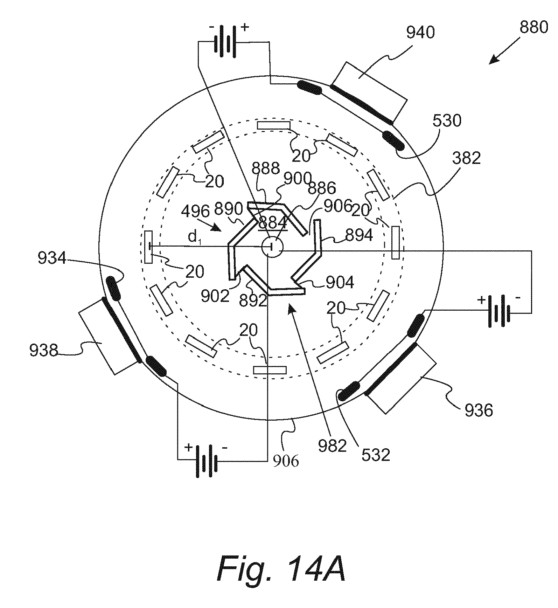

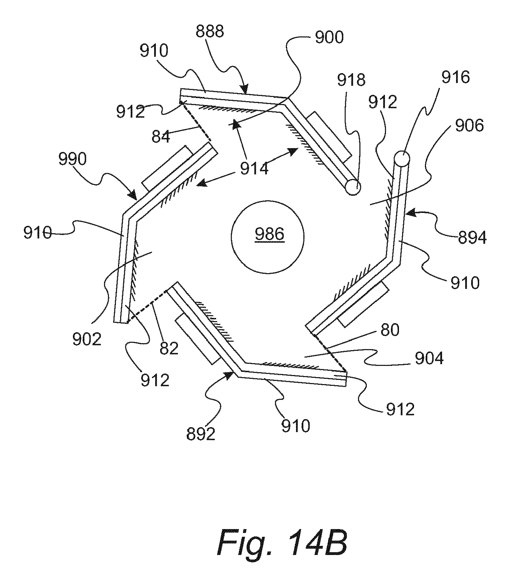

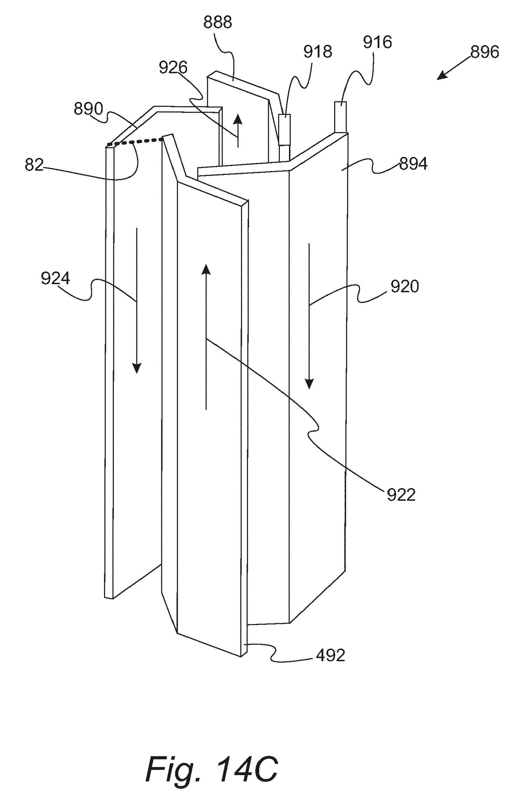

With reference to Figures 14A-14C, schematic illustrations of a variation of a coating system incorporating a macroparticle filter are provided. In this variation, the design of the cathode chamber of U.S. Pat. Application No. 2012/0199070 is adopted, the entire disclosure of this patent application is hereby incorporated by reference. System 880 includes cathode chamber 884 which is configured as a macroparticles filter. Cathode chamber 884 includes an even number of duct assemblies symmetrically positioned around elongated cathode 886. The variation set forth in Figures 14A and 14B includes four duct assemblies, i.e., duct assemblies 888, 890, 892, 894, which effectively form an enclosure 896 around the cathode 886. The duct assemblies 888, 890, 892, 894 define ducts 900, 902, 904, 906 through which positively charged ions are guided from cathode target 986 to substrates 20. Duct assemblies 988, 990, 992, 994 define a magnetic field for guiding a plasma. Duct assemblies each include support component 910 and baffle component 912 for blocking macroparticles. In a refinement, baffle component 912 includes protrusions 914 for enhancing the ability of filtering out macroparticles. Electrical posts 916, 918 are used to connect to the filter power supply so that the duct assemblies are electrically biased for repelling positively charged ions. When the duct assemblies 888, 890, 892, 894 are positively biased in relationship to the cathode 886 it is also serving as a primary anode for the primary arc discharge established within the cathode chamber 884. The duct assemblies 888, 890, 892, 894 can also be isolated and have a floating potential. In this case the arc steering electromagnetic coil (not shown) can serve as a primary anode to the cathode 886 for igniting the primary arc discharge in the cathode chamber 884 as was explained above in relation to the embodiment of the invention shown in Figure 14B. With reference to Figure 14C a schematic perspective view of a cathode chamber enclosure-filter assembly 896 is provided. Filter assembly-cathode chamber enclosure 896 is made of a set of duct assemblies 888, 890, 892, 894, which are parallel to the cathode 886, preferably having a shape of a rod but which can also be made as a bar with any polygonal cross-section. During the filtered cathodic arc coating deposition process the filter is electrically activated by passing a current along the duct assemblies 888, 890, 892, 894 to establish a magnetic field.

Still referring to Figures 14A-14C, a magnetic field is optionally created by passing a current through the duct assemblies so as to create a magnetic field. In particular, adjacent duct assemblies generate magnetic fields with opposite magnetic polarities. Arrows 920, 922, 924, 926 indicate an example of the directions that current may flow to create such magnetic fields. The arrows show that the directions of the currents in the neighboring duct assemblies are opposite to each another. The magnetic field generated in this manner has an orientation normal to an elongated cathode surface and strength conductive to plasma guidance produced by passing current through the duct assemblies. In this filtered arc deposition mode, the metal vapor plasma emitted from the cathode 986 passes through the ducts between the duct assemblies thereby allowing undesirable macroparticles and neutral metal vapor constituencies to be eliminated and to deliver 100% ionized metal vapor plasma to the substrates.

In the remote anode arc plasma discharge (RAAD) mode, the current does not conduct through the duct assemblies 888, 890, 892, 894 and the metal vapor plasma extracting magnetic field is not generating. In this duct-passive mode, the electrons emitted from the surface of the cathode 886 can pass freely through the ducts 900, 902, 904, 906 which conduct the RAAD current between the cathode 886 in the cathode chamber 884 and the remote anodes 930, 932 and 934 which surround the magnetron sources 936, 938 and 940 which are positioned along the chamber wall 906 of the coating system 880. At the same time, the duct assemblies 888, 890, 892, 894 serve as a barrier which stops the heavy particles such as metal vapor atoms, ions and macroparticles, emitted from the cathode 886 to reach substrates. The RAAD plasma ionizes and activates the plasma processing environment in a processing area of the system 880 where the substrates are positioned. This results in the ability to conduct ion plasma cleaning, ion implantation ionitriding and remote arc assisted magnetron sputtering (RAAMS) yielding advanced properties of plasma processing products.

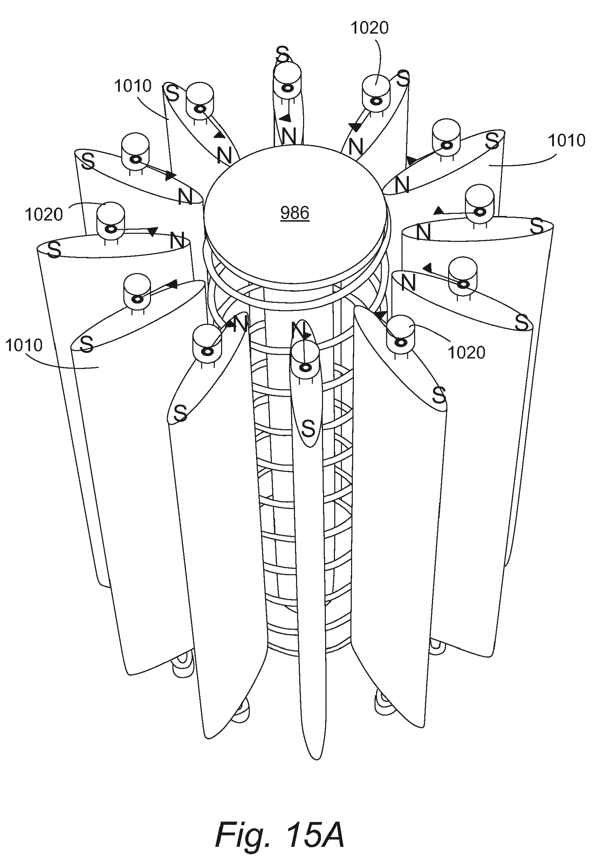

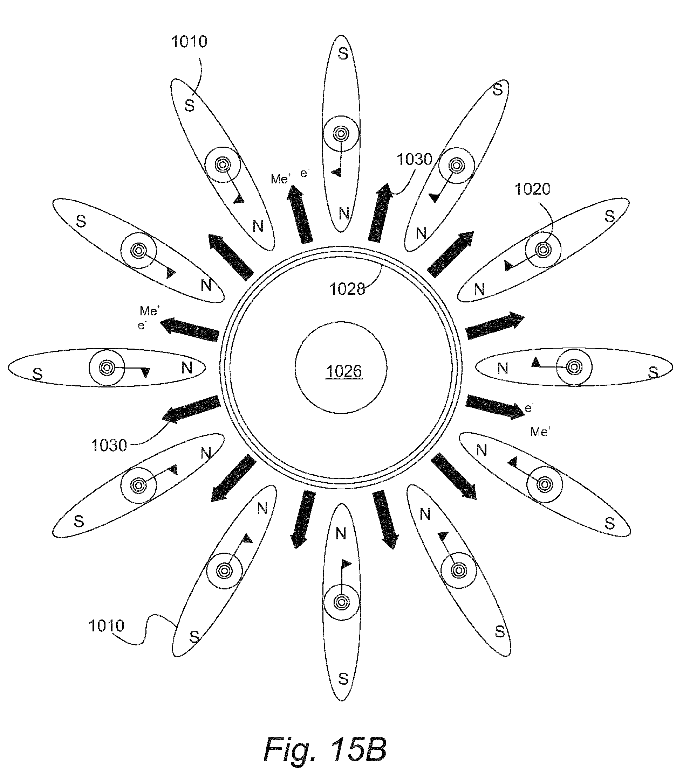

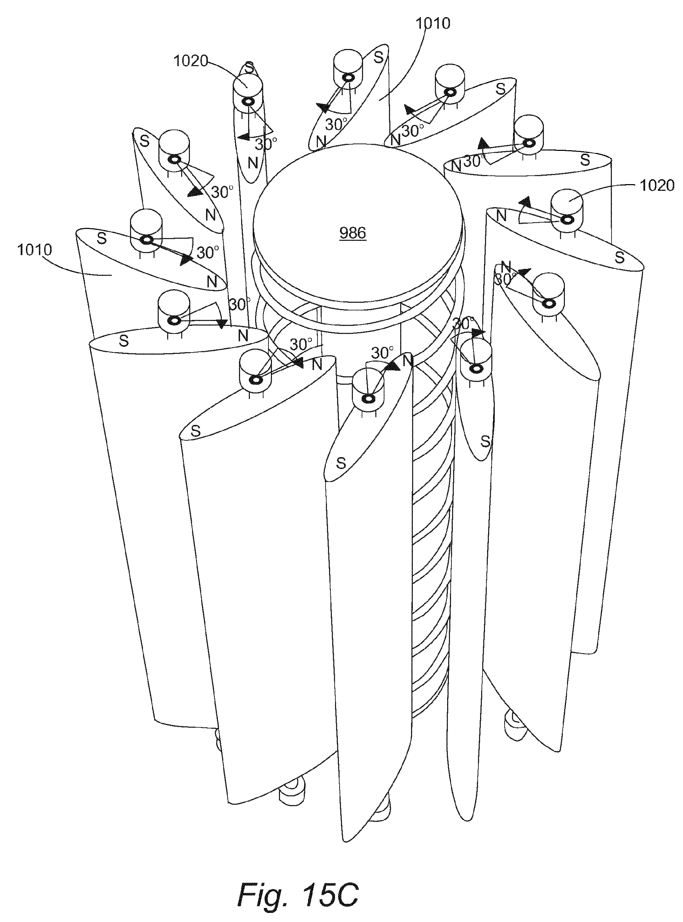

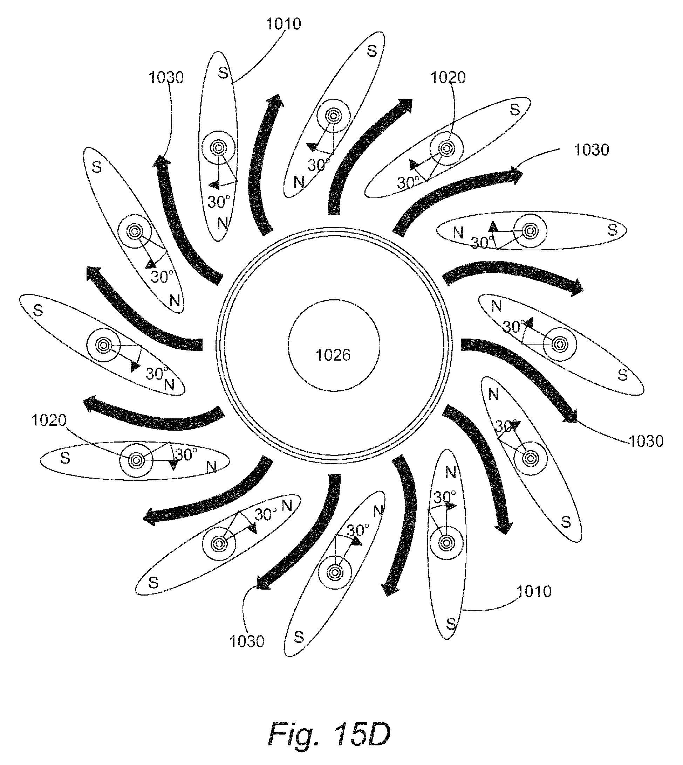

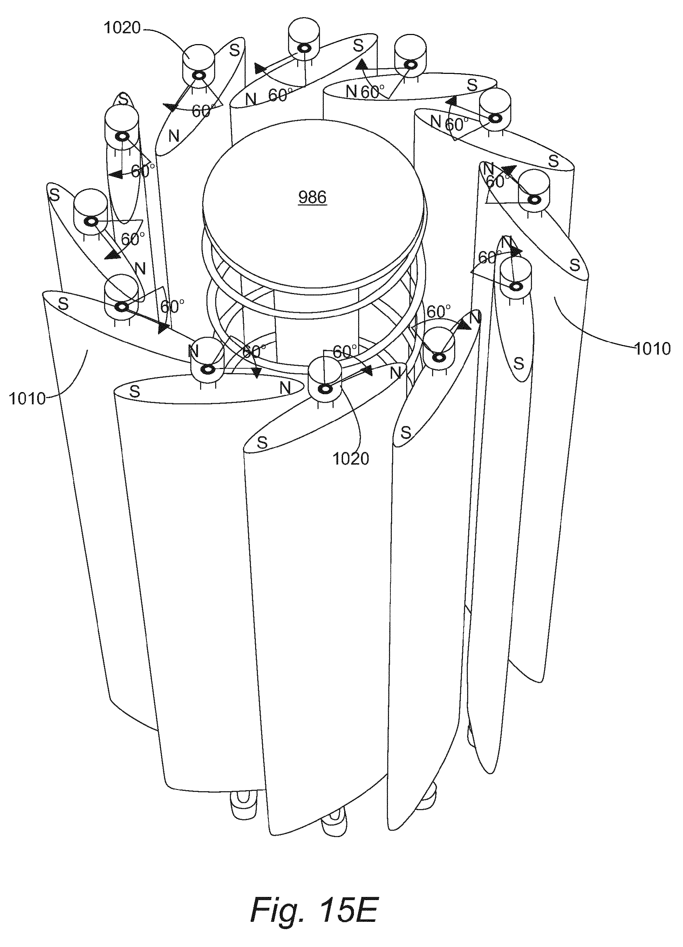

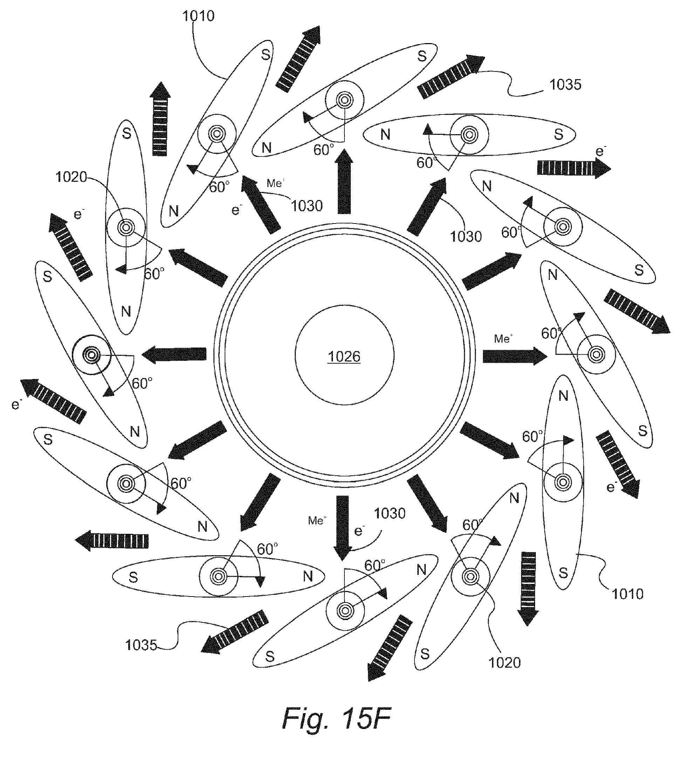

With reference to Figure 15A, a schematic illustration of a cathode chamber that also functions as a macroparticle filter is provided. This design is similar to one shown in Figure 13A and can be used in place of the cathode chamber in the inline coating system of Figure 14B. In this variation, the cathode chamber includes a set of magnetic blades 1010 that are positioned circumferentially around the cylindrical cathodic arc source 986. In a refinement, the blades can turn around their axes of rotation 1020. The cylindrical cathodic arc source 986 shown in cross-sectional view in Figure 15B consists of the cylindrical cathode target 1026 made of material to be evaporated by vacuum cathodic arc evaporation process and surrounding magnetic coil 1028. The magnetic poles of the same polarity of the blades 1010 are facing the cathode 986 while the other ends of the blades with opposite polarity are facing the substrates to be coated (shown in Figure 14A). The potential of the blades should be either floating or otherwise positive in reference to the surrounding plasma environment which will create electrical field repelling positively charged metal ions from the baffles 1010 effectively holding the baffles magnetically isolated from the metal vapor plasma, while the neutral metal atoms and macroparticles can freely impact the baffle's surface. When the blades 1010 are aligned almost radially or at acute angle generally less than 45° to the radii of the cathode 986, the gaps between the neighboring magnetically isolated blades 1010 form a plasma guiding corridors for transporting the metal vapor plasma 1030, generating from the cathodic arc spots on evaporating surface of the cathode target of the cylindrical cathodic arc source 486, the metal vapor plasma is propagating along the magnetic force line away from the cathode 486 toward substrates to be coated (shown in Figure 14A). The metal vapor plasma streams 1030 generating from the cathodic arc spots on evaporating surface of the cathode target 1026 (shown by the arrows in Figure 15B) are propagating along the plasma transporting corridors between the neighboring magnetic blades 1010 toward substrates to be coated (shown in Figure 14A). Figures 15C-D show the magnetic blades positioned at a 30° angle to the radii of the cylindrical coated arc source 986. In this position, the plasma transporting corridor formed between the neighboring blades 1010 are permeable for transporting both the metal ions and electron current of the metal vapor plasma generating by the cathodic arc spots at the evaporating surface of the cathode target 1026. The metal vapor plasma is propagating along the curvilinear magnetic field lines between the neighboring magnetic baffles 1010. When the blades 1010 turn to an angular position generally greater than 45° and less than 90° to the radii of the cylindrical cathodic arc source 986, the plasma corridors between neighboring blades 1010 become impermeable for the metal vapor plasma streams 1030, but the electrons can still flow freely within the remaining gaps between the neighboring blades 1010 (as shown in dashed arrows 1035 in Figure 15F) from cathode 1026 as an electron emitter to the remote anodes installed elsewhere in the coating chamber (as shown in Figure 14A) hence providing a remote arc discharge between the cathode 1026 and the remote anodes in the coating chamber. This electron emitting mode of the cathode assembly is illustrated in Figures 15E and 15F in which the blades are positioned at 60° angle to the radii of the cathode 1026.

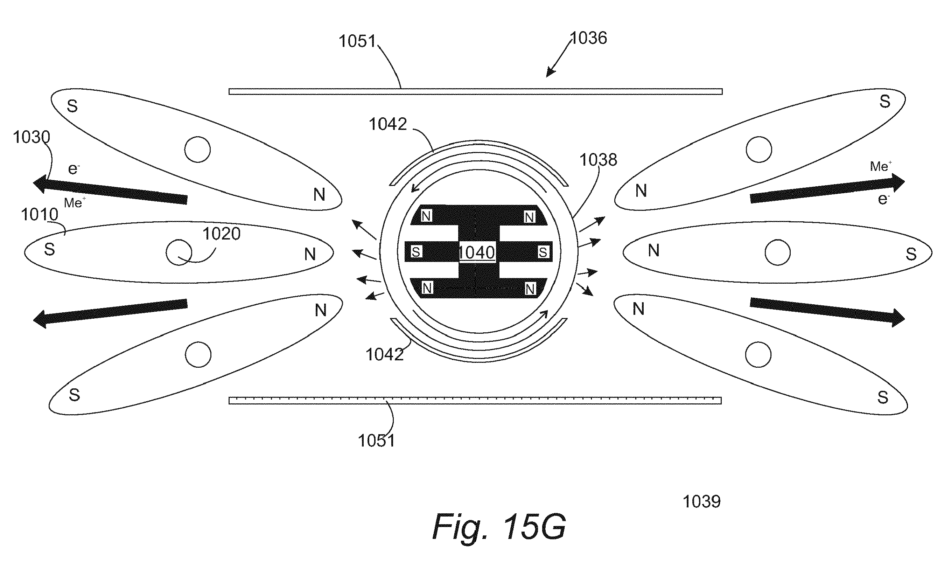

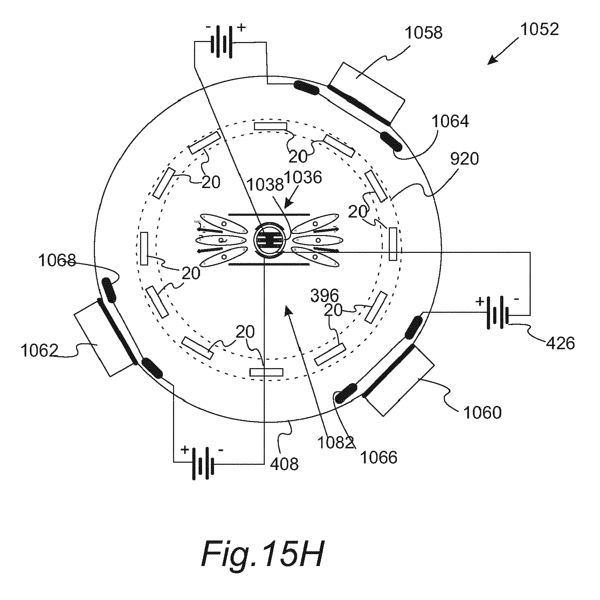

With reference to Figure 15G, a schematic illustration of a bidirectional cylindrical cathodic arc source with rotating target utilizing a set of plasma guiding magnetic baffles is provided. In this design, the cathode assembly 1036 is similar to the cathodic arc source with rotating cylindrical cathode target shown in Figure 12D, but optionally has dual magnetic yoke 1040 providing arc spots steering areas on opposing sides of the rotating target 1038. The shields 1042 restrict arc spots from escaping the evaporating area between the poles of the magnetic yoke 1040. The additional shields 1051 can be optionally installed at the sides of the filtered cathodic arc source 1036 to trap the macroparticles from reaching the substrates to be coated in the coating chamber (as shown in Figure 14A). The metal vapor plasma transports within the plasma guiding corridors along the magnetic force lines between the neighboring magnetically isolated baffles 1010 when they are aligned near the direction along the radii of the cathode 1036 or, more specifically, at the angle ranging from 0° to 45° to the radii of the cathode target 1038. The baffles 1010 can be turned around the axes 1020 to the angle ranging from 45° to 90° to the radii of the cathode target 1038 effectively closing the plasma guiding corridors for heavy particles, including metal ions, but still leave gaps which allow the electrons to flow from the cathode 1036 to the remote anodes in the coating chamber in remote arc discharge mode. Figure 15H provides a coating system similar to one shown in Figure 14A, utilizing the cathode chamber 1036 of Figure 15G. Coating system 1052 operates in two modes: in filtered cathodic arc deposition mode when the baffles 1010 are aligned at the angles ranging from 0 to 45 to the radii of the cathode target 1038, and in electron emission mode, when the angle between the magnetic baffles 1010 and the radii of the cathode target 1038 ranges from 45° to 60°. In the filtered cathodic arc deposition mode, the coatings are deposited from the metal vapor plasma generated by the evaporation target 1038 of the cylindrical cathodic arc source 1082 with or without magnetron sputtering deposition providing by the magnetron sputtering sources 1058, 1060, 1062 installed in the coating chamber 408. In the remote anode arc assisted magnetron sputtering (RAAMS) mode the coatings are depositing by ionized magnetron sputtering generating by the magnetron sputtering sources 1058, 1060, 1062 which metal sputtering flow is ionized by the remote arcs conducting between the cathode target 1038 and the remote anodes 1064, 1066 and 1068.

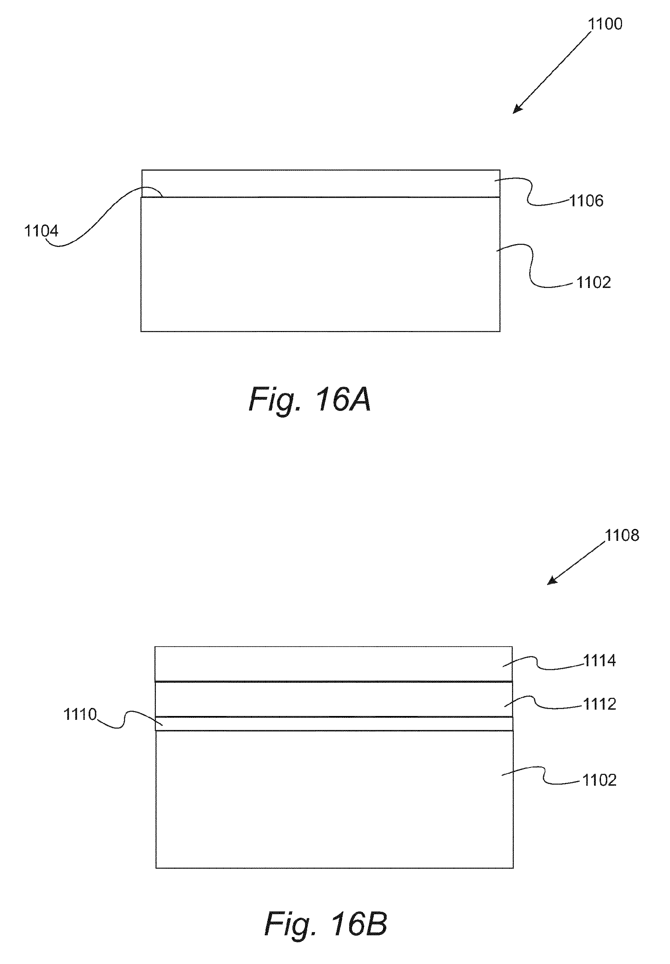

In another embodiment, a coated article formed by the methods and systems set forth above is provided. With reference to Figure 16A, coated article 1100 comprises substrate 1102 having surface 1104 and coating 1106 disposed over surface 1104. In a refinement, the coating is a protective coating. Typically, the coating has a dense microstructure and a characteristic color. In a refinement, the coating includes a refractory metal reacted with nitrogen, oxygen and/or carbon to form a refractory metal nitride, oxide, or carbide. Examples of suitable refractory metals include, but are not limited to, chromium, hafnium, tantalum, zirconium, titanium and zirconium-titanium alloy. Chromium nitride is an example of a particularly useful coating made by the methods set forth above. In a refinement, the coating has a thickness from about 1 to about 6 microns. With reference to Figure 16B, a variation of a chromium nitride coating, which is a multilayer structure, formed by the methods set forth above, is provided. Coated article 1108 includes thin layer 1110 of an unreacted chromium layer disposed over substrate 1102 and a thick stoichiometric chromium nitride layer 1112 disposed over unreacted chromium layer 1110. In a further refinement, the multilayer structure further includes layer 1114 of intermediate stoichiometric chromium nitride layer disposed over the stoichiometric chromium nitride layer 1112. Intermediate stoichiometric chromium nitride 1114 has a stoichiometry given by $CrN_{(1-x)}$ where x is a number between 0.3 and 1.0. In a refinement, the thickness of the unreacted chromium layer 1110 is between 0.05 and 0.5 microns, the thickness of the thick chromium nitride layer 1112 is from 1 to 3 microns, and the intermediate stoichiometric chromium nitride 1114 is from 0.5 to 1 micron.

While embodiments of the invention have been illustrated and described, it is not intended that these embodiments illustrate and describe all possible forms of the invention. Rather, the words used in the specification are words of description rather than limitation, and it is understood that various changes may be made without departing from the spirit and scope of the invention.

The following numbered clauses (numbered 1 to 44) provide embodiments and examples of the invention:

1. A coating system comprising:

a vacuum chamber; and
a coating assembly positioned in the vacuum chamber, the coating assembly including:

a vapor source;
a substrate holder to hold substrates to be coated such that the substrates are positioned in front of the vapor source;
a primary cathodic vacuum-arc assembly including a cathode chamber assembly, a cathode target, an optional primary anode and a shield which isolates the cathode target from the vacuum chamber, the shield defining openings for transmitting either electron emission current or metal vapor plasma from the cathode target into the vacuum chamber;
a remote anode electrically coupled to the cathode target;

a primary power supply connected between the cathode target and the primary anode; and
a secondary power supply connected between the cathode target and the remote anode, the vapor source being positioned between the cathode chamber assembly and the remote anode, the remote anode having a linear remote anode dimension, the vapor source having a linear vapor source dimension, the cathode target having a linear cathode target dimension, and the substrate holder having a linear holder dimension such that the linear remote anode dimension, the linear vapor source dimension, and the linear holder dimension are parallel to each other, with the linear remote anode dimension being equal to or greater than the linear vapor source dimension such that a confined plasma streams from the cathode target to the remote anode.

2. The system of clause 1 wherein the linear vapor source dimension is a long side that is parallel to linear cathode target dimension, the linear vapor source dimension being parallel to the linear cathode target dimension.

3. The system of clause 1 wherein the linear vapor source dimension is a short side that is parallel to linear cathode target dimension.

4. The system of clause 1 wherein the primary anode is a ground or the shield.

5. The system of clause 1 further comprising at least one additional vapor source positioned between the cathode chamber assembly and the remote anode.

6. The system of clause 5 wherein perpendicular distances between each of the vapor sources and the substrates to be coated are substantially equal and the distance between the cathode chamber assembly and the remote anode is less than the distance at which breakdown occurs when an applied voltage of the secondary power supply exceeds 1.2 to 10 times the applied voltage of the primary power supply.

7. The system of clause 5 wherein a plurality of cathode targets are coupled to the remote anode, each cathode target of the plurality of cathode targets having a linear cathode target dimension that is parallel to the linear remote anode dimension.

8. The system of clause 1 wherein a separation from the top of the cathode chamber assembly to substrates is from about 2 to 20 inches.

9. The system of clause 1 wherein an external magnetic field is applied along a region between the vapor source and the substrates to be coated.

10. The system of clause 9 wherein the external magnetic field is applied to magnetically insulate the cathode target of the cathode chamber assembly.

11. The system of clause 9 wherein the external magnetic field is applied to magnetically insulate the anode of the remote anode.

12. The system of clause 1 wherein the vapor source comprises a component selected from the group consisting of a magnetron, a thermal evaporator, an electron beam evaporator, and a cathodic arc evaporator.

13. The system of clause 1 wherein the cathode target comprises a component selected from the group consisting of a cold vacuum arc cathode, a hollow cathode, a thermionic filament cathode, an electron beam evaporator, and combinations thereof.

14. The system of clause 11 wherein the cathode target is made of metal having a gettering capability including titanium and zirconium alloys.

15. The system of clause 1 wherein the shield of the cathode chamber is water cooled and negatively biased in relation to the cathode target wherein a bias potential of the shield ranges from -50 volts to -1000 volts

16. The system of clause 1 wherein plasma probes are installed between the cathode chamber assembly and the remote anode to measure plasma density, the plasma probes providing feedback for controlling the secondary power supply in which a remote anode current is adjusted to obtain a uniform distribution of the plasma density between the cathode chamber assembly and the remote anode.

17. The system of clause 1 wherein the cathode target is part of a cathode array having a plurality of cathode targets installed in the cathode chamber assembly, a linear dimension of each cathode target being substantially equal to the linear dimension of the remote anode.

18. The system of clause 1 wherein the cathode target is a plate or a bar.

19. The system of clause 1 wherein a plurality of slave remote anodes are connected to the remote anode via variable resistors.

20. The system of clause 19 wherein a plurality of slave remote anodes are connected to the remote anode with capacitors.

21. The system of clause 1 comprising a plurality of coating assemblies.

22. The system of clause 21 wherein the plurality of coating assemblies is aligned essentially inline.

23. The system of clause 1 wherein the vapor source, the cathode target and the remote anode are distributed along a linear direction with the substrate holder moving along the linear direction.

24. The system of clause 1 wherein the vacuum chamber has a circular cross section with the cathode target and the remote anode distributed about a central axis of the vacuum chamber with the substrate holder moving in a circular direction.

25. The system of clause 1 wherein the primary cathodic vacuum-arc assembly includes a filtered cathodic vacuum-arc source.

26. The system of clause 25 wherein the filtered cathodic vacuum-arc source includes a cathode target and a plasma duct, the plasma duct having a long side, the plasma duct having a bend section along a centerline of the plasma duct, the plasma duct having a cathode chamber portion and an exit tunnel portion on opposite sides of the bend.

27. The system of clause 26 wherein the plasma duct has a rectangular cross-sectional shape of similar dimensions to the cathode target.

28. The system of clause 26 wherein the cathode chamber assembly includes a rectangular tube.

29. The system of clause 26 wherein the cathode target is mounted on an isolated holder at an end of cathode chamber portion so that an evaporable surface of the cathode target faces into the plasma duct.

30. The system of clause 26 wherein the bend has an angle from about 60 to 120 degrees.

31. The system of clause 26 further including a magnetic shutter having deflecting magnets and focusing electromagnets disposed about the plasma duct, the deflecting magnets positioned about an outer side of the cathode chamber and the bend section, the focusing electromagnetics positioned at the exit of the plasma duct.

32. The system of clause 31 wherein the magnetic shutter is open when both deflection electromagnets and the focusing electromagnets are activated such that ionized filtered metal vapor plasma generated at the cathode target are transported through the plasma duct toward substrates.

33. The system of clause 31 wherein a gaseous environment is also highly ionized within a narrow corridor defined between the substrates and walls of the vacuum chamber along a remote arc discharge path.

34. The system of clause 31 wherein the vapor sources includes a plurality of magnetron sputtering source that combines discharge with a remote anode arc discharge thereby allowing an increase ionization of the magnetron sputtering source.

35. The system of clause 31 wherein the magnetic shutter is closed when the deflecting magnets and the focusing electromagnets are not activated such that metal vapor plasma generated by the cathode target is trapped within the plasma duct while a remote anode arc discharge runs between the cathode target and the remote anode providing ionization and activation of coating deposition environment along a corridor defined between the substrates and walls of the vacuum chamber.

36. The system of clause 31 wherein a plurality of magnetron sputtering sources and remote anodes are positioned on a hub in a central region of the vacuum chamber such that a remote arc discharge fill a region between the hub and walls of the vacuum chamber.

37. The system of clause 31 wherein the vapor source include a bi-directional filtered arc source having a bi-directional plasma duct the remote anodes installed at a peripheral rim of the bi-directional plasma duct, a remote anode arc discharge being established along a corridor defined between an outer rim of the plasma duct and the substrates.

38. The system of clause 37 wherein the bi-directional plasma duct further includes shields at both ends of the bi-directional plasma duct.

39. The system of clause 37 wherein the remote anode arc discharge is supported either by a unidirectional filtered vacuum-arc source and/or by the bi-directional filtered arc source, such that a remote anode arc discharge plasma fills a coating deposition area defined between an outer wall of the bi-directional filtered arc source and walls of the vacuum chamber.

40. The system of clause 39 wherein the bi-directional filtered arc source and the unidirectional filtered arc source are configured to operate concurrently and independently in a magnetic shutter mode while coupled with magnetron sputtering sources.

41. The system of clause 39 further comprising a first additional magnetron source and a second additional magnetron source positioned adjacent to the exit of the plasma duct in the vacuum chamber facing the substrates such that the magnetron sputtering flow is merging with the cathode target of the filtered arc source.

42. The system of clause 39 further comprising two magnetron sources positioned at the exit of the plasma duct.

43. The system of clause 31 configured to operate in an inline mode.

44. The system of clause 1 configured to operate in a batch mode.


**Claims**

1. A coating system comprising:

   a coating chamber;
   a vapor source having a target face with a vapor source long dimension and a vapor face short dimension;
   a substrate holder to hold substrates to be coated such that the substrates are positioned within the coating chamber and in front of the vapor source, the substrate holder having a linear holder dimension;
   a dual filtered arc unidirectional rectangular plasma source operating as a metal vapor plasma coating deposition source and an electron emitting source, the unidirectional dual filtered arc source including a rectangular plasma duct having deflecting section and an exit tunnel section, a first cathodic arc chamber having a first cathode target, a second cathodic arc chamber having a second cathode target, and a baffled anode plate, the first cathodic arc chamber and the second cathodic arc chamber separated by the baffled anode plate and positioned on opposite sides of a deflecting section;

   a remote anode electrically coupled to the first cathode target and the second cathode target, the remote anode having a linear remote anode dimension, the vapor source having a linear vapor source dimension;
   a primary power supply connected between the cathode target and a primary anode; and a secondary power supply connected between the cathode target and the remote anode, wherein a confined remote arc plasma streams from the cathode target to the remote anode through a narrow corridor between the chamber walls and substrates to be coated while substrates are positioned in front of the vapor sources during coating.

2. The coating system of claim 1 further comprising deflecting coils surrounding a deflection portion of the plasma duct.

3. The coating system of any of claims 1 and 2 further comprising stabilizing coils that surround the cathode chambers and confine confining cathodic arc spots at evaporable surface of the cathode targets.

4. The coating system of any of claims 1 to 3 further comprising focusing coils surrounding an exit portion of the cathode chambers that focus a metal vapor plasma stream towards a deflection portion of the plasma duct.

5. The coating system of any of claims 1 to 4 further comprising a first magnetron source and a second magnetron source positioned as an exit tunnel portion of the plasma duct, the first magnetron source and the second magnet source regulating the degree of ion bombardment by metal ions during a hybrid filtered arc enhanced magnetron sputtering coating deposition process.

6. The coating system of any of claims 1 to 5 further comprising a shielded cathodic arc electron emission source located centrally in the coating chamber.

7. The coating system of any of claims 1 to 5 configured to operate in an inline mode.

8. The coating system of any of claims 1 to 6 configured to operate in a batch mode.

*Fig. 1A*

$D_h$

$D_c$

$D_v$

$D_a$

20

22

*Fig. 1B*

*Fig. 1C*

## Plasma Density Distribution

$\approx 10^{10}/cm^3$

$d_4$

62

$>>10^{12}/cm^3$

44

22    22    22

20

## Plasma Density Distribution

$d_4$

64

28

68

66

## Fig. 1D

$28^1$    $28^2$    $28^3$    $28^4$    $28^5$    $28^6$

## Fig. 1E

*Fig. 1G*

*Fig. 1F*

Fig. 2

Fig. 3

*Fig. 4A*

EP 3 091 560 A1

Fig. 4B

Fig. 4C

*Fig. 5*

RAD Plasma Potential

Remote Anode Potential

Ground, Primary
arc anode potential

Primary Cathode
Potential

Floated Substrate
Potential

Biased Substrate
Potential

*Fig. 6*

Fig. 7A

*Fig. 7B*

*Fig. 8A*

EP 3 091 560 A1

*Fig. 8B*

Fig. 8C

Fig. 8D

*Fig. 8E*

*Fig. 8F*

Fig. 8G

Fig. 8H

Fig. 9A

Fig. 9B

Fig. 9C

*Fig. 9D*

Fig. 9E

Fig. 10

EP 3 091 560 A1

Fig. 11A

Fig. 11B

Fig.11C

Fig.11D

*Fig.11E*

EP 3 091 560 A1

Fig.11F

*Fig.11G*

EP 3 091 560 A1

*Fig.11H*

EP 3 091 560 A1

*Fig. 12A*

Fig. 12B

*Fig.12C*

Fig.12D

*Fig. 13A*

EP 3 091 560 A1

*Fig. 13B*

Fig. 13C

Fig. 13D

*Fig. 13E*

*Fig. 13F*

EP 3 091 560 A1

Fig. 13G

Fig. 13H

EP 3 091 560 A1

*Fig. 13I*

Fig. 13J

Fig. 13K

Fig. 13L

*Fig. 13M*

*Fig. 14A*

Fig. 14B

Fig. 14C

Fig. 15A

Fig. 15B

*Fig. 15C*

Fig. 15D

Fig. 15E

*Fig. 15F*

Fig. 15G

EP 3 091 560 A1

Fig.15H

1100

1106

1104

1102

## Fig. 16A

1108

1114

1112

1110

1102

## Fig. 16B

Europäisches
Patentamt

European
Patent Office

Office européen
des brevets

# EUROPEAN SEARCH REPORT

Application Number

EP 16 16 8630

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/168637 A1 (GOROKHOVSKY VLADIMIR I [US]) 2 September 2004 (2004-09-02) | 1-6,8 | INV. H01J37/32 |
| Y | * paragraph [0117] - paragraph [0130] * * figures 8b-8k * | 7 | H01J37/34 |
| X | WO 2012/062369 A1 (NCI SWISSNANOCOAT SA [CH]; MIKHAILOV SERGUEI [CH]) 18 May 2012 (2012-05-18) * page 6, line 2 - page 13, line 24 * * figure 1 * | 1-4,8 | |
| Y,D | US 2014/076718 A1 (GOROKHOVSKY VLADIMIR [US] ET AL) 20 March 2014 (2014-03-20) * paragraph [0048] - paragraph [0052] * * figure 1 * | 7 | |
| A,D | BHAT D G ET AL: "Development of a Coating for Wear and Cracking Prevention in Die-Casting Dies by the Filtered Cathodic Arc Process", TRANSACTIONS OF THE NORTH AMERICAN DIE CASTING ASSOCIATION, 20TH INTERNATIONAL DIE CASTING CONGRESS AND EXPOSITION, CLEVELAND, OH, NOVEMBER 1999,, 30 November 1999 (1999-11-30), pages 391-399, XP009191506, * page 4, paragraph 4 - page 5, paragraph 3 * | 1-8 | TECHNICAL FIELDS SEARCHED (IPC) H01J C23C |

The present search report has been drawn up for all claims

| Place of search | Date of completion of the search | Examiner |
|---|---|---|
| The Hague | 2 September 2016 | Aguilar, María |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 16 8630

This annex lists the patent family members relating to the patent documents cited in the above-mentioned European search report.
The members are as contained in the European Patent Office EDP file on
The European Patent Office is in no way liable for these particulars which are merely given for the purpose of information.

02-09-2016

| Patent document cited in search report | Publication date | Patent family member(s) | | Publication date |
|---|---|---|---|---|
| US 2004168637 A1 | 02-09-2004 | NONE | | |
| WO 2012062369 A1 | 18-05-2012 | CN | 103459652 A | 18-12-2013 |
| | | EP | 2638182 A1 | 18-09-2013 |
| | | RU | 2013126583 A | 20-12-2014 |
| | | TW | 201233830 A | 16-08-2012 |
| | | WO | 2012062369 A1 | 18-05-2012 |
| US 2014076718 A1 | 20-03-2014 | AR | 092512 A1 | 22-04-2015 |
| | | BR | 102013023563 A2 | 24-11-2015 |
| | | CA | 2826917 A1 | 14-03-2014 |
| | | CN | 103668099 A | 26-03-2014 |
| | | EP | 2743370 A1 | 18-06-2014 |
| | | JP | 2014058742 A | 03-04-2014 |
| | | RU | 2013142040 A | 20-03-2015 |
| | | US | 2014076718 A1 | 20-03-2014 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 13617005 B
- US 13840305 B
- US 14064617 B
- US 6350356 B
- US 7498587 B
- EP 1852891 A2
- US 5480527 A
- US 5269898 A
- US 20120199070 A

**Non-patent literature cited in the description**

- **R.L.BOXMAN ; D.M.SANDERS ; P.J.MARTIN.** Handbook of Vacuum Arc Science and Technology. Noyes Publications, 1995, 423-444
- **D.G. BHAT ; V.I. GOROKHOVSKY ; R. BHATTACHARYA ; R. SHIVPURI ; K. KULKARNI.** Development of a Coating for Wear and Cracking Prevention in Die-Casting Dies by the Filtered Cathodic Arc Process. *Transactions of the North American Die Casting Association, 20th International Die Casting Congress and Exposition, Cleveland, OH,* November 1999, 391-399